# EUROPEAN PATENT APPLICATION

(11) **EP 4 006 022 A1**
(43) Date of publication of application: **01.06.2022**
(21) Application number: 20847341.3
(22) Date of filing: 26.05.2020
(51) Int. Cl.: C07D 401/04, C07F 15/00, C09K 11/06, H01L 51/50

(54) **METAL COMPLEX AND LIGHT-EMITTING ELEMENT CONTAINING SAME**

(30) Priority: 26.07.2019 JP 2019138199
(71) Applicant: Sumitomo Chemical Company, Limited, Tokyo 103-6020 (JP)
(72) Inventor: USUI, Motoaki, Tsukuba-shi, Ibaraki 300-3294 (JP); MATSUMOTO, Ryuji, Tsukuba-shi, Ibaraki 300-3294 (JP); ISHIKAWA, Rui, Tsukuba-shi, Ibaraki 300-3294 (JP); FUKUSHIMA, Daisuke, Tsukuba-shi, Ibaraki 300-3294 (JP)
(74) Representative: J A Kemp LLP
(86) International application number: PCT/JP2020/020657
(87) International publication number: WO 2021/019884

(57) **Abstract**

To provide a metal complex which is useful for production of a light emitting device of which long-term degradation is suppressed, and the like.

A metal complex represented by the formula (1), a composition containing the above-described metal complex, and at least one material selected from the group consisting of a hole transporting material, a hole injection material, an electron transporting material, an electron injection material, a light emitting material, an antioxidant and a solvent, and, a light emitting device containing the above-described metal complex: 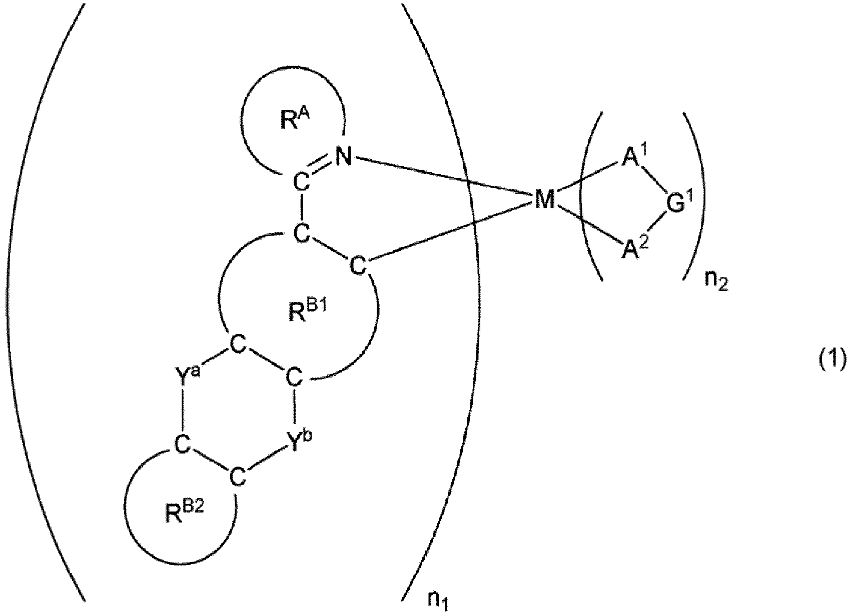 [wherein, one of Y^{a} and Y^{b} is a single bond, and the other is a group represented by the formula (C-1):

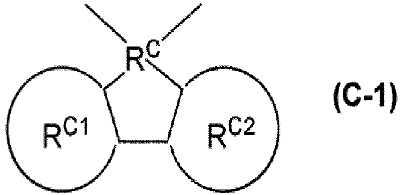

At least one of Ring R^{A}, Ring R^{B1}, Ring R^{B2}, Ring R^{C1} and Ring R^{C2} has a group represented by the formula (D-A), the formula (D-B) or the formula (D-C) as a substituent.].

## Description

### Technical Field

The present invention relates to a metal complex, a composition containing the metal complex, and a light emitting device containing the metal complex.

### Background Art

As light emitting materials used for a light emitting layer of a light emitting device, phosphorescent compounds showing light emission from the triplet excited state have been variously investigated. As such phosphorescent compounds, many metal complexes in which the central metal is a transition metal belonging to the 5-th period or 6-th period have been studied. For example, Patent Document 1 suggests metal complexes having as a ligand a phenylpyridine structure having dendron (for example, a metal complex represented by the following formula).

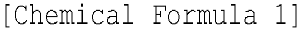

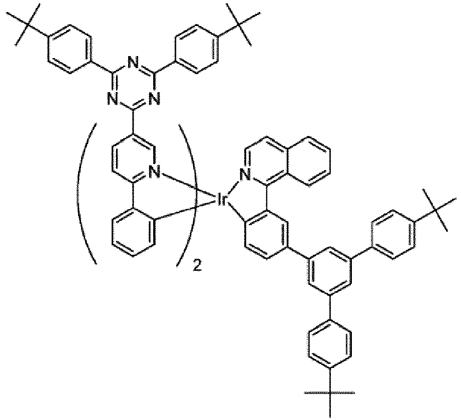

### Prior Art Document

### Patent Document

[Patent Document 1]: Japanese Unexamined Patent Application Publication (JP-A) No. 2011-105701

### Summary of the Invention

### Problem to be Solved by the Invention

However, light emitting devices fabricated using the above-described metal complexes were not necessarily sufficient in suppression of long-term degradation.

Then, the present invention has an object of providing a metal complex which is useful for production of a light emitting device of which long-term degradation is suppressed. Further, the present invention has an object of providing a composition containing the metal complex, and a light emitting device containing the metal complex.

### Means for Solving the Problem

The present invention provides the following [1] to [11].

[1] A metal complex represented by the formula (1): 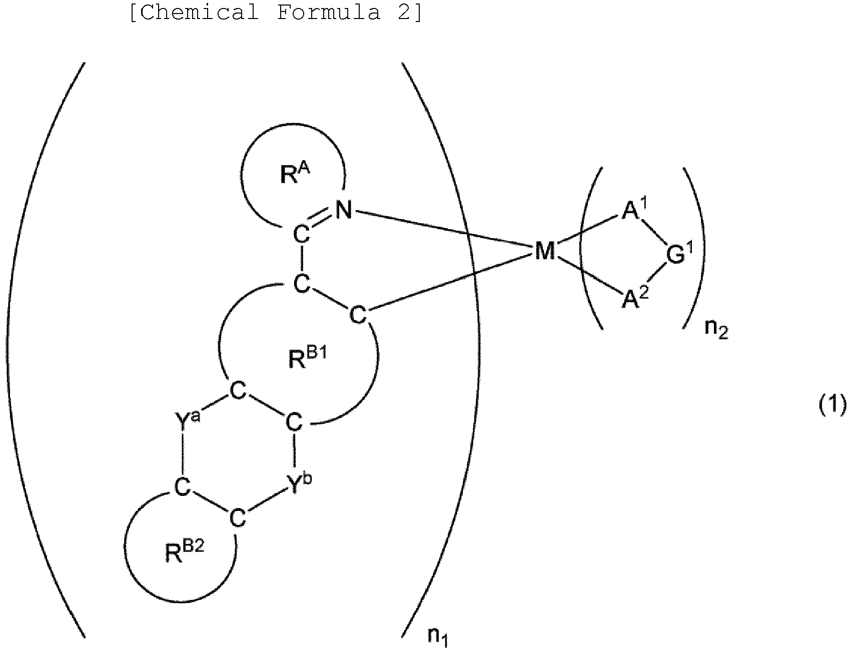 [wherein,
   M represents a rhodium atom, a palladium atom, an iridium atom or a platinum atom.
   n₁ represents 1, 2 or 3. n₂ represents 0, 1 or 2. n₁+n₂ is 3 when M is a rhodium atom or an iridium atom, while n₁+n₂ is 2 when M is a platinum atom or a palladium atom.
   Ring R^{A} represents an aromatic hetero ring, and the aromatic hetero ring optionally has a substituent. When a plurality of the substituents are present, they may be combined together to form a ring together with atoms to which they are attached. When a plurality of Ring R^{A} are present, they may be the same or different at each occurrence.
   Ring R^{B1} and Ring R^{B2} each independently represent an aromatic hydrocarbon ring or an aromatic hetero ring, and these rings optionally have a substituent. When a plurality of the substituents are present, they may be combined together to form a ring together with atoms to which they are attached. When a plurality of Ring R^{B1} and Ring R^{B2} are present, they may be the same or different at each occurrence.
   One of Y^{a} and Y^{b} is a single bond, and the other is a group represented by the formula (C-1): 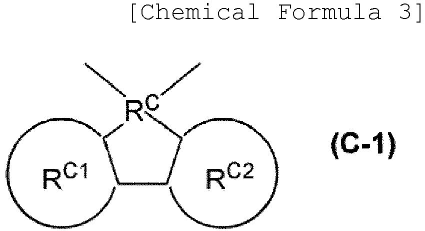 (wherein,
      R^{c} represents a carbon atom, a silicon atom, a germanium atom, a tin atom or a lead atom.
      Ring R^{C1} and Ring R^{C2} each independently represent an aromatic hydrocarbon ring or an aromatic hetero ring, and these rings optionally have a substituent. When a plurality of the substituents are present, they may be combined together to form a ring together with atoms to which they are attached. A substituent which Ring R^{C1} optionally has and a substituent which Ring R^{C2} optionally has may be combined together to form a ring together with atoms to which they are attached.). When a plurality of Y^{a} and Y^{b} are present, they may be the same or different at each occurrence.
      A¹-G¹-A² represents an anionic bidentate ligand, and G¹ represents an atomic group constituting a bidentate ligand together with A¹ and A². A¹ and A² each independently represent a carbon atom, an oxygen atom or a nitrogen atom, and these atoms may be ring-constituent atoms. When a plurality of A¹-G¹-A² are present, they may be the same or different.
      At least one of Ring R^{A}, Ring R^{B1}, Ring R^{B2}, Ring R^{C1} and Ring R^{C2} has a group represented by the formula (D-A), the formula (D-B) or the formula (D-C) as a substituent.] 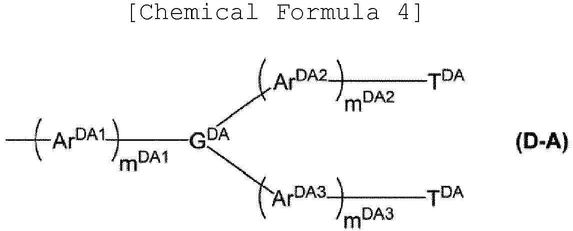
   [wherein,
      m^{DA1}, m^{DA2} and m^{DA3} each independently represent an integer of 0 or more.
      G^{DA} represents a nitrogen atom, an aromatic hydrocarbon group or a hetero ring group, and these groups optionally have a substituent.
      Ar^{DA1}, Ar^{DA2} and Ar^{DA3} each independently represent an arylene group or a divalent hetero ring group, and these groups optionally have a substituent. When a plurality of Ar^{DA1}, Ar^{DA2} and Ar^{DA3} are present, they may be the same or different at each occurrence.
      T^{DA} represents an aryl group or a monovalent hetero ring group, and these groups optionally have a substituent. A plurality of T^{DA} may be the same or different.] 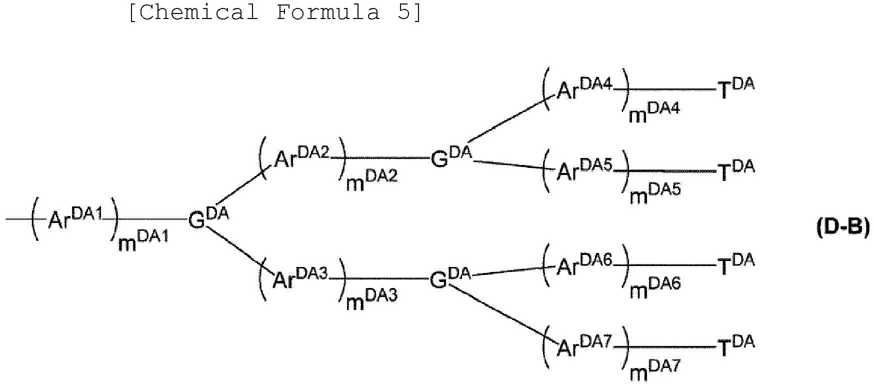
   [wherein,
      m^{DA1}, m^{DA2}, m^{DA3}, m^{DA4}, m^{DA5}, m^{DA6} and m^{DA7} each independently represent an integer of 0 or more.
      G^{DA} represents a nitrogen atom, an aromatic hydrocarbon group or a hetero ring group, and these groups optionally have a substituent. A plurality of G^{DA} may be the same or different.
      Ar^{DA1}, Ar^{DA2}, Ar^{DA3}, Ar^{DA4}, Ar^{DA5}, Ar^{DA6} and Ar^{DA7} each independently represent an arylene group or a divalent hetero ring group, and these groups optionally have a substituent. When a plurality of Ar^{DA1}, Ar^{DA2}, Ar^{DA3}, Ar^{DA4}, Ar^{DA5}, Ar^{DA6} and Ar^{DA7} are present, they may be the same or different at each occurrence.
      T^{DA} represents an aryl group or a monovalent hetero ring group, and these groups optionally have a substituent. A plurality of T^{DA} may be the same or different.] 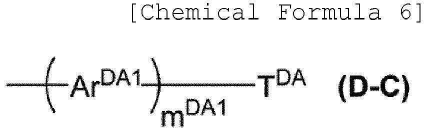
   [wherein,
      m^{DA1} represents an integer of 0 or more.
      Ar^{DA1} represents an arylene group or a divalent hetero ring group, and these groups optionally have a substituent. When a plurality of Ar^{DA1} are present, they may be the same or different.
      T^{DA} represents an aryl group or a monovalent hetero ring group, and these groups optionally have a substituent.].
[2] The metal complex according to [1], wherein the above-described metal complex represented by the formula (1) is a metal complex represented by the formula (1-A1), a metal complex represented by the formula (1-A2) or a metal complex represented by the formula (1-A3): 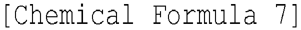 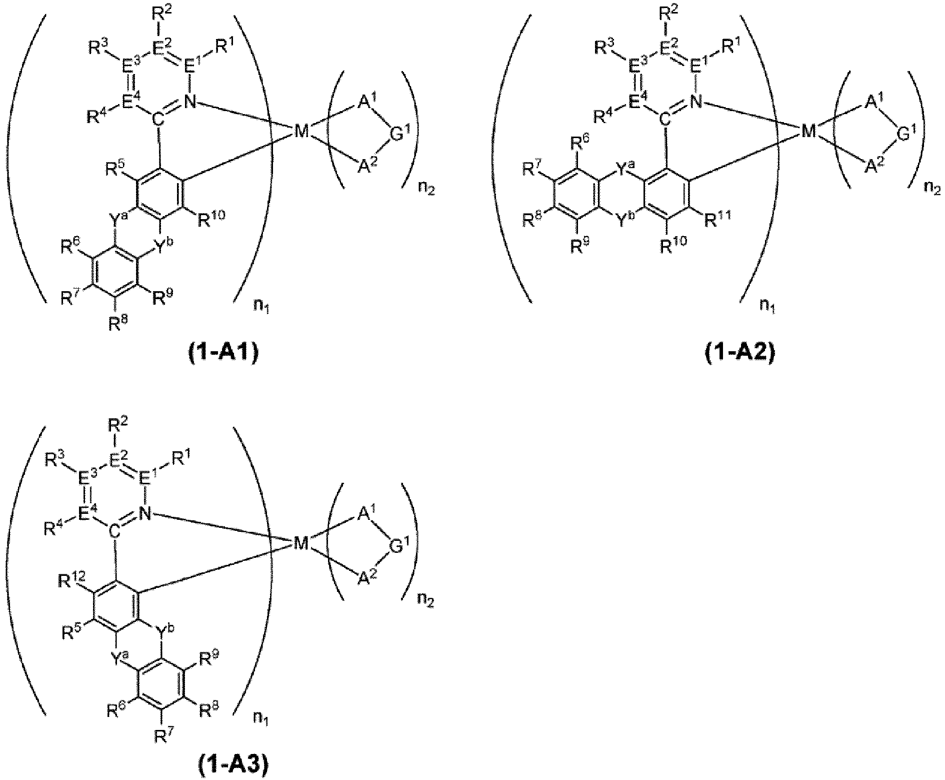 [wherein,
   M, n¹, n², Y^{a}, Y^{b} and A¹-G¹-A² represent the same meaning as described above.
   E¹, E², E³ and E⁴ each independently represent a nitrogen atom or a carbon atom. When a plurality of E¹, E², E³ and E⁴ are present, they may be the same or different at each occurrence. When E¹ is a nitrogen atom, R¹ is not present. When E² is a nitrogen atom, R² is not present. When E³ is a nitrogen atom, R³ is not present. When E⁴ is a nitrogen atom, R⁴ is not present.
   R¹, R², R³ and R⁴ each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom, a group represented by the above-described formula (D-A), a group represented by the above-described formula (D-B) or a group represented by the above-described formula (D-C), and these groups optionally have a substituent. When a plurality of R¹, R², R³ and R⁴ are present, they may be the same or different at each occurrence.
   R⁵, R⁶, R⁷, R⁸, R⁹, R¹⁰, R¹¹ and R¹² each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom, a group represented by the above-described formula (D-A), a group represented by the above-described formula (D-B) or a group represented by the above-described formula (D-C), and these groups optionally have a substituent. When a plurality of R⁵, R⁶, R⁷, R⁸, R⁹, R¹⁰, R¹¹ and R¹² are present, they may be the same or different at each occurrence. R⁶ and R⁷, R⁷ and R⁸, R⁸ and R⁹, R¹⁰ and R¹¹, and R⁵ and R¹² may each be combined together to form a ring together with atoms to which they are attached.

At least one of R¹, R², R³, R⁴, R⁵, R⁶, R⁷, R⁸, R⁹, R¹⁰, R¹¹, R¹², a substituent which Ring R^{C1} has and a substituent which Ring R^{C2} has is a group represented by the above-described formula (D-A), the above-described formula (D-B) or the above-described formula (D-C).]

[3] The metal complex according to [1] or [2], wherein the group represented by the above-described formula (C-1) is a group represented by the formula (C-2): 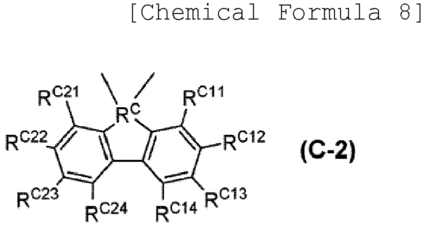 [wherein, R^{c} represents the same meaning as described above.
R^{C11}, R^{C12}, R^{C13}, R^{C14}, R^{C21}, R^{C22}, R^{C23} and R^{C24} each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom, a group represented by the above-described formula (D-A), a group represented by the above-described formula (D-B) or a group represented by the above-described formula (D-C), and these groups optionally have a substituent. When a plurality of R^{C11}, R^{C12}, R^{C13}, R^{C14}, R^{C21}, R^{C22}, R^{C23} and R^{C24} are present, they may be the same or different at each occurrence. R^{C11} and R^{C12}, R^{C12} and R^{C13}, R^{C13} and R^{C14}, R^{C14} and R^{C24}, R^{C24} and R^{C23}, R^{C23} and R^{C22}, and R^{C22} and R^{C21} may each be combined together to form a ring together with atoms to which they are attached.

At least one of a substituent which Ring R^{B1} has, a substituent which Ring R^{B2} has, R^{C11}, R^{C12}, R^{C13}, R^{C14}, R^{C21}, R^{C22}, R^{C23} and R^{C24} is a group represented by the above-described formula (D-A), a group represented by the above-described formula (D-B) or a group represented by the above-described formula (D-C).].

[4] The metal complex according to claim [3], wherein the metal complex represented by the above-described formula (1) is a metal complex represented by the formula (1-A1-1) : 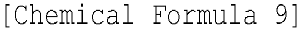 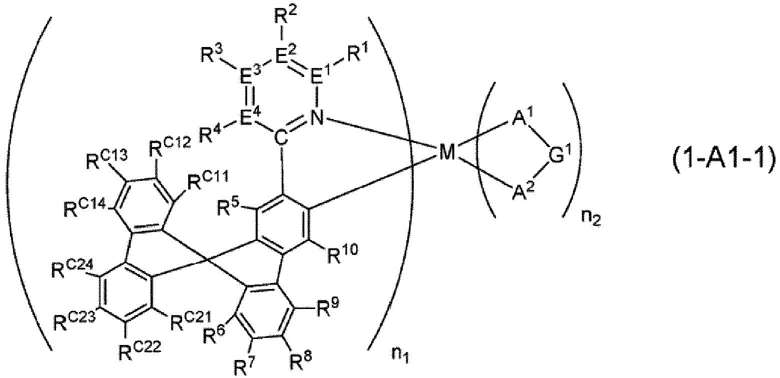 [wherein, M, n¹, n², E¹, E², E³, E⁴, R¹, R², R³, R⁴, R⁵, R⁶, R⁷, R⁸, R⁹, R¹⁰, R^{C11}, R^{C12}, R^{C13}, R^{C14}, R^{C21}, R^{C22}, R^{C23}, R^{C24}, and A¹-G¹-A² represent the same meaning as described above.].

[5] The metal complex according to any one of [1] to [4], wherein Ring R^{A} has a group represented by the above-described formula (D-A), the above-described formula (D-B) or the above-described formula (D-C) as a substituent.

[6] The metal complex according to [5], wherein Ring R^{A} is a 6-membered ring, and the group represented by the above-described formula (D-A), the above-described formula (D-B) or the above-described formula (D-C) is present at the para position with respect to a carbon atom bonding to Ring R^{B1}.

[7] The metal complex according to any one of [1] to [6], wherein the group represented by the above-described formula (D-A) is a group represented by the formula (D-A1), a group represented by the formula (D-A2), a group represented by the formula (D-A3), a group represented by the formula (D-A4) or a group represented by the formula (D-A5) : 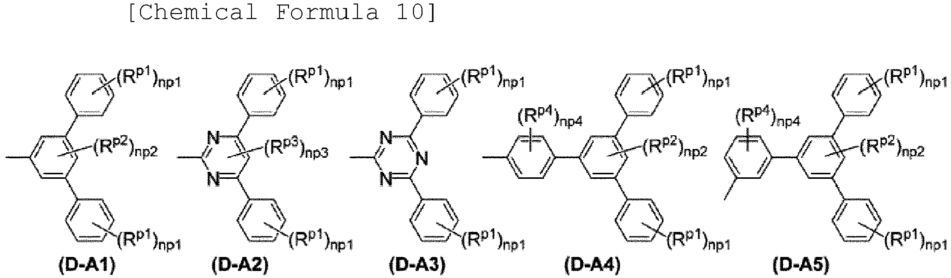 [wherein,
R^{p1}, R^{p2}, R^{p3} and R^{p4} each independently represent an alkyl group, a cycloalkyl group, an alkoxy group, a cycloalkoxy group or a halogen atom, and these groups optionally have a substituent. When a plurality of R^{p1}, R^{p2} and R^{p4} are present, they may be the same or different at each occurrence.
n^{p1} represents an integer of 0 to 5, n^{p2} represents an integer of 0 to 3, n^{p3} represents 0 or 1, and n^{p4} represents an integer of 0 to 4. A plurality of n^{p1} may be the same or different.].

[8] The metal complex according to any one of [1] to [7], wherein Ring R^{A} is a pyridine ring.

[9] A composition comprising the metal complex as described in any one of [1] to [8], and at least one selected from the group consisting of a compound represented by the formula (H-1) and a polymer compound containing a constitutional unit represented by the formula (Y) : 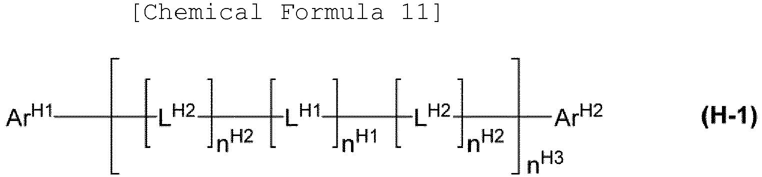 [wherein,
Ar^{H1} and Ar^{H2} each independently represent an aryl group or a monovalent hetero ring group, and these groups optionally have a substituent.
n^{H1} and n^{H2} each independently represent 0 or 1. When a plurality of n^{H1} are present, they may be the same or different. A plurality of n^{H2} may be the same or different.
n^{H3} represents an integer of 0 or more.
L^{H1} represents an arylene group, a divalent hetero ring group, or a group represented by -[C(R^{H11})₂]n^{H11}-, and these groups optionally have a substituent. When a plurality of L^{H1} are present, they may be the same or different. n^{H11} represents an integer of 1 or more and 10 or less. R^{H11} represents a hydrogen atom, an alkyl group, a cycloalkyl group, an alkoxy group, a cycloalkoxy group, an aryl group or a monovalent hetero ring group, and these groups optionally have a substituent. A plurality of R^{H11} may be the same or different, and may be combined together to form a ring together with carbon atoms to which they are attached.
L^{H2} represents a group represented by -N(-L^{H21}-R^{H21})-. When a plurality of L^{H2} are present, they may be the same or different.
L^{H21} represents a single bond, an arylene group or a divalent hetero ring group, and these groups optionally have a substituent. R^{H21} represents a hydrogen atom, an alkyl group, a cycloalkyl group, an aryl group or a monovalent hetero ring group, and these groups optionally have a substituent.] 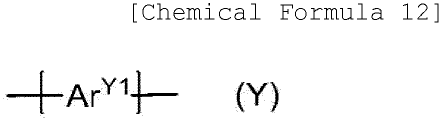
[wherein, Ar^{Y1} represents an arylene group, a divalent hetero ring group, or a divalent group in which an arylene group and a divalent hetero ring group are bonded directly, and these groups optionally have a substituent.].

[10] A composition comprising the metal complex as described in any one of [1] to [8], and at least one material selected from the group consisting of a hole transporting material, a hole injection material, an electron transporting material, an electron injection material, a light emitting material, an antioxidant and a solvent.

[11] A light emitting device comprising the metal complex as described in any one of [1] to [8].

### Effect of the Invention

According to the present invention, it is possible to provide a metal complex which is useful for production of a light emitting device of which long-term degradation is suppressed. Further, according to the present invention, it is possible to provide a composition comprising the metal complex, and a light emitting device comprising the metal complex.

### Modes for a carrying out the Invention

Hereinafter, suitable embodiments of the present invention will be illustrated in detail.

### <Explanation of common terms>

The terms commonly used in the present specification have the following meanings unless otherwise stated.

Me represents a methyl group, Et represents an ethyl group, a bu represents a butyl group, i-Pr represents an isopropyl group, and t-Bu represents a tert-butyl group.

The hydrogen atom may be a heavy hydrogen atom or a light hydrogen atom.

In the formula representing a metal complex, the solid line representing a bond to the central metal denotes a covalent bond or a coordinate bond.

"The low molecular compound" means a compound having no molecular weight distribution and having a molecular weight of 1 × 10⁴ or less.

"The polymer compound" means a polymer having molecular weight distribution and having a polystyreneequivalent number-average molecular weight of 1 × 10³ or more (for example, 1 × 10³ to 1 × 10⁸) .

"The constitutional unit" means a unit occurring once or more times in a polymer compound. The constitutional unit occurring twice or more times in a polymer compound is in general also called "repeating unit".

The polymer compound may be any of a block copolymer, a random copolymer, an alternate copolymer and a graft copolymer, and may also be in another configuration.

The end group of a polymer compound is preferably a stable group, since if a polymerization active group remains intact there, the light-emitting property or luminance life may possibly lower when the polymer compound is used for fabricating a light emitting device. The end group of a polymer compound is preferably a group conjugatively bonded to the main chain, and includes, for example, an aryl group and a monovalent hetero ring group bonding to the main chain of a polymer compound via a carbon-carbon bond.

"The alkyl group" may be any of linear and branched. The number of carbon atoms of the the linear alkyl group is usually 1 to 50, preferably 3 to 30, more preferably 4 to 20, not including the number of carbon atoms of the substituent. The number of carbon atoms of the the branched alkyl group is usually 3 to 50, preferably 3 to 30, more preferably 4 to 20, not including the number of carbon atoms of the substituent.

The alkyl group optionally has a substituent. The alkyl group includes, for example, a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group, and a dodecyl group. Further, the alkyl group may be a group obtained by substituting a part or all of hydrogen atoms in these groups with a cycloalkyl group, an alkoxy group, a cycloalkoxy group, an aryl group, a fluorine atom, and the like. The alkyl group as described above includes, for example, a trifluoromethyl group, a pentatrifluoroethyl group, a pertrifluorobutyl group, a pertrifluorohexyl group, a pertrifluorooctyl group, a 3-phenylpropyl group, a 3-(4-methylphenyl)propyl group, a 3-(3,5-di-hexylphenyl)propyl group, and a 6-ethyloxyhexyl group.

The number of carbon atoms of the "cycloalkyl group" is usually 3 to 50, preferably 3 to 30, more preferably 4 to 20, not including the number of carbon atoms of the substituent. The cycloalkyl group optionally has a substituent. The cycloalkyl group includes, for example, a cyclohexyl group, a cyclohexylmethyl group, and a cyclohexylethyl group.

"The aryl group" means an atomic group remaining after removing from an aromatic hydrocarbon one hydrogen atom bonding directly to a carbon atom constituting the ring. The number of carbon atoms of the aryl group is usually 6 to 60, preferably 6 to 20, more preferably 6 to 10, not including the number of carbon atoms of the substituent.

The aryl group optionally has a substituent. The aryl group includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, and a 4-phenylphenyl group. Further, the aryl group may be a group obtained by substituting a part or all of hydrogen atoms in these groups with an alkyl group, a cycloalkyl group, an alkoxy group, a cycloalkoxy group, an aryl group, a fluorine atom, and the like.

"The alkoxy group" may be any of linear and branched. The number of carbon atoms of the linear alkoxy group is usually 1 to 40, preferably 4 to 10, not including the number of carbon atoms of the substituent. The number of carbon atoms of the branched alkoxy group is usually 3 to 40, preferably 4 to 10, not including the number of carbon atoms of the substituent.

The alkoxy group optionally has a substituent. The alkoxy group includes, for example, methoxy group, ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group, and a lauryloxy group. Further, the alkoxy group may be a group obtained by substituting a part or all of hydrogen atoms in these groups with a cycloalkyl group, an alkoxy group, a cycloalkoxy group, an aryl group, a fluorine atom, and the like.

The number of carbon atoms of the "cycloalkoxy group" is usually 3 to 40, preferably 4 to 10, not including the number of carbon atoms of the substituent.

The cycloalkoxy group optionally has a substituent. The cycloalkoxy group includes, for example, a cyclohexyloxy group.

The number of carbon atoms of the "aryloxy group" is usually 6 to 60, preferably 6 to 48, not including the number of carbon atoms of the substituent.

The aryloxy group optionally has a substituent. The aryloxy group includes, for example, a phenoxy group, a 1-naphthyloxy group, a 2-naphthyloxy group, a 1-anthracenyloxy group, a 9-anthracenyloxy group, and a 1-pyrenyloxy group. Further, the aryloxy group may be a group obtained by substituting a part or all of hydrogen atoms in these groups with an alkyl group, a cycloalkyl group, an alkoxy group, a cycloalkoxy group, a fluorine atom, and the like.

"The p-valent hetero ring group" (p represents an integer of 1 or more) means an atomic group remaining after removing from a heterocyclic compound p hydrogen atoms among hydrogen atoms bonding directly to carbon atoms or hetero atoms constituting the ring. Of the p-valent hetero ring groups, "p-valent aromatic hetero ring group" which is an atomic group remaining after removing from an aromatic heterocyclic compound p hydrogen atoms among hydrogen atoms bonding directly carbon atoms or hetero atoms constituting the ring is preferable.

"The aromatic heterocyclic compound" includes, for example, compounds of which hetero ring itself shows aromaticity such as azole, thiophene, furan, pyridine, diazabenzene, triazine, azanaphthalene, diazanaphthalene and carbazole and the like, and compounds in which an aromatic ring is condensed to the hetero ring though the hetero ring itself shows no aromaticity such as phenoxazine, phenothiazine and benzopyran and the like.

The number of carbon atoms of the monovalent hetero ring group is usually 2 to 60, preferably 4 to 20, not including the number of carbon atoms of the substituent.

The monovalent hetero ring group optionally has a substituent. The monovalent hetero ring group includes, for example, a thienyl group, a pyrrolyl group, a furyl group, a pyridinyl group, a piperidinyl group, a quinolinyl group, an isoquinolinyl group, a pyrimidinyl group, and a triazinyl group. Further, the monovalent hetero ring group may be a group obtained by substituting a part or all of hydrogen atoms in these groups with an alkyl group, a cycloalkyl group, an alkoxy group, a cycloalkoxy group, and the like.

"The halogen atom" denotes a fluorine atom, a chlorine atom, a bromine atom or an iodine atom.

"The amino group" optionally has a substituent, and substituted amino groups (preferably secondary amino group or tertiary amino groups, more preferably tertiary amino groups) are preferred. The substituent which an amino group has is preferably an alkyl group, a cycloalkyl group, an aryl group or a monovalent hetero ring group. When a plurality of the substituents which an amino group has are present, they may be the same or different, and may be combined together to form a ring together with nitrogen atoms to which they are attached.

The substituted amino group includes, for example, dialkylamino groups (for example, a dimethylamino group, a diethylamino group), dicycloalkylamino groups, and diarylamino groups (for example, a diphenylamino group, a bis(4-methylphenyl)amino group, a bis(4-tert-butylphenyl)amino group, a bis(3,5-di-tert-butylphenyl)amino group).

"The alkenyl group" may be any of linear and branched. The number of carbon atoms of the linear alkenyl group is usually 2 to 30, preferably 3 to 20, not including the number of carbon atoms of the substituent. The number of carbon atoms of the branched alkenyl group is usually 3 to 30, preferably 4 to 20, not including the number of carbon atoms of the substituent.

The number of carbon atoms of the "cycloalkenyl group" is usually 3 to 30, preferably 4 to 20, not including the number of carbon atoms of the substituent.

The alkenyl group and the cycloalkenyl group optionally have a substituent. The alkenyl group includes, for example, a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and groups obtained by substituting a part or all of hydrogen atoms in these groups with substituents. The cycloalkenyl group includes, for example, a cyclohexenyl group, a cyclohexadienyl group, a cyclooctatrienyl group, a norbornylenyl group, and groups obtained by substituting a part or all of hydrogen atoms in these groups with substituents.

"The alkynyl group" may be any of linear and branched. The number of carbon atoms of the linear alkynyl group is usually 2 to 20, preferably 3 to 20, not including carbon atoms of the substituent. The number of carbon atoms of the branched alkynyl group is usually 4 to 30, preferably 4 to 20, not including carbon atoms of the substituent.

The number of carbon atoms of the "cycloalkynyl group" is usually 4 to 30, preferably 4 to 20, not including carbon atoms of the substituent.

The alkynyl group and the cycloalkynyl group optionally have a substituent. The alkynyl group includes, for example, ethynyl group, a 1-propynyl group, a 2-propynyl group, a 2-butynyl group, a 3-butynyl group, a 3-pentynyl group, a 4-pentynyl group, a 1-hexynyl group, a 5-hexynyl group, and groups obtained by substituting a part or all of hydrogen atoms in these groups with substituents. The cycloalkynyl group includes, for example, a cyclooctynyl group, and groups obtained by substituting a part or all of hydrogen atoms in these groups with substituents.

"The arylene group" means an atomic group remaining after removing two hydrogen atoms bonding directly to carbon atoms constituting the ring. The number of carbon atoms of the arylene group is usually 6 to 60, preferably 6 to 30, more preferably 6 to 18, not including the number of carbon atoms of the substituent.

The arylene group optionally has a substituent. The arylene group includes, for example, a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and groups obtained by substituting a part or all of hydrogen atoms in these groups with substituents. The arylene group is preferably a group represented by the formula (A-1) to the formula (A-20). The arylene group includes a group in which a plurality of these groups are bonded. 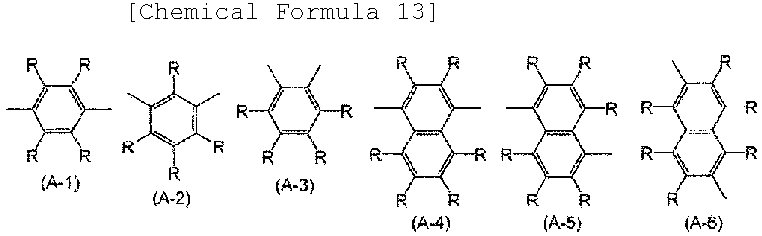 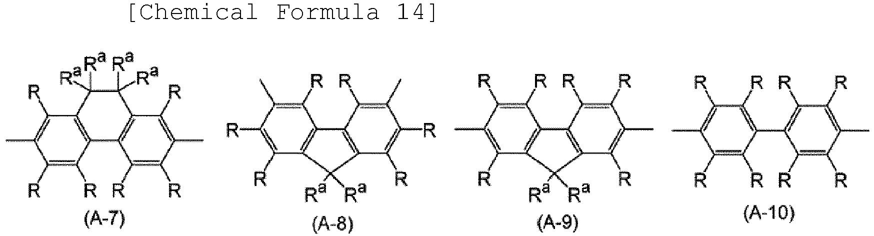 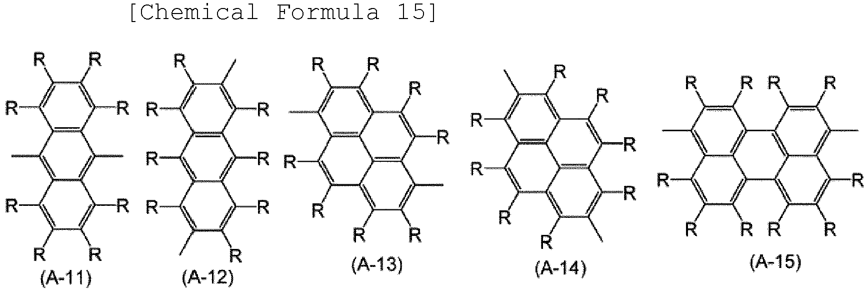 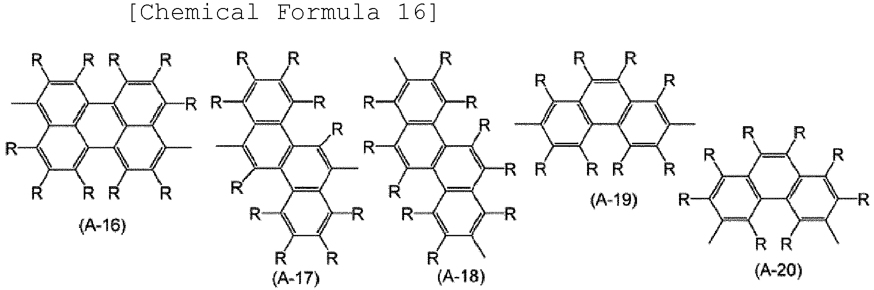 (wherein, R and R^{a} each independently represent a hydrogen atom, an alkyl group, a cycloalkyl group, an aryl group or a monovalent hetero ring group. A plurality of R and R^{a} each may be the same or different, and the groups R^{a} may be combined together to form a ring together with atoms to which they are attached.)

The number of carbon atoms of the divalent hetero ring group is usually 2 to 60, preferably 3 to 20, more preferably 4 to 15, not including the number of carbon atoms of the substituent.

The divalent hetero ring group optionally has a substituent. The divalent hetero ring group includes divalent groups obtained by removing from, for example, pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole or triazole two hydrogen atoms among hydrogen atoms bonding directly to carbon atoms or hetero atoms constituting the ring. Further, the divalent hetero ring group may be a group obtained by substituting a part or all of hydrogen atoms in these groups with substituents. The divalent hetero ring group is preferably a group represented by the formula (AA-1) to the formula (AA-34). The divalent hetero ring group includes groups in which a plurality of these groups are bonded. 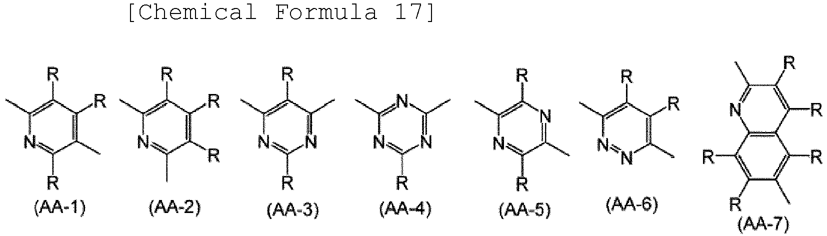 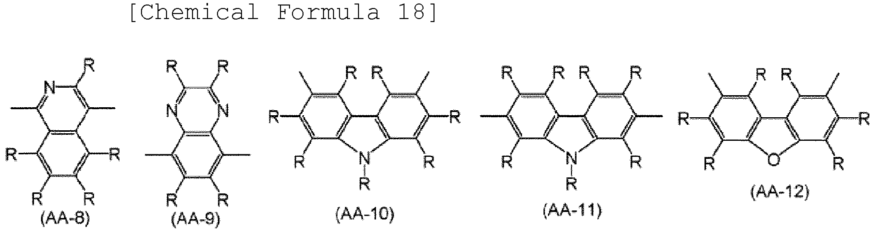 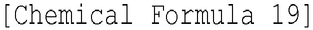 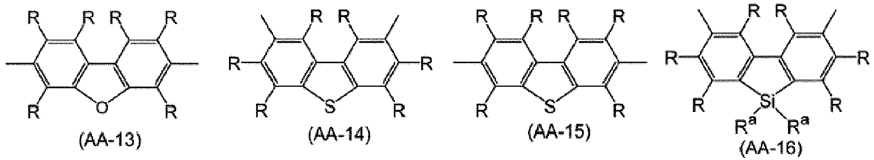 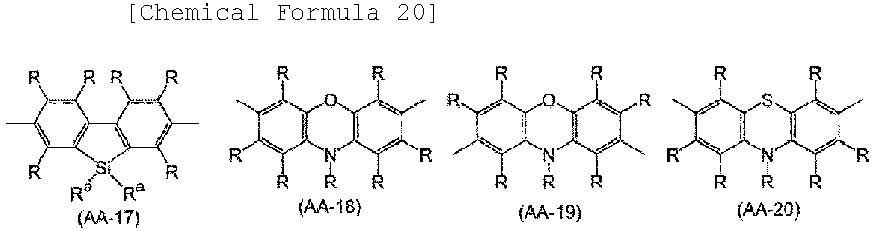 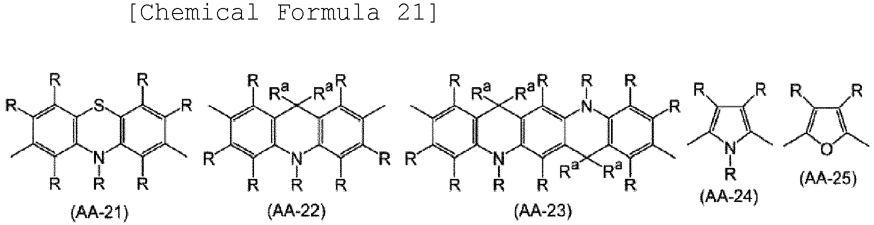 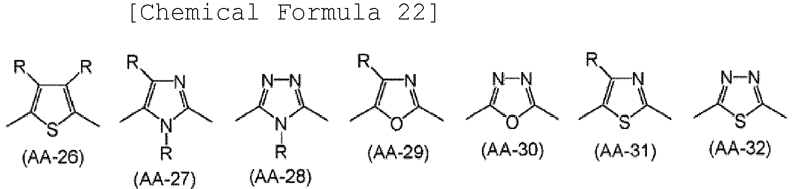 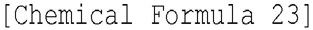 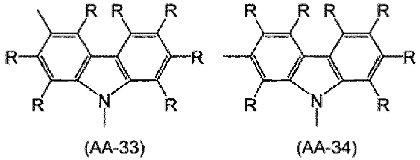 (wherein, R and R^{a} represent the same meaning as described above.)

The "crosslinkable group" is a group capable of forming a new bond by being subjected to heating, ultraviolet irradiation, near-ultraviolet irradiation, visible light irradiation, infrared irradiation, radical reaction and the like. The crosslinkable group is preferably a group represented by any of the formula (B-1) to the formula (B-18). These groups optionally have a substituent, and substituents carried on respective groups may be combined together to form a ring.

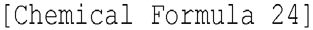

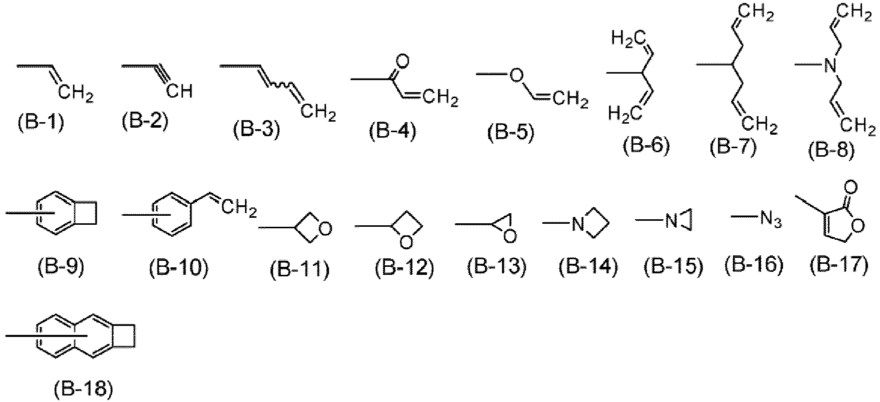

"The substituent" represents a halogen atom, a cyano group, an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group or a cycloalkynyl group. The substituent may be a crosslinkable group.

### <Metal complex>

Next, the metal complex of the present embodiment will be illustrated. The metal complex of the present embodiment is a metal complex represented by the formula (1) .

The metal complex represented by the formula (1) is usually a metal complex showing phosphorescence at room temperature (25°C), preferably a metal complex showing light emission from the triplet excited state at room temperature.

The metal complex represented by the formula (1) is constituted of M as the central metal, a ligand of which number is defined by the suffix n¹, and a ligand of which number is defined by the suffix n².

M is preferably an iridium atom, since the long-term degradation of a light emitting device using the metal complex of the present embodiment is more suppressed.

n² is preferably 0 (in other words, for example, n¹ is preferably 3 when M is an iridium atom), since the long-term degradation of a light emitting device using the metal complex of the present embodiment is more suppressed.

For Ring R^{A}, the number of carbon atoms of the aromatic hetero ring is usually 2 to 60, preferably 3 to 30, more preferably 4 to 15, not including the number of carbon atoms of the substituent.

The aromatic hetero ring represented by Ring R^{A} includes, for example, a pyrrole ring, a diazole ring, a triazole ring, a furan ring, a thiophene ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a dibenzosilole ring, a dibenzophosphole ring, a carbazole ring, an azacarbazole ring, a diazacarbazole ring, a phenoxazine ring, a phenothiazine ring, a dihydroacridine ring and a dihydrophenazine ring, preferably a pyridine ring, a diazabenzene ring, an azanaphthalene ring, a diazanaphthalene ring, an azaanthracene ring, a diazaphenanthrene ring, a dibenzofuran ring, a dibenzothiophene ring, a carbazole ring, a phenoxazine ring, a phenothiazine ring, a dihydroacridine ring or a dihydrophenazine ring, more preferably a pyridine ring, a diazabenzene ring, an azanaphthalene ring, a diazanaphthalene ring, a dibenzofuran ring, a dibenzothiophene ring or a carbazole ring, further preferably a pyridine ring or a diazabenzene ring, and these rings optionally have a substituent.

Ring R^{A} optionally has a group represented by the formula (D-A), the formula (D-B) or the formula (D-C) as a substituent.

In addition to the group represented by the formula (D-A), the formula (D-B) or the formula (D-C), the substituent which Ring R^{A} optionally has is preferably an alkyl group, a cycloalkyl group, an alkoxy group, a cycloalkoxy group, an aryl group, an aryloxy group, a monovalent hetero ring group, a substituted amino group or a halogen atom; and since synthesis of the metal complex of the present embodiment is facilitated, it is more preferably an alkyl group, a cycloalkyl group, an aryl group, a monovalent hetero ring group or a halogen atom, further preferably an alkyl group, a cycloalkyl group or an aryl group.

For the substituent which Ring R^{A} optionally has, the number of carbon atoms of the aryl group is usually 6 to 60, preferably 6 to 40, more preferably 6 to 25, not including the number of carbon atoms of the substituent.

For the substituent which Ring R^{A} optionally has, the aryl group includes, for example, groups obtained by removing from a benzene ring, a naphthalene ring, an anthracene ring, an indene ring, a fluorene ring, a spirobifluorene ring, a phenanthrene ring, a dihydrophenanthrene ring, a pyrene ring, a chrysene ring, a triphenylene ring, or a ring in which these rings are condensed one hydrogen atom bonding directly to a carbon atom constituting the ring, preferably groups obtained by removing from a benzene ring, a naphthalene ring, a fluorene ring, a spirobifluorene ring, a phenanthrene ring, a dihydrophenanthrene ring or a triphenylene ring one hydrogen atom bonding directly to a carbon atom constituting the ring, more preferably groups obtained by removing from a benzene ring, a fluorene ring or a spirobifluorene ring one hydrogen atom bonding directly to a carbon atom constituting the ring, further preferably groups obtained by removing from a benzene ring one hydrogen atom bonding directly to a carbon atom constituting the ring, and these groups optionally further have a substituent.

For the substituent which Ring R^{A} optionally has, the aryloxy group includes groups represented by -O-Ar¹ (Ar¹ represents an aryl group, and the aryl group optionally has a substituent). The examples and preferable ranges of the aryl group represented by Ar¹ are the same as the examples and preferable ranges of the aryl group as the substituent which Ring R^{A} optionally has.

For the substituent which Ring R^{A} optionally has, the number of carbon atoms of the monovalent hetero ring group is usually 2 to 60, preferably 3 to 30, more preferably 3 to 15, not including the number of carbon atoms of the substituent.

For the substituent which Ring R^{A} optionally has, the monovalent hetero ring group includes, for example, groups obtained by removing from a pyrrole ring, a diazole ring, a triazole ring, a furan ring, a thiophene ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a dibenzosilole ring, a dibenzophosphole ring, a carbazole ring, an azacarbazole ring, a diazacarbazole ring, a phenoxazine ring, a phenothiazine ring, a dihydroacridine ring, a dihydrophenazine ring, or a ring in which an aromatic ring is condensed to these rings one hydrogen atom bonding directly to a carbon atom or a hetero atom constituting the ring, preferably groups obtained by removing from a pyridine ring, a diazabenzene ring, a triazine ring, an azanaphthalene ring, a diazanaphthalene ring, a dibenzofuran ring, a dibenzothiophene ring, a carbazole ring, an azacarbazole ring, a diazacarbazole ring, a phenoxazine ring or a phenothiazine ring one hydrogen atom bonding directly to a carbon atom or a hetero atom constituting the ring, more preferably groups obtained by removing from a pyridine ring, a diazabenzene ring, a triazine ring, a dibenzofuran ring, a dibenzothiophene ring, a carbazole ring, an azacarbazole ring, a diazacarbazole ring, a phenoxazine ring, a phenothiazine ring, a dihydroacridine ring or a dihydrophenazine ring one hydrogen atom bonding directly to a carbon atom or a hetero atom constituting the ring, further preferably groups obtained by removing from a triazine ring one hydrogen atom bonding directly to a carbon atom constituting the ring, and these rings optionally have a substituent.

For the substituted amino group as the substituent which Ring R^{A} optionally has, the substituent which an amino group has is preferably an aryl group or a monovalent hetero ring group, more preferably an aryl group, and these groups optionally further have a substituent. The examples and preferable ranges of the aryl group as the substituent which an amino group has are the same as the examples and preferable ranges of the aryl group as the substituent which Ring R^{A} optionally has. The examples and preferable ranges of the monovalent hetero ring group as the substituent which an amino group has are the same as the examples and preferable ranges of the monovalent hetero ring group as the substituent which Ring R^{A} optionally has.

For the substituent which Ring R^{A} optionally has, the halogen atom is preferably a fluorine atom or a chlorine atom, more preferably a fluorine atom.

The substituent which the substituent which Ring R^{A} optionally has optionally further has is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group or a monovalent hetero ring group, further preferably an alkyl group or an aryl group, and these groups optionally further have a substituent.

The examples and preferable ranges of the aryl group, the aryloxy group, the monovalent hetero ring group, the substituted amino group and the halogen atom as the substituent which the substituent which Ring R^{A} optionally has optionally further has are the same as the examples and preferable ranges of the aryl group, the aryloxy group, the monovalent hetero ring group, the substituted amino group and the halogen atom as the substituent which Ring R^{A} optionally has, respectively.

For Ring R^{B1}, Ring R^{B2}, Ring R^{C1} and Ring R^{C2}, the number of carbon atoms of the aromatic hydrocarbon ring is usually 6 to 60, preferably 6 to 30, more preferably 6 to 18, not including the number of carbon atoms of the substituent.

The aromatic hydrocarbon ring represented by Ring R^{B1}, Ring R^{B2}, Ring R^{C1} and Ring R^{C2} includes, for example, a benzene ring, a naphthalene ring, an anthracene ring, an indene ring, a fluorene ring, a spirobifluorene ring, a phenanthrene ring, a dihydrophenanthrene ring, a pyrene ring, a chrysene ring and triphenylene ring, preferably a benzene ring, a naphthalene ring, an anthracene ring, a fluorene ring, a spirobifluorene ring, a phenanthrene ring or a dihydrophenanthrene ring, more preferably a benzene ring, a naphthalene ring, a fluorene ring or a spirobifluorene ring, further preferably a benzene ring, and these rings optionally have a substituent.

For Ring R^{B1}, Ring R^{B2}, Ring R^{C1} and Ring R^{C2}, the number of carbon atoms of the aromatic hetero ring is usually 2 to 60, preferably 3 to 30, more preferably 4 to 15, not including the number of carbon atoms of the substituent.

The aromatic hetero ring represented by Ring R^{B1}, Ring R^{B2}, Ring R^{C1} and Ring R^{C2} includes, for example, a pyrrole ring, a diazole ring, a triazole ring, a furan ring, a thiophene ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a dibenzosilole ring, a dibenzophosphole ring, a carbazole ring, an azacarbazole ring, a diazacarbazole ring, a phenoxazine ring, a phenothiazine ring, a dihydroacridine ring and a dihydrophenazine ring, preferably a pyridine ring, a diazabenzene ring, an azanaphthalene ring, a diazanaphthalene ring, an azaanthracene ring, a diazaphenanthrene ring, a dibenzofuran ring, a dibenzothiophene ring, a carbazole ring, a phenoxazine ring, a phenothiazine ring, a dihydroacridine ring or a dihydrophenazine ring, more preferably a pyridine ring, a diazabenzene ring, an azanaphthalene ring, a diazanaphthalene ring, a dibenzofuran ring, a dibenzothiophene ring or a carbazole ring, further preferably a pyridine ring or a diazabenzene ring, and these rings optionally have a substituent.

For Ring R^{B1}, Ring R^{B2}, Ring R^{C1} and Ring R^{C2}, it is preferable that at least one of Ring R^{B1}, Ring R^{B2}, Ring R^{C1} and Ring R^{C2} is an aromatic hydrocarbon ring, it is more preferable that two or more of Ring R^{B1}, Ring R^{B2}, Ring R^{C1} and Ring R^{C2} are aromatic hydrocarbon rings, and it is further preferable that all of Ring R^{B1}, Ring R^{B2}, Ring R^{C1} and Ring R^{C2} are aromatic hydrocarbon rings.

Ring R^{B1}, Ring R^{B2}, Ring R^{C1} and Ring R^{C2} optionally have a group represented by the formula (D-A), the formula (D-B) or the formula (D-C) as a substituent.

In addition to the group represented by the formula (D-A), the formula (D-B) or the formula (D-C), the substituent which Ring R^{B1}, Ring R^{B2}, Ring R^{C1} and Ring R^{C2} optionally have is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group, a monovalent hetero ring group or a substituted amino group, further preferably an aryl group or a monovalent hetero ring group, a particularly preferably a monovalent hetero ring group. These groups optionally further have a substituent.

For the substituent which Ring R^{B1}, Ring R^{B2}, Ring R^{C1} and Ring R^{C2} optionally have, the number of carbon atoms of the aryl group is usually 6 to 60, preferably 6 to 40, more preferably 6 to 25, not including the number of carbon atoms of the substituent.

For the substituent which Ring R^{B1}, Ring R^{B2}, Ring R^{C1} and Ring R^{C2} optionally have, the aryl group includes, for example, groups obtained by removing from a benzene ring, a naphthalene ring, an anthracene ring, an indene ring, a fluorene ring, a spirobifluorene ring, a phenanthrene ring, a dihydrophenanthrene ring, a pyrene ring, a chrysene ring, a triphenylene ring, or a ring in which these rings are condensed one hydrogen atom bonding directly to a carbon atom constituting the ring, preferably groups obtained by removing from a benzene ring, a naphthalene ring, a fluorene ring, a spirobifluorene ring, a phenanthrene ring, a dihydrophenanthrene ring or a triphenylene ring one hydrogen atom bonding directly to a carbon atom constituting the ring, more preferably groups obtained by removing from a benzene ring, a fluorene ring or a spirobifluorene ring one hydrogen atom bonding directly to a carbon atom constituting the ring, further preferably groups obtained by removing from a benzene ring one hydrogen atom bonding directly to a carbon atom constituting the ring, and these groups optionally further have a substituent.

For the substituent which Ring R^{B1}, Ring R^{B2}, Ring R^{C1} and Ring R^{C2} optionally have, the aryloxy group includes groups represented by -O-Ar² (Ar² represents an aryl group, and the aryl group optionally has a substituent). The examples and preferable ranges of the aryl group represented by Ar² are the same as the examples and preferable ranges of the aryl group as the substituent which Ring R^{B1}, Ring R^{B2}, Ring R^{C1} and Ring R^{C2} optionally have.

For the substituent which Ring R^{B1}, Ring R^{B2}, Ring R^{C1} and Ring R^{C2} optionally have, the number of carbon atoms of the monovalent hetero ring group is usually 2 to 60, preferably 3 to 30, more preferably 3 to 15, not including the number of carbon atoms of the substituent.

For the substituent which Ring R^{B1}, Ring R^{B2}, Ring R^{C1} and Ring R^{C2} optionally have, the monovalent hetero ring group includes, for example, groups obtained by removing from a pyrrole ring, a diazole ring, a triazole ring, a furan ring, a thiophene ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a dibenzosilole ring, a dibenzophosphole ring, a carbazole ring, an azacarbazole ring, a diazacarbazole ring, a phenoxazine ring, a phenothiazine ring, a dihydroacridine ring, a dihydrophenazine ring, or a ring in which an aromatic ring is condensed to these rings one hydrogen atom bonding directly to a carbon atom or a hetero atom constituting the ring, preferably groups obtained by removing from a pyridine ring, a diazabenzene ring, a triazine ring, an azanaphthalene ring, a diazanaphthalene ring, a dibenzofuran ring, a dibenzothiophene ring, a carbazole ring, an azacarbazole ring, a diazacarbazole ring, a phenoxazine ring or a phenothiazine ring one hydrogen atom bonding directly to a carbon atom or a hetero atom constituting the ring, more preferably groups obtained by removing from a pyridine ring, a diazabenzene ring, a triazine ring, a dibenzofuran ring, a dibenzothiophene ring, a carbazole ring, an azacarbazole ring, a diazacarbazole ring, a phenoxazine ring, a phenothiazine ring, a dihydroacridine ring or a dihydrophenazine ring one hydrogen atom bonding directly to a carbon atom or a hetero atom constituting the ring, further preferably groups obtained by removing from a dibenzofuran ring, a dibenzothiophene ring, a carbazole ring, a phenoxazine ring, a phenothiazine ring, a dihydroacridine ring or a dihydrophenazine ring one hydrogen atom bonding directly to a carbon atom or a hetero atom constituting the ring, particularly preferably groups obtained by removing from a dibenzofuran ring or a dibenzothiophene ring one hydrogen atom bonding directly to a carbon atom constituting the ring, and these rings optionally have a substituent.

For the substituted amino group as the substituent which Ring R^{B1}, Ring R^{B2}, Ring R^{C1} and Ring R^{C2} optionally have, the substituent which an amino group has is preferably an aryl group or a monovalent hetero ring group, more preferably an aryl group, and these groups optionally further have a substituent. The examples and preferable ranges of the aryl group as the substituent which an amino group has are the same as the examples and preferable ranges of the aryl group as the substituent which Ring R^{B1}, Ring R^{B2}, Ring R^{C1} and Ring R^{C2} optionally have. The examples and preferable ranges of the monovalent hetero ring group as the substituent which an amino group has are the same as the examples and preferable ranges of the monovalent hetero ring group as the substituent which Ring R^{B1}, Ring R^{B2}, Ring R^{C1} and Ring R^{C2} optionally have.

For the substituent which Ring R^{B1}, Ring R^{B2}, Ring R^{C1} and Ring R^{C2} optionally have, the halogen atom is preferably a fluorine atom or a chlorine atom, more preferably a fluorine atom.

The substituent which the substituent which Ring R^{B1}, Ring R^{B2}, Ring R^{C1} and Ring R^{C2} optionally have optionally further has is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group or a monovalent hetero ring group, further preferably an alkyl group or an aryl group, and these groups optionally further have a substituent.

The examples and preferable ranges of the aryl group, the aryloxy group, the monovalent hetero ring group, the substituted amino group and the halogen atom as the substituent which the substituent which Ring R^{B1}, Ring R^{B2}, Ring R^{C1} and Ring R^{C2} optionally have optionally further has are the same as the examples and preferable ranges of the aryl group, the aryloxy group, the monovalent hetero ring group, the substituted amino group and the halogen atom as the substituent which Ring R^{B1}, Ring R^{B2}, Ring R^{C1} and Ring R^{C2} optionally have, respectively.

Since the long-term degradation of the light emitting device comprising the metal complex of the present embodiment is more suppressed, it is preferable that at least one of Ring R^{B1}, Ring R^{B2}, Ring R^{C1} and Ring R^{C2} has an aryl group or a monovalent hetero ring group as a substituent, it is more preferable that at least one of Ring R^{B1}, Ring R^{B2}, Ring R^{C1} and Ring R^{C2} has an aryl group as a substituent, and it is further preferable that Ring R^{B2} has an aryl group as a substituent.

When at least one of Ring R^{B1}, Ring R^{B2}, Ring R^{C1} and Ring R^{C2} has an aryl group or a monovalent hetero ring group, the total number of the aryl group and the monovalent hetero ring group which Ring R^{B1}, Ring R^{B2}, Ring R^{C1} and Ring R^{C2} have as a substituent is preferably 1 to 5, more preferably 1 to 3, further preferably 1 or 2, particularly preferably 1.

R^{C} is preferably a carbon atom, a silicon atom or a germanium atom, more preferably a carbon atom or a silicon atom, further preferably a carbon atom, since the long-term degradation of the light emitting device comprising the metal complex of the present embodiment is more suppressed.

The group represented by the formula (C-1) includes, for example, groups represented by the formula (C-2).

The examples and preferable ranges of the aryl group, the aryloxy group, the monovalent hetero ring group, the substituted amino group and the halogen atom represented by R^{C11}, R^{C12}, R^{C13}, R^{C14}, R^{C21}, R^{C22}, R^{C23} and R^{C24} are the same as the examples and preferable ranges of the aryl group, the aryloxy group, the monovalent hetero ring group, the substituted amino group and the halogen atom as the substituent which Ring R^{C1} and Ring R^{C2} optionally have, respectively,.

The examples and preferable ranges of the substituent which each group represented by R^{C11}, R^{C12}, R^{C13}, R^{C14}, R^{C21}, R^{C22}, R^{C23} and R^{C24} optionally further has are the same as the examples and preferable ranges of the substituent which the substituent which Ring R^{C1} and Ring R^{C2} optionally have optionally further has.

R^{C11}, R^{C12}, R^{C13}, R^{C14}, R^{C21}, R^{C22}, R^{C23} and R^{C24} represent preferably a hydrogen atom, an alkyl group, a cycloalkyl group, an aryl group or a monovalent hetero ring group, more preferably a hydrogen atom, an alkyl group, a cycloalkyl group or an aryl group, further preferably a hydrogen atom, an alkyl group or an aryl group, when they are groups other than the group represented by the formula (D-A), the formula (D-B) or the formula (D-C), since long-term degradation is more suppressed.

For the metal complex represented by the formula (1), at least one of Ring R^{A}, Ring R^{B1}, Ring R^{B2}, Ring R^{C1} and Ring R^{C2} has a group represented by the formula (D-A), the formula (D-B) or the formula (D-C) as a substituent.

It is preferable that a group represented by the formula (D-A), the formula (D-B) or the formula (D-C) is substituted on Ring R^{A}. Further, when Ring R^{A} is a 6-membered ring, it is preferable that a group represented by the formula (D-A), the formula (D-B) or the formula (D-C) is substituted on the para position with respect to a carbon atom bonding to Ring R^{B1} (that is, for example, R² in the formula (1-A) described later). By this configuration, the long-term degradation of the light emitting device comprising the metal complex of the present embodiment is more suppressed.

Of groups represented by the formula (D-A), the formula (D-B) or the formula (D-C), a group represented by the formula (D-A) is more preferable, a group represented by the formula (D-A1), the formula (D-A2) or the formula (D-A3) is further preferable, and a group represented by the formula (D-A3) is particularly preferable, since the long-term degradation of the light emitting device comprising the metal complex of the present embodiment is more suppressed.

The metal complex represented by the formula (1) includes, for example, metal complexes represented by the formula (1-A). 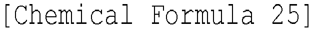 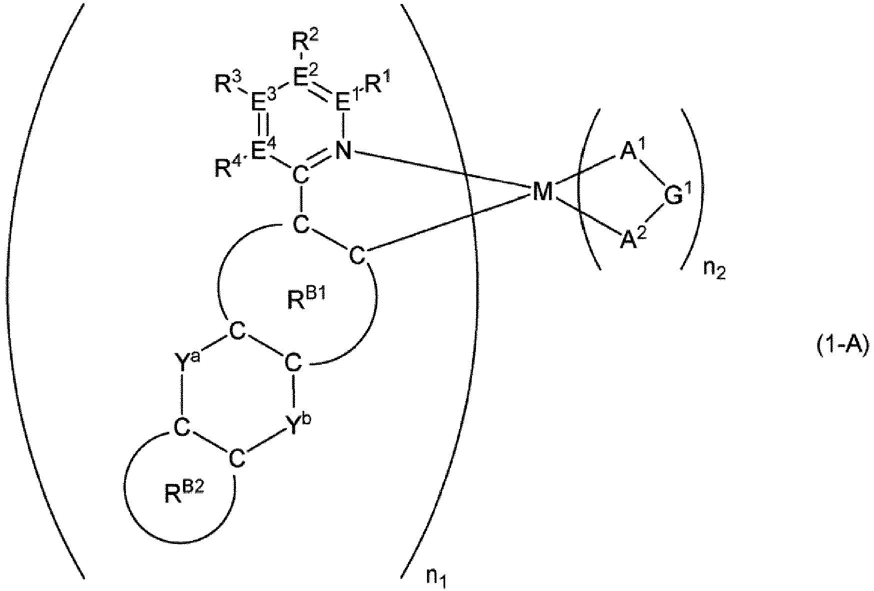 [wherein, M, n¹, n², Ring R^{B1}, Ring R^{B2}, Y^{a}, Y^{b} and A¹-G¹-A² represent the same meaning as described above.
E¹, E², E³ and E⁴ each independently represent a nitrogen atom or a carbon atom. When a plurality of E¹, E², E³ and E⁴ are present, they may be the same or different at each occurrence. When E¹ is a nitrogen atom, R¹ is not present. When E² is a nitrogen atom, R² is not present. When E³ is a nitrogen atom, R³ is not present. When E⁴ is a nitrogen atom, R⁴ is not present.
R¹, R², R³ and R⁴ each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom, a group represented by the formula (D-A), a group represented by the formula (D-B) or a group represented by the formula (D-C), and these groups optionally have a substituent. When a plurality of R¹, R², R³ and R⁴ are present, they may be the same or different at each occurrence.]

E¹, E², E³ and E⁴ represent preferably a carbon atom, since synthesis of the metal complex of the present embodiment is facilitated.

The examples and preferable ranges of the aryl group, the aryloxy group, the monovalent hetero ring group, the substituted amino group and the halogen atom represented by R¹, R², R³ and R⁴ are the same as the examples and preferable ranges of the aryl group, the aryloxy group, the monovalent hetero ring group, the substituted amino group and the halogen atom as the substituent which Ring R^{A} optionally has, respectively.

The examples and preferable ranges of the substituent which each group represented by R¹, R², R³ and R⁴ optionally further has are the same as the examples and preferable ranges of the substituent which the substituent which Ring R^{A} optionally has optionally further has.

R¹, R², R³ and R⁴ represent preferably a hydrogen atom, an alkyl group, a cycloalkyl group, an aryl group, a monovalent hetero ring group or a halogen atom, more preferably a hydrogen atom, an alkyl group, a cycloalkyl group or an aryl group, further preferably a hydrogen atom, when they are groups other than the group represented by the formula (D-A), the formula (D-B) or the formula (D-C), since synthesis of the metal complex of the present embodiment is facilitated.

The metal complex represented by the formula (1-A) includes, for example, a metal complex represented by the formula (1-A1) , a metal complex represented by the formula (1-A2), and A metal complex represented by the formula (1-A3) .

The examples and preferable ranges of the aryl group, the aryloxy group, the monovalent hetero ring group, the substituted amino group and the halogen atom represented by R⁵, R⁶, R⁷, R⁸, R⁹, R¹⁰, R¹¹ and R¹² are the same as the examples and preferable ranges of the aryl group, the aryloxy group, the monovalent hetero ring group, the substituted amino group and the halogen atom as the substituent which Ring R^{B1} and Ring R^{B2} optionally have, respectively,.

The examples and preferable ranges of the substituent which each group represented by R⁵, R⁶, R⁷, R⁸, R⁹, R¹⁰, R¹¹ and R¹² optionally further has are the same as the examples and preferable ranges of the substituent which the substituent which Ring R^{B1} and Ring R^{B2} optionally have optionally further has.

R⁵, R⁶, R⁷, R⁸, R⁹, R¹⁰, R¹¹ and R¹² represent preferably a hydrogen atom, an alkyl group, a cycloalkyl group, an aryl group or a monovalent hetero ring group, more preferably a hydrogen atom, an alkyl group, a cycloalkyl group or an aryl group, further preferably a hydrogen atom, an alkyl group or an aryl group, when they are groups other than the group represented by the formula (D-A), the formula (D-B) or the formula (D-C), since long-term degradation is more suppressed.

It is preferable that at least one of R⁶, R⁷, R⁸ and R⁹ is an aryl group or a monovalent hetero ring group (more preferably aryl group), it is more preferable that at least one of R⁷ and R⁸ is an aryl group or a monovalent hetero ring group (further preferably aryl group), since the long-term degradation of the light emitting device comprising the metal complex of the present embodiment is more suppressed.

The metal complex represented by the formula (1-A1) includes, for example, metal complexes represented by the formula (1-A1-1).

### • Group represented by the formula (D-A) to the formula (D-C)

m^{DA1}, m^{DA2}, m^{DA3}, m^{DA4}, m^{DA5}, m^{DA6} and m^{DA7} represent usually an integer of 10 or less, preferably an integer of 5 or less, more preferably an integer of 2 or less, further preferably 0 or 1. It is preferable that m^{DA2}, m^{DA3}, m^{DA4}, m^{DA5}, m^{DA6} and m^{DA7} represent the same integer.

G^{DA} is preferably an aromatic hydrocarbon group or a hetero ring group, more preferably a group obtained by removing from a benzene ring, a pyridine ring, a pyrimidine ring, a triazine ring or a carbazole ring three hydrogen atoms bonding directly to carbon atoms or nitrogen atoms constituting the ring, and these groups optionally have a substituent.

The substituent which G^{DA} optionally has is preferably an alkyl group, a cycloalkyl group, an alkoxy group, a cycloalkoxy group, an aryl group or a monovalent hetero ring group, more preferably an alkyl group, a cycloalkyl group, an alkoxy group or a cycloalkoxy group, further preferably an alkyl group or a cycloalkyl group, and these groups optionally have a substituent.

The substituent which the substituent which G^{DA} optionally has optionally further has is preferably an alkyl group, a cycloalkyl group, an alkoxy group, a cycloalkoxy group, an aryl group or a monovalent hetero ring group, more preferably an alkyl group, a cycloalkyl group, an alkoxy group or a cycloalkoxy group, further preferably an alkyl group or a cycloalkyl group, and these groups optionally further have a substituent.

G^{DA} is preferably a group represented by the formula (GDA-11) to the formula (GDA-15), more preferably a group represented by the formula (GDA-11) to the formula (GDA-14), further preferably a group represented by the formula (GDA-11) or the formula (GDA-14). 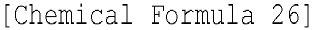 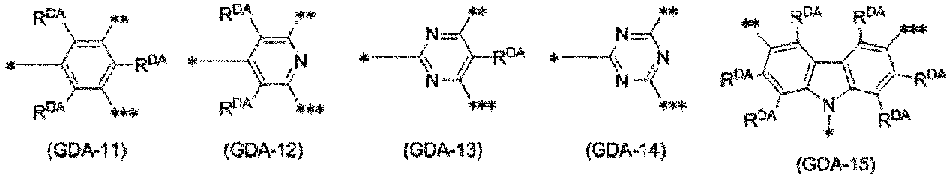 [wherein,
* represents a bond to Ar^{DA1} in the formula (D-A), Ar^{DA1} in the formula (D-B), Ar^{DA2} in the formula (D-B), or Ar^{DA3} in the formula (D-B).
** represents a bond to Ar^{DA2} in the formula (D-A), Ar^{DA2} in the formula (D-B), Ar^{DA4} in the formula (D-B), or Ar^{DA6} in the formula (D-B).
*** represents a bond to Ar^{DA3} in the formula (D-A), Ar^{DA3} in the formula (D-B), Ar^{DA5} in the formula (D-B), or Ar^{DA7} in the formula (D-B).
R^{DA} represents a hydrogen atom, an alkyl group, a cycloalkyl group, an alkoxy group, a cycloalkoxy group, an aryl group or a monovalent hetero ring group, and these groups optionally further have a substituent. When a plurality of R^{DA} are present, they may be the same or different.]

R^{DA} is preferably preferably a hydrogen atom, an alkyl group, a cycloalkyl group, an alkoxy group or a cycloalkoxy group, more preferably a hydrogen atom, an alkyl group or a cycloalkyl group, and these groups optionally have a substituent.

The substituent which R^{DA} optionally has is preferably an alkyl group, a cycloalkyl group, an alkoxy group or a cycloalkoxy group, more preferably an alkyl group or a cycloalkyl group, and these groups optionally further have a substituent.

The substituent which the substituent which R^{DA} optionally has optionally further has is preferably an alkyl group, a cycloalkyl group, an alkoxy group or a cycloalkoxy group, more preferably an alkyl group or a cycloalkyl group, and these groups optionally further have a substituent.

Ar^{DA1}, Ar^{DA2}, Ar^{DA3}, Ar^{DA4}, Ar^{DA5}, Ar^{DA6} and Ar^{DA7} represent preferably a phenylene group, a fluorenediyl group or a carbazolediyl group, more preferably a group represented by the formula (ArDA-1) to the formula (ArDA-5), further preferably a group represented by the formula (ArDA-1) to the formula (ArDA-3), particularly preferably a group represented by the formula (ArDA-1) or the formula (ArDA-2), especially preferably a group represented by the formula (ArDA-2), and these groups optionally have a substituent. The examples and preferable ranges of the substituent which Ar^{DA1}, Ar^{DA2}, Ar^{DA3}, Ar^{DA4}, Ar^{DA5}, Ar^{DA6} and Ar^{DA7} optionally have are the same as the examples and preferable ranges of the substituent which G^{DA} optionally has. 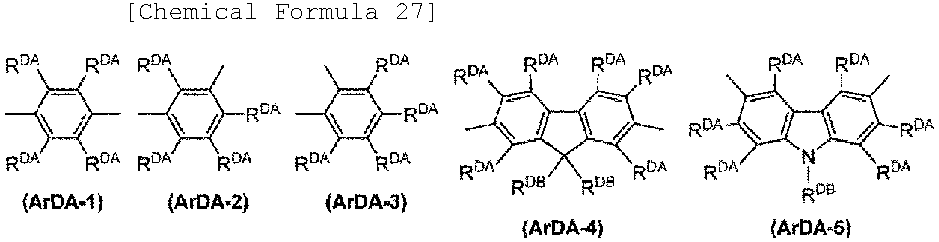 [wherein,
R^{DA} represents the same meaning as described above.
R^{DB} represents a hydrogen atom, an alkyl group, a cycloalkyl group, an aryl group or a monovalent hetero ring group, and these groups optionally have a substituent. When a plurality of R^{DB} are present, they may be the same or different.]

R^{DB} is preferably an alkyl group, a cycloalkyl group, an aryl group or a monovalent hetero ring group, more preferably an aryl group or a monovalent hetero ring group, further preferably an aryl group, and these groups optionally have a substituent.

The substituent which R^{DB} optionally has is preferably an alkyl group, a cycloalkyl group, an aryl group or a monovalent hetero ring group, more preferably an alkyl group, a cycloalkyl group or an aryl group, further preferably an alkyl group or an aryl group, and these groups optionally further have a substituent.

The substituent which the substituent which R^{DB} optionally has optionally further has is preferably an alkyl group, a cycloalkyl group, an aryl group or a monovalent hetero ring group, more preferably an alkyl group, a cycloalkyl group or an aryl group, further preferably an alkyl group or an aryl group, and these groups optionally further have a substituent.

The substituent which T^{DA} optionally has is preferably an alkyl group, a cycloalkyl group, an aryl group or a monovalent hetero ring group, more preferably an alkyl group, a cycloalkyl group or an aryl group, further preferably an alkyl group or an aryl group, and these groups optionally further have a substituent.

The substituent which the substituent which T^{DA} optionally has optionally further has is preferably an alkyl group, a cycloalkyl group, an aryl group or a monovalent hetero ring group, more preferably an alkyl group, a cycloalkyl group or an aryl group, further preferably an alkyl group or an aryl group, and these groups optionally further have a substituent.

T^{DA} is preferably a group represented by the formula (TDA-1) to the formula (TDA-3), more preferably a group represented by the formula (TDA-1). 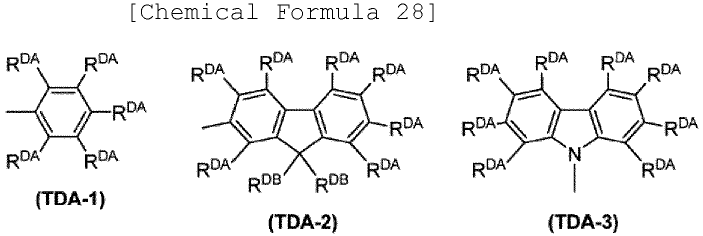 [wherein, R^{DA} and R^{DB} represent the same meaning as described above.]

The group represented by the formula (D-A) is preferably a group represented by the formula (D-A1) to the formula (D-A5), more preferably a group represented by the formula (D-A1) to the formula (D-A3), further preferably a group represented by the formula (D-A3). 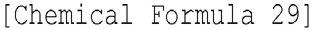 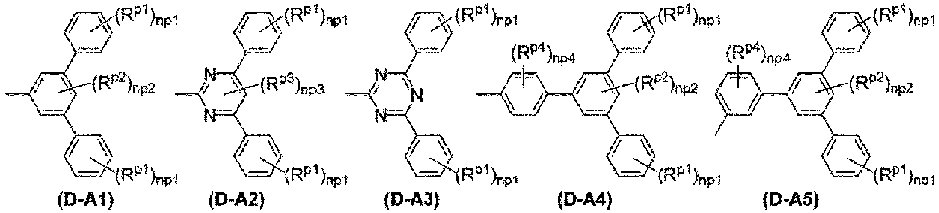 [wherein,
R^{p1}, R^{p2}, RP3 and RP4 each independently represent an alkyl group, a cycloalkyl group, an alkoxy group, a cycloalkoxy group or a halogen atom, and these groups optionally have a substituent. When a plurality of R^{p1}, R^{p2} and R^{p4} are present, they may be the same or different at each occurrence.
n^{p1} represents an integer of 0 to 5, np2 represents an integer of 0 to 3, np3 represents 0 or 1, and np4 represents an integer of 0 to 4. A plurality of np1 may be the same or different.]

The group represented by the formula (D-B) is preferably a group represented by the formula (D-B1) to the formula (D-B6), more preferably a group represented by the formula (D-B1) to the formula (D-B3), the formula (D-B5) or the formula (D-B6), further preferably a group represented by the formula (D-B1), the formula (D-B3) or the formula (D-B5), particularly preferably a group represented by the formula (D-B1).

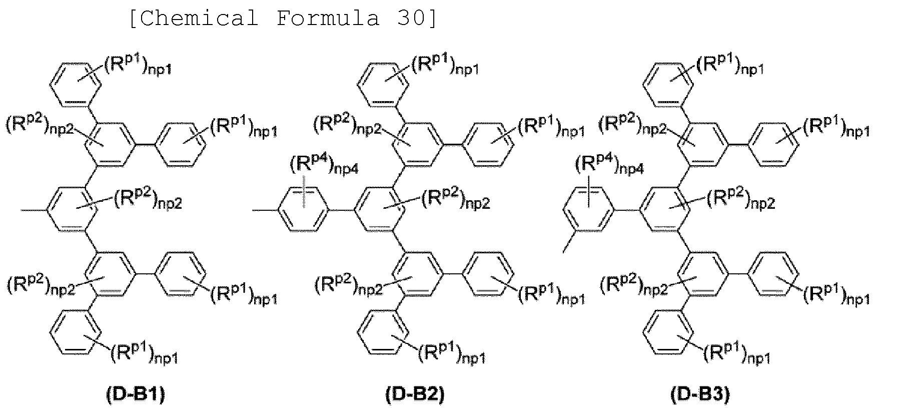

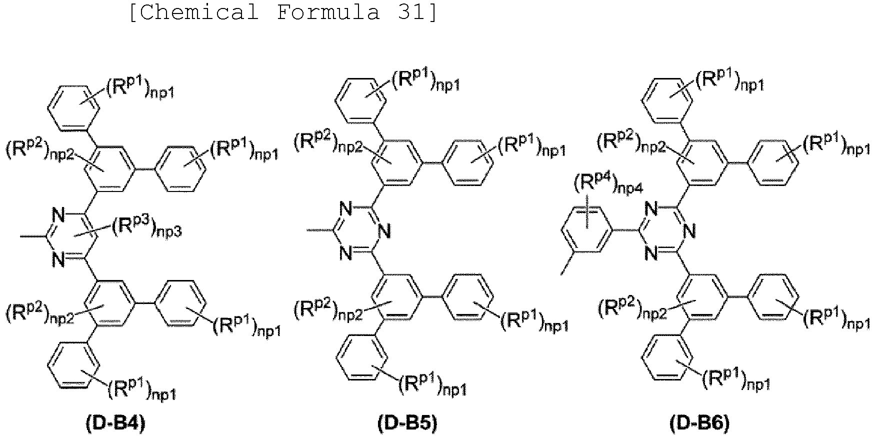

[wherein,
R^{p1}, R^{p2}, R^{p3} and R^{p4} each independently represent an alkyl group, a cycloalkyl group, an alkoxy group, a cycloalkoxy group or a halogen atom, and these groups optionally have a substituent. When a plurality of R^{p1}, R^{p2} and R^{p4} are present, they may be the same or different at each occurrence.
np1 represents an integer of 0 to 5, np2 represents an integer of 0 to 3, np3 represents 0 or 1, and np4 represents an integer of 0 to 4. A plurality of np1 may be the same or different. A plurality of np2 may be the same or different.]

The group represented by the formula (D-C) is preferably a group represented by the formula (D-C1) to the formula (D-C4), more preferably a group represented by the formula (D-C1) to the formula (D-C3), further preferably a group represented by the formula (D-C1) or the formula (D-C2), particularly preferably a group represented by the formula (D-C1). 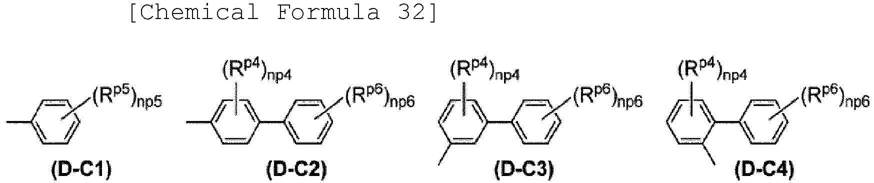 [wherein,
R^{p4}, R^{p5} and RP6 each independently represent an alkyl group, a cycloalkyl group, an alkoxy group, a cycloalkoxy group or a halogen atom, and these groups optionally have a substituent. When a plurality of RP4, R^{p5} and RP6 are present, they may be the same or different at each occurrence.
n^{p4} represent an integer of 0 to 4, n^{p5} represents an integer of 0 to 5, n^{p6} represents an integer of 0 to 5.]

n^{p1} is preferably an integer of 0 to 2, more preferably 0 or 1. n^{p2} is preferably 0 or 1, more preferably 0. n^{p3} is preferably 0. n^{p4} is preferably an integer of 0 to 2, more preferably 0. n^{p5} is preferably an integer of 0 to 3, more preferably 0 or 1. n^{p6} is preferably an integer of 0 to 2, more preferably 0 or 1.

The alkyl group represented by R^{p1}, R^{p2}, R^{p3}, R^{p4}, R^{p5} and RP6 is preferably an alkyl group having a number of carbon atoms of 1 to 6, more preferably a methyl group, an ethyl group, an isopropyl group, a tert-butyl group, a hexyl group, a 2-ethylhexyl group or a tert-octyl group.

The cycloalkyl group represented by R^{p1}, R^{p2}, R^{p3}, R^{p4}, R^{p5} and RP6 is preferably a cycloalkyl group having a number of carbon atoms of 5 to 6, more preferably a cyclohexyl group.

The alkoxy group represented by R^{p1}, R^{p2}, R^{p3}, R^{p4}, R^{p5} and R^{p6} is preferably an alkoxy group having a number of carbon atoms of 1 to 6, more preferably a methoxy group or a 2-ethylhexyloxy group.

The cycloalkoxy group represented by R^{p1}, R^{p2}, R^{p3}, R^{p4}, R^{p5} and R^{p6} is preferably a cycloalkoxy group having a number of carbon atoms of 5 to 6, more preferably a cyclohexyloxy group.

R^{p1}, R^{p2}, R^{p3}, R^{p4}, R^{p5} and R^{p6} represent preferably an alkyl group optionally having a substituent or a cycloalkyl group optionally having a substituent, more preferably an alkyl group optionally having a substituent, further preferably a methyl group, an ethyl group, an isopropyl group, a tert-butyl group, a hexyl group, a 2-ethylhexyl group or a tert-octyl group.

The substituent which R^{p1}, R^{p2}, R^{p3}, R^{p4}, R^{p5} and R^{p6} optionally have is preferably an alkyl group or a cycloalkyl group, and these groups optionally further have a substituent.

The substituent which the substituent which R^{p1}, R^{p2}, R^{p3}, R^{p4}, R^{p5} and RP6 optionally have optionally further has is preferably an alkyl group or a cycloalkyl group, and these groups optionally further have a substituent.

The group represented by the formula (D-A) includes, for example, groups represented by the formula (D-A-1) to the formula (D-A-12). 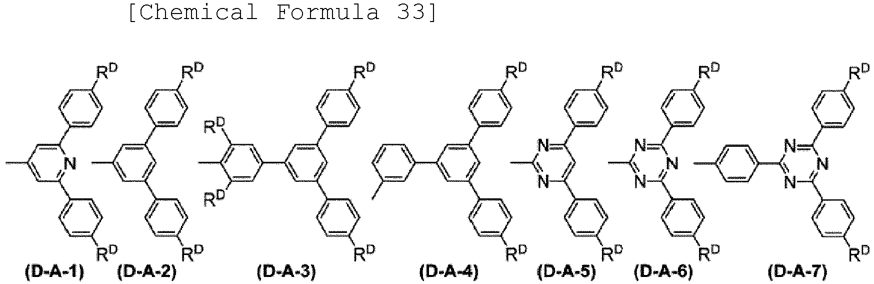 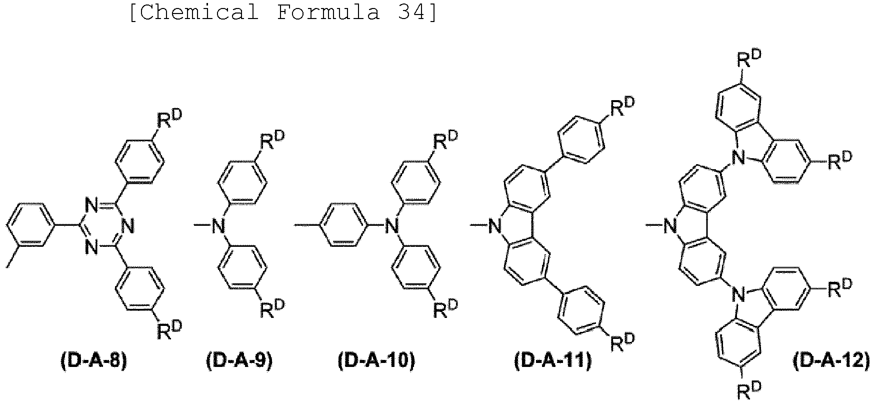 [wherein, R^{D} represents a hydrogen atom, an alkyl group, a cycloalkyl group, an alkoxy group or a cycloalkoxy group, and these groups optionally have a substituent. When a plurality of R^{D} are present, they may be the same or different.]

The examples and preferable ranges of the alkyl group, the cycloalkyl group, the alkoxy group and the cycloalkoxy group represented by R^{D} are the same as the examples and preferable ranges of the alkyl group, the cycloalkyl group, the alkoxy group and the cycloalkoxy group represented by R^{p1}, R^{p2}, R^{p3}, R^{p4}, RP5 and RP6, respectively.

The examples and preferable ranges of the substituent which R^{D} optionally has are the same as the examples and preferable ranges of the substituent which R^{p1}, R^{p2}, R^{p3}, R^{p4}, R^{p5} and RP6 optionally have.

R^{D} is preferably a hydrogen atom, a methyl group, an ethyl group, an isopropyl group, a tert-butyl group, a hexyl group, a 2-ethylhexyl group, a tert-octyl group, a cyclohexyl group, methoxy group, a 2-ethylhexyloxy group or a cyclohexyloxy group, more preferably a hydrogen atom, a methyl group, an ethyl group, an isopropyl group, a tert-butyl group, a hexyl group, a 2-ethylhexyl group or tert-octyl group, further preferably a hydrogen atom, a tert-butyl group or tert-octyl group, from the standpoint of the quantum yield of the metal complex.

The group represented by the formula (D-B) includes, for example, groups represented by the formula (D-B-1) to the formula (D-B-7). 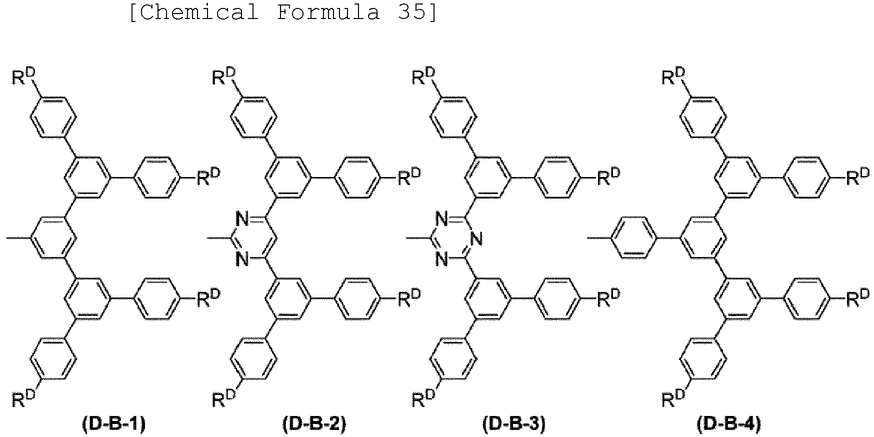 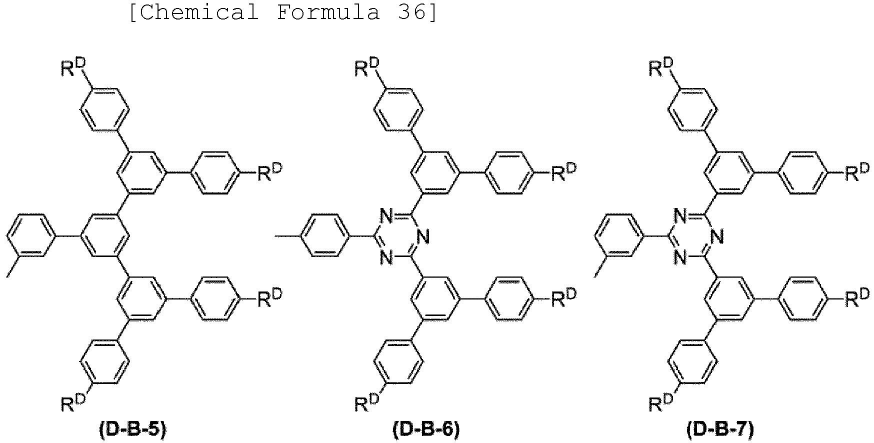 [wherein, R^{D} represents the same meaning as described above.]

The group represented by the formula (D-C) includes, for example, groups represented by the formula (D-C-1) to the formula (D-C-13). 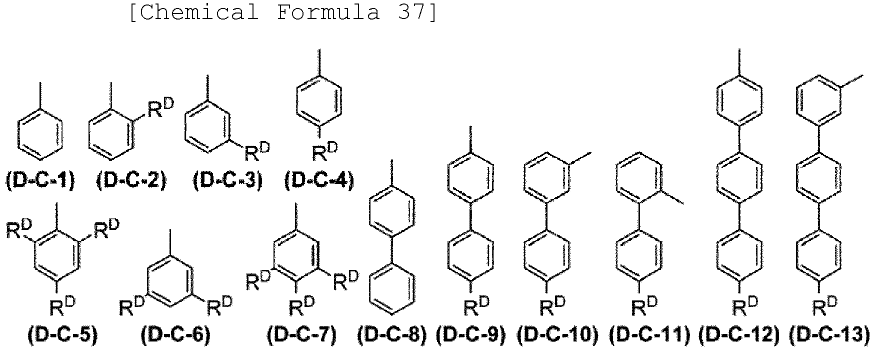 [wherein, R^{D} represents the same meaning as described above.]

### • Anionic bidentate ligand

The anionic bidentate ligand represented by A¹-G¹-A² includes, for example, ligands represented by the following formulae. However, the anionic bidentate ligand represented by A¹-G¹-A² is different from the ligand of which number is defined by suffix n¹. 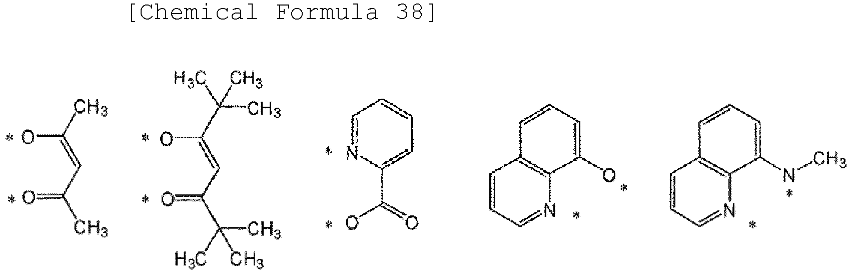 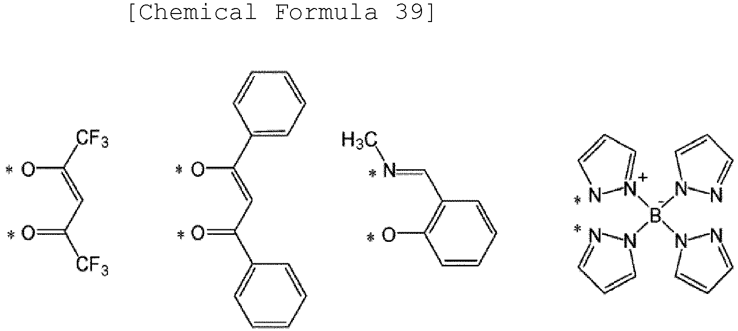 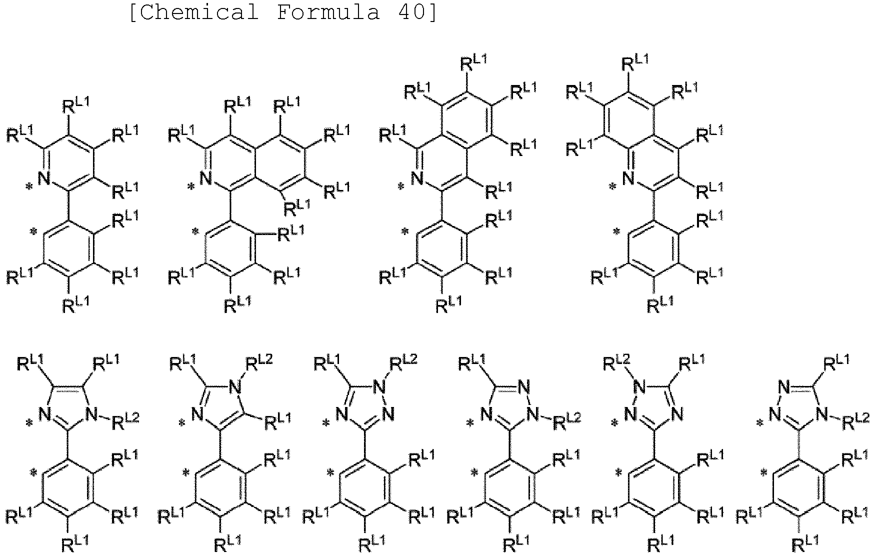 [wherein,
* represents a site binding to M.
R^{L1} represents a hydrogen atom, an alkyl group, a cycloalkyl group, an aryl group, a monovalent hetero ring group or a halogen atom, and these groups optionally have a substituent. A plurality of R^{L1} may be the same or different.
R^{L2} represents an alkyl group, a cycloalkyl group, an aryl group, a monovalent hetero ring group or a halogen atom, and these groups optionally have a substituent.]

R^{L1} is preferably a hydrogen atom, an alkyl group, a cycloalkyl group, an aryl group or a fluorine atom, more preferably a hydrogen atom or an alkyl group, and these groups optionally have a substituent.

R^{L2} is preferably an alkyl group or an aryl group, and these groups optionally have a substituent.

The substituent which R^{L1} optionally has is preferably an alkyl group, a cycloalkyl group or an aryl group, more preferably an alkyl group or an aryl group, and these groups optionally further have a substituent.

The substituent which the substituent which R^{L1} optionally has optionally further has is preferably an alkyl group, a cycloalkyl group or an aryl group, more preferably an alkyl group or an aryl group, and these groups optionally further have a substituent.

The substituent which R^{L2} optionally has is preferably an alkyl group, a cycloalkyl group or an aryl group, more preferably an alkyl group or an aryl group, and these groups optionally further have a substituent.

The substituent which the substituent which R^{L2} optionally has optionally further has is preferably an alkyl group, a cycloalkyl group or an aryl group, more preferably an alkyl group or an aryl group, and these groups optionally further have a substituent.

The metal complex represented by the formula (1) includes, for example, metal complexes represented by the formula (Ir-1) to the formula (Ir-20). Of them, , metal complexes represented by the formula (Ir-1) to the formula (Ir-8), the formula (Ir-13) to the formula (Ir-16) are preferable, metal complexes represented by the formula (Ir-1) to the formula (Ir-8) are more preferable, since the metal complex of the present embodiment is more excellent in quantum yield. Of them, metal complexes represented by the formula (Ir-1) to the formula (Ir-4) are further preferable, metal complexes represented by the formula (Ir-1) or the formula (Ir-3) are particularly preferable, since synthesis of the metal complex of the present embodiment is facilitated.

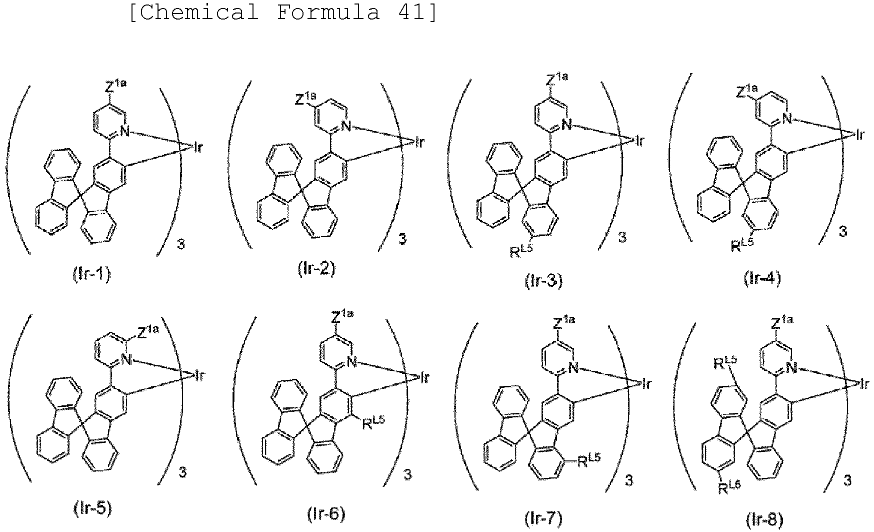

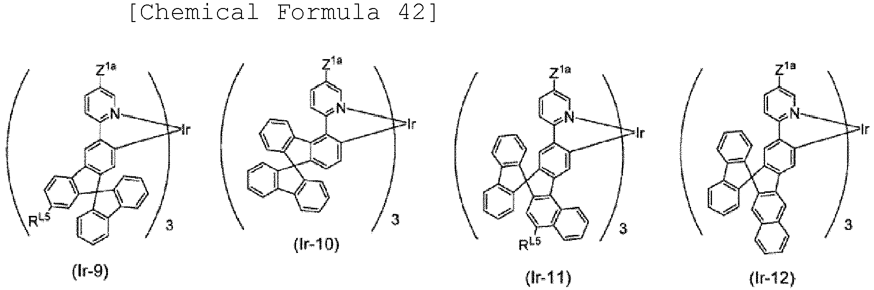

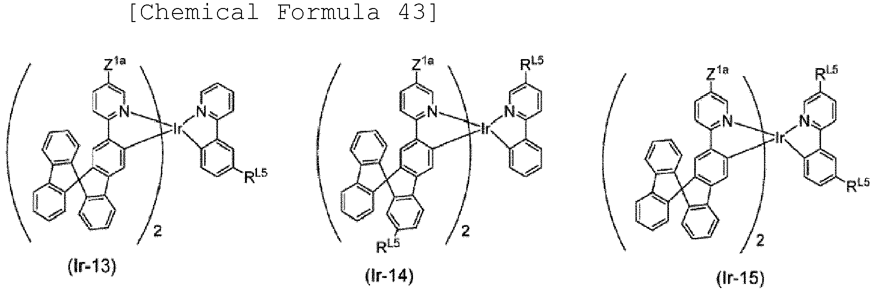

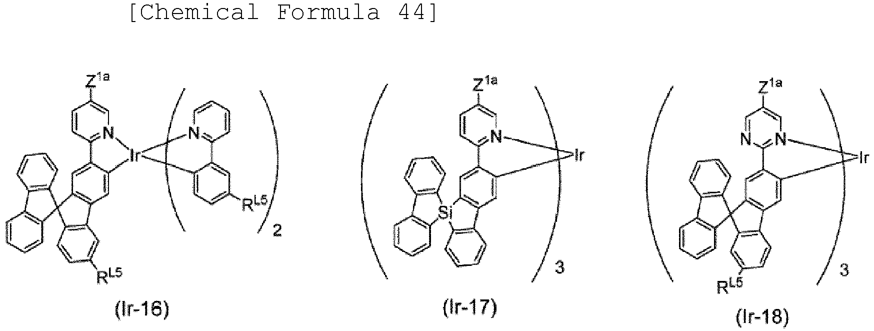

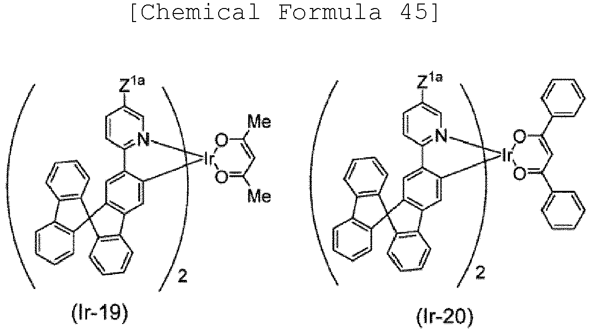

In the formula (Ir-1) to the formula (Ir-20),
R^{L5} is an alkyl group, a cycloalkyl group, a halogen atom, an aryl group, a 1,3,5-triazin-2-yl group having an aryl group at 4-position and 6-position as a substituent, a 1,3-pyrimidin-2-yl group having an aryl group at 4-position and 6-position as a substituent, a group represented by the formula (D-A), a group represented by the formula (D-B) or a group represented by the formula (D-C). When a plurality of R^{L5} are present, they may be the same or different.
Z^{1a} is a group represented by the formula (D-A), the formula (D-B) or the formula (D-C). When a plurality of Z^{1a} are present, they may be the same or different.

The examples and preferable ranges of the alkyl group represented by R^{L5} are the same as the examples and preferable ranges of the alkyl group represented by RP1, R^{p2}, R^{p3}, R^{p4}, R^{p5} and R^{p6}.

The examples and preferable ranges of the cycloalkyl group represented by R^{L5} are the same as the examples and preferable ranges of the cycloalkyl group represented by R^{p1}, R^{p2}, R^{p3}, R^{p4}, R^{p5} and R^{p6}.

The examples and preferable ranges of the aryl group represented by R^{L5} are the same as the examples and preferable ranges of the aryl group as the substituent which Ring R^{A} optionally has.

The substituent which R^{L5} optionally has is preferably an alkyl group, a cycloalkyl group or an aryl group, more preferably an alkyl group or an aryl group, and these groups optionally further have a substituent.

The substituent which the substituent which R^{L5} optionally has optionally further has is preferably an alkyl group or an aryl group, and these groups optionally further have a substituent.

In the formula (Ir-1) to the formula (Ir-20),
R^{L5} is preferably a group selected from groups represented by the formula (II-1) to the formula (11-15) in Group II described below and groups represented by the formula (III-1) to the formula (111-17) in Group III described below.
Z^{1a} is preferably a group selected from groups represented by the formula (III-1) to the formula (111-17) in Group III described below corresponding to the above-described group represented by the formula (D-A).

### <Group II>

[Chemical Formula 46] **-Me -C₃H₇ -Bu -t-Bu -C₆H₁₃** -Br **(II-1) (II-2) (II-3) (II-4) (II-5) (II-6)**

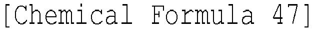

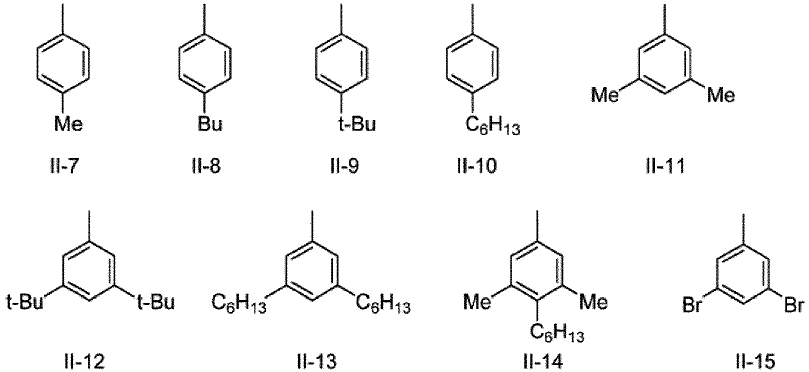

### <Group III>

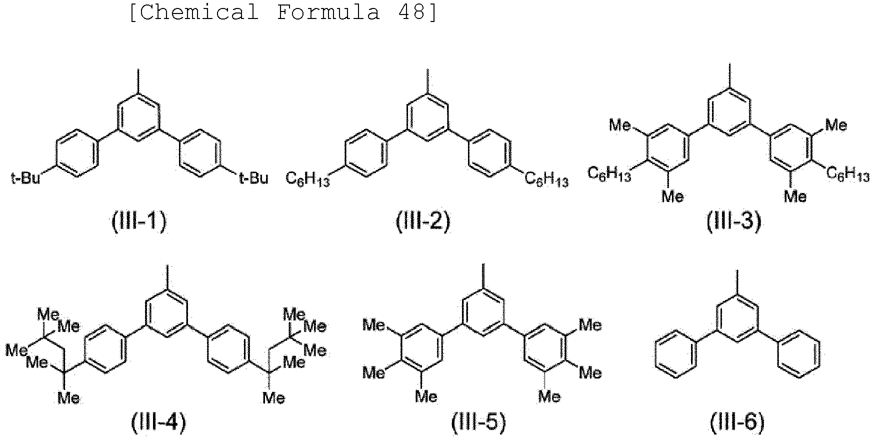

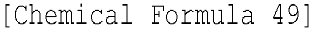

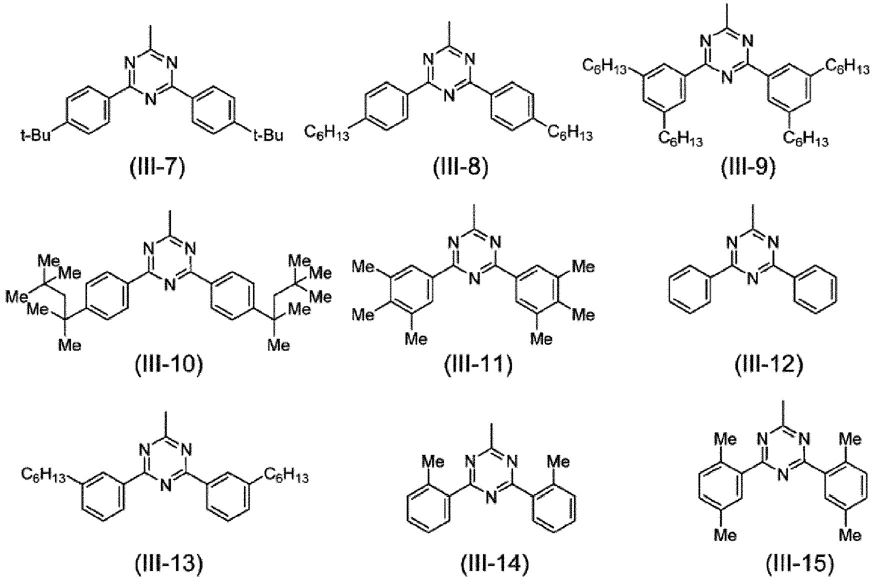

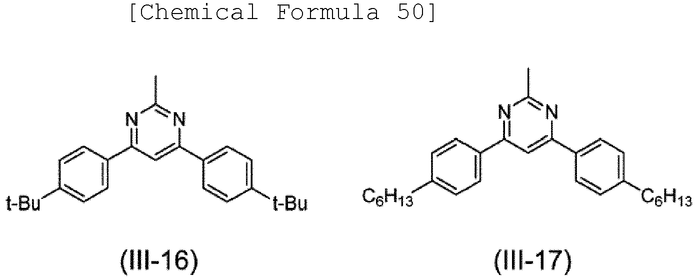

Among the formula (Ir-1) to the formula (Ir-20), Z^{1a} is more preferably a group selected from the group consisting of groups represented by the formula (III-1) to the formula (111-13), particularly preferably a group selected from the group consisting of groups represented by the formula (III-7) to the formula (111-13).

Specific examples of the metal complex represented by the formula (1) include metal complexes represented by the formula (Ir-101) to the formula (Ir-118).

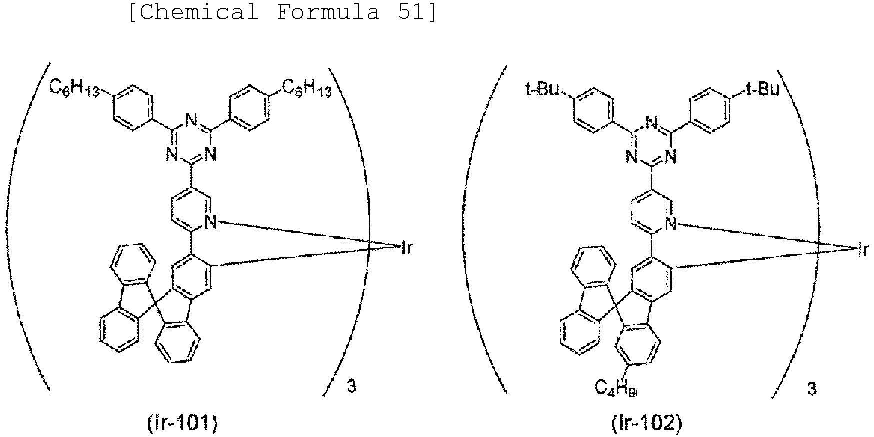

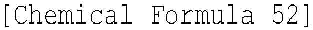

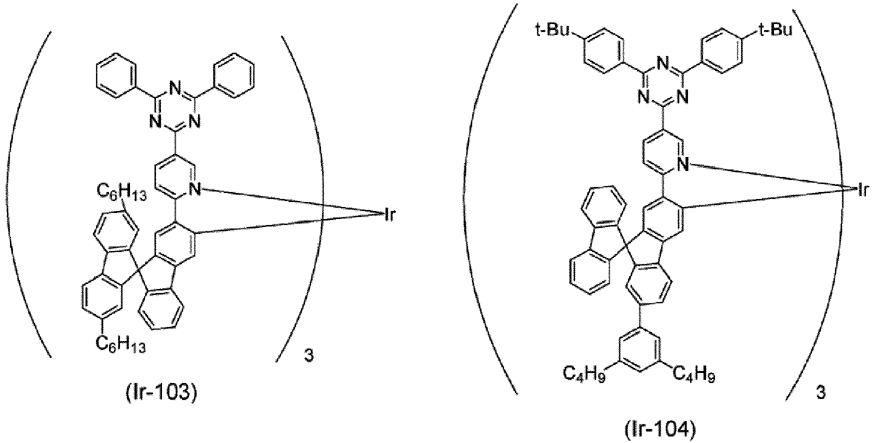

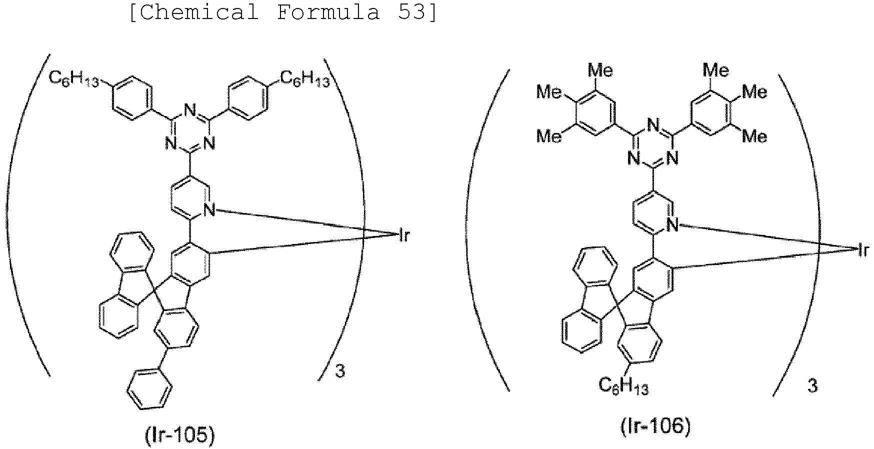

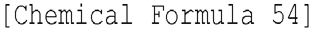

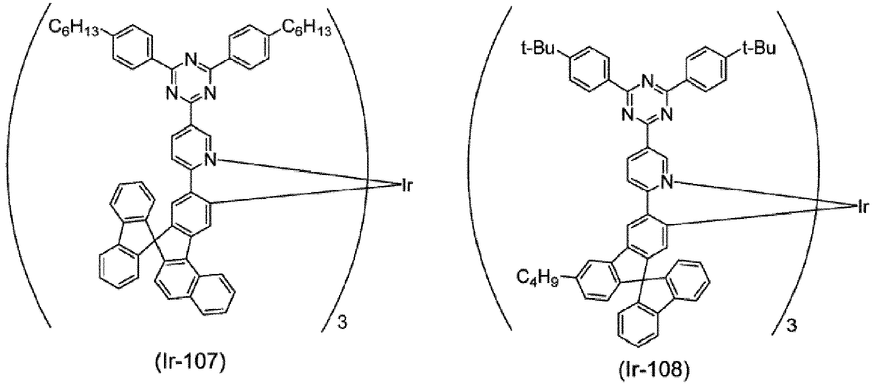

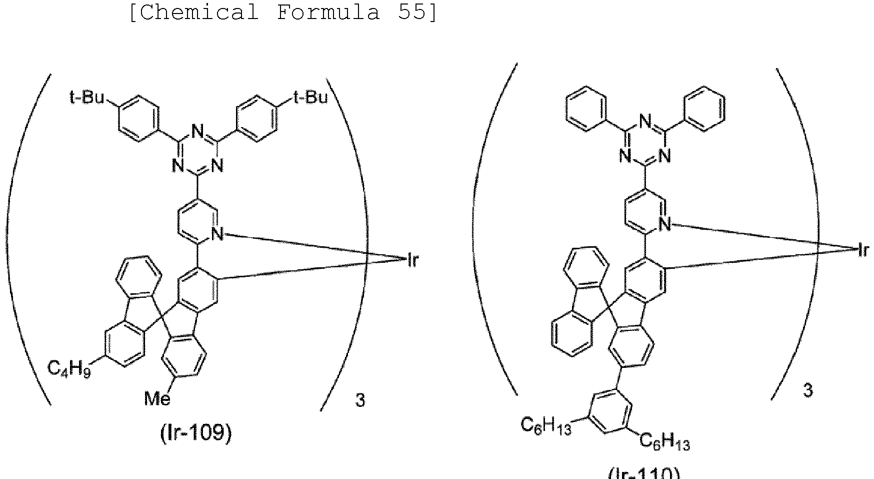

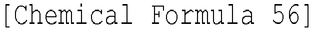

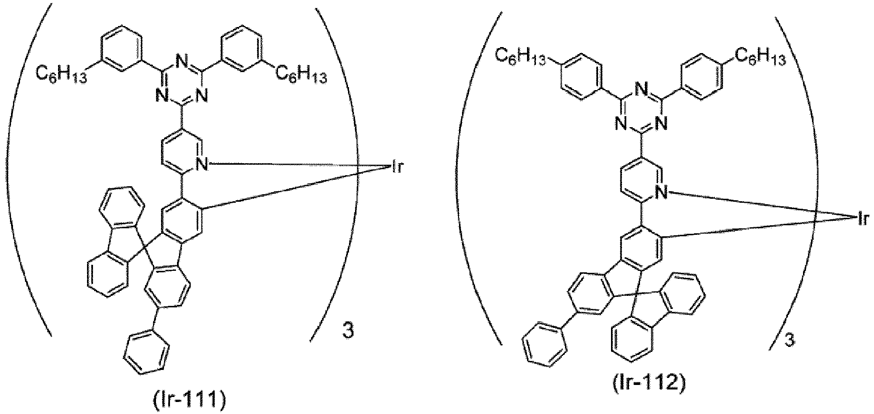

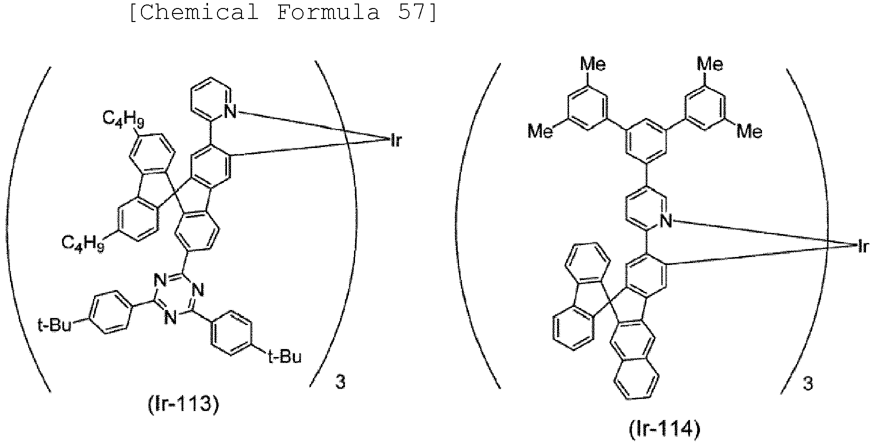

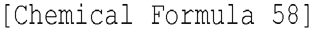

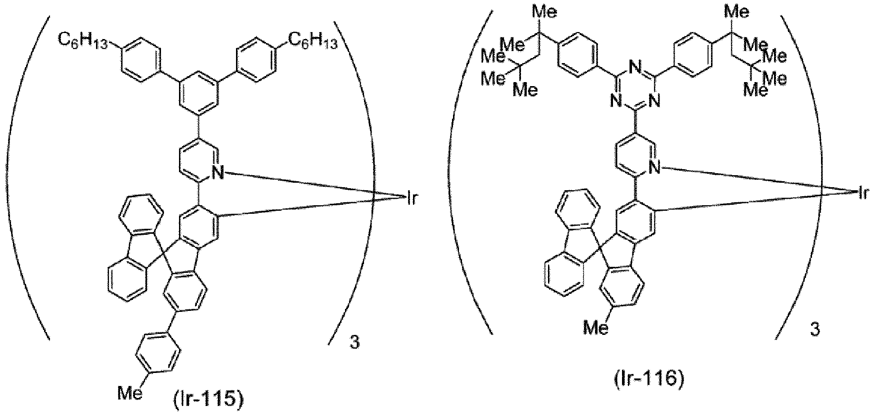

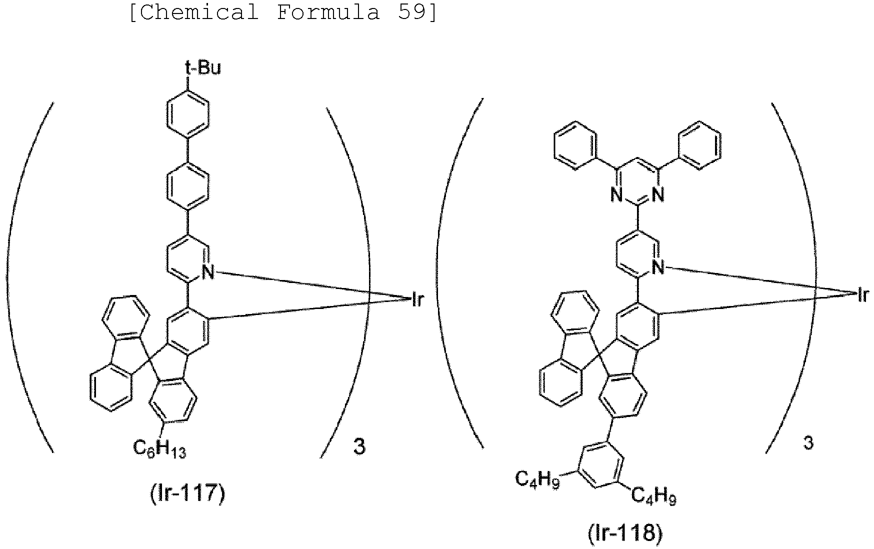

In the light emitting device obtained by using the metal complex of the present embodiment, the metal complex of the present embodiment may be used singly or in combination of two or more.

As the metal complex represented by the formula (1), a plurality of geometric isomers are envisaged, and any geometric isomer may be adopted, and the proportion of the facial body is preferably 80% by mol or more, more preferably 90% by mol or more, further more preferably 99% by mol or more, particularly preferably 100% by mol (that is, other geometric isomers are not contained), with respect to the whole metal complex, since the half value width of the emission spectrum of the metal complex of the present embodiment is more excellent.

### <Production method of metal complex represented by the formula (1)

### [Production method 1]

The metal complex represented by the formula (1) which is the metal complex of the present embodiment can be produced, for example, by a method of reacting a compound acting as a ligand with a metal compound. If necessary, the functional group transformation reaction of a ligand of the metal complex may be carried out.

The metal complex represented by the formula (1) in which M is an iridium atom and n₁ is 2 or 3 can be produced, for example, by a method including
a step A1 of reacting a compound represented by the formula (M1-1) and an iridium compound or its hydrate to synthesize a metal complex represented by the formula (M1-2), and
a step B1 of reacting a metal complex represented by the formula (M1-2) and a compound represented by the formula (M1-1) or a precursor of a ligand represented by A¹-G¹-A².

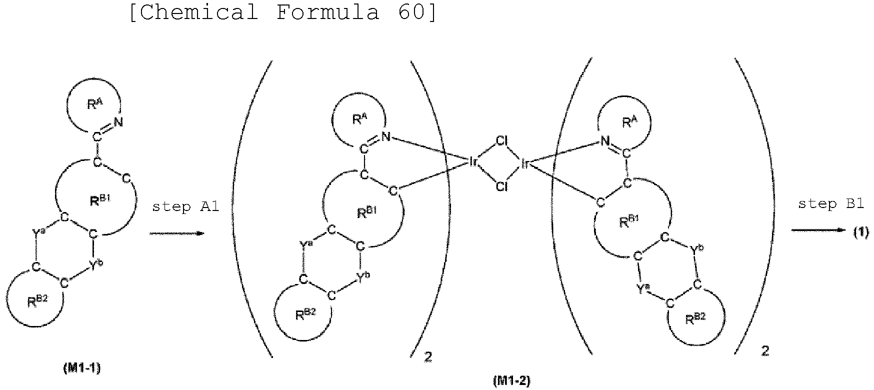

In the step A1, the iridium compound includes, for example, iridium chloride, tris(acetylacetonato)iridium(III), chloro(cyclooctadiene)iridium(I) dimer, and iridium(III) acetate, and the hydrate of the iridium compound includes, for example, iridium chloride trihydrate.

The step A1 and the step B1 are usually carried out in a solvent. The solvent includes, for example, alcohol solvents such as methanol, ethanol, propanol, ethylene glycol, glycerin, 2-methoxyethanol, 2-ethoxyethanol, and the like; ether solvents such as diethyl ether, tetrahydrofuran, dioxane, cyclopentylmethyl ether, diglyme, and the like; halogen-based solvents such as methylene chloride, chloroform, and the like; nitrile solvents such as acetonitrile, benzonitrile, and the like; hydrocarbon solvents such as hexane, decalin, toluene, xylene, mesitylene, and the like; amide solvents such as N,N-dimethylformamide, N,N-dimethylacetamide, and the like; acetone, dimethyl sulfoxide, and water.

In the step A1 and the step B1, the reaction time is usually 30 minutes to 150 hours, and the reaction temperature is usually between the melting point and the boiling point of a solvent present in the reaction system.

In the step A1, the amount of the compound represented by the formula (M1-1) is usually 2 to 20 mol with respect to 1 mol of the iridium compound or its hydrate.

In the step B1, the amount of the compound represented by the formula (M1-1) or the precursor of a ligand represented by A¹-G¹-A² is usually 1 to 100 mol with respect to 1 mol of the metal complex represented by the formula (M1-2).

In the step B1, the reaction is preferably carried out in the presence of a silver compound such as silver trifluoromethanesulfonate, and the like. When the silver compound is used, its amount is usually 2 to 20 mol with respect to 1 mol of the metal complex represented by the formula (M1-2).

The compound represented by the formula (M1-1) can be synthesized, for example, by a step of coupling-reacting a compound represented by the formula (M1-3) and a compound represented by the formula (M1-4) as in the Suzuki reaction, the Kumada reaction, the Stille reaction, and the like. 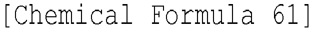 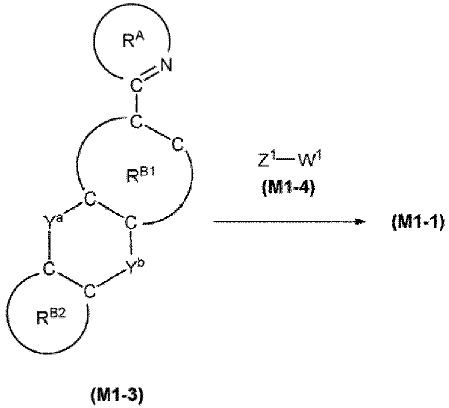 [in the formula (M1-3), Ring R^{A}, Ring R^{B1}, Ring R^{B2}, Y^{a} and Y^{b} represent the same meaning as described above. However, at least one of Ring R^{A}, Ring R^{B1}, Ring R^{B2}, Ring R^{C1} and Ring R^{C2} has a group represented by -B(OR^{W1})₂, an alkylsulfonyloxy group, a cycloalkylsulfonyloxy group, an arylsulfonyloxy group, a chlorine atom, a bromine atom or an iodine atom as a substituent, instead of the group represented by the formula (D-A), the formula (D-B) or the formula (D-C).

R^{W1} represents a hydrogen atom, an alkyl group, a cycloalkyl group, an aryl group or an amino group, and these groups optionally have a substituent. A plurality of R^{W1} may be the same or different, and may be combined together to form a ring structure together with oxygen atoms to which they are attached.]

In the formula (M1-4), Z¹ represents a group represented by the formula (D-A), the formula (D-B) or the formula (D-C). W¹ represents a group represented by - B(OR^{W1})₂, an alkylsulfonyloxy group, a cycloalkylsulfonyloxy group, an arylsulfonyloxy group, a chlorine atom, a bromine atom or an iodine atom, and these groups optionally have a substituent. R^{W1} represents the same meaning as described above.

The group represented by -B(OR^{W1})₂ includes, for example, groups represented by the formula (W-1) to the formula (W-10).

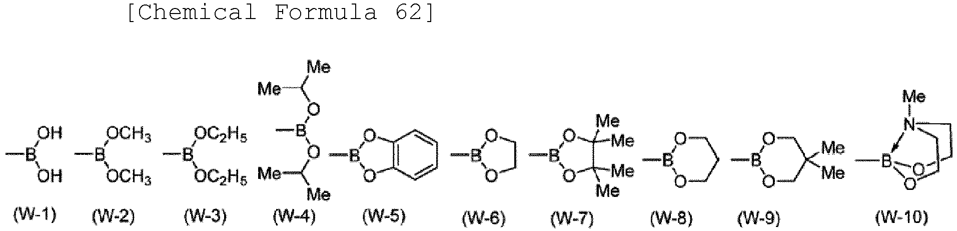

The alkylsulfonyloxy group represented by W¹ includes, for example, a methanesulfonyloxy group, an ethanesulfonyloxy group, and a trifluoromethanesulfonyloxy group.

The arylsulfonyloxy group represented by W¹ includes, for example, a p-toluenesulfonyloxy group.

As W¹, a group represented by -B(OR^{W1})₂, a trifluoromethanesulfonyloxy group, a chlorine atom, a bromine atom or an iodine atom is preferred, since the coupling reaction of a compound represented by the formula (M1-4) and a metal complex represented by the formula (M1-3) proceeds easily, and of them, a chlorine atom, a bromine atom or a group represented by the formula (W-7) is more preferred, since synthesis of a compound represented by the formula (M1-4) is easy.

The alkylsulfonyloxy group, the cycloalkylsulfonyloxy group and the arylsulfonyloxy group as the substituent which at least one of Ring R^{A}, Ring R^{B1}, Ring R^{B2}, Ring R^{C1} and Ring R^{C2} has instead of the group represented by the formula (D-A), the formula (D-B) or the formula (D-C) represent the same meaning as the alkylsulfonyloxy group, the cycloalkylsulfonyloxy group and the arylsulfonyloxy group represented by W¹, respectively.

Z¹ is preferably a group represented by the formula (D-A), more preferably a group represented by the formula (D-A1) to the formula (D-A3).

The coupling reaction of a compound represented by the formula (M1-3) and a compound represented by the formula (M1-4) is usually carried out in a solvent. The solvent to be used, the reaction time and the reaction temperature may be the same as those explained for the step A1 and the step B1.

In the coupling reaction of a compound represented by the formula (M1-3) and a compound represented by the formula (M1-4), the amount of a compound represented by the formula (M1-4) is usually 0.05 to 20 mol with respect to 1 mol of a compound represented by the formula (M1-3).

The compound represented by the formula (M1-4) includes, for example, compounds in which Z¹ is a group represented by the formula (D-A1) to the formula (D-A3) and W¹ is a group represented by -B(OR^{W1})₂, a trifluoromethanesulfonyloxy group, a bromine atom or an iodine atom.

The compound represented by the formula (M1-4-1) which is one embodiment of the compound represented by the formula (M1-4) can be synthesized, for example, by the following method. 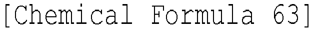 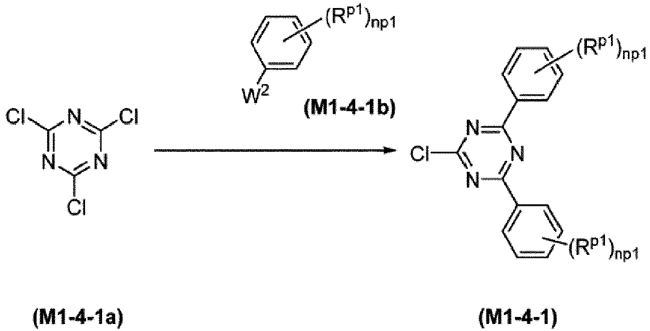 [wherein,
R^{p1} and n^{p1} represent the same meaning as described above.
W² represents a group represented by -B(OR^{W1})₂, an alkylsulfonyloxy group, a cycloalkylsulfonyloxy group, an arylsulfonyloxy group, a chlorine atom, a bromine atom or an iodine atom, and these groups optionally have a substituent.]

The compound represented by the formula (M1-4-1) can be produced, for example, by coupling-reacting a compound represented by the formula (M1-4-1a) and a compound represented by the formula (M1-4-1b). This coupling reaction may be the same as that explained for the compound represented by the formula (M1-1).

The compound represented by the formula (M1-4-2) which is one embodiment of the compound represented by the formula (M1-4) can be synthesized, for example, by the following method. 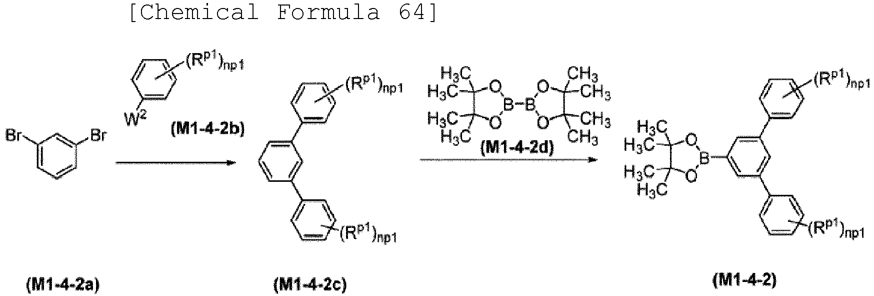 [wherein, RP1, n^{p1} and W² represent the same meaning as described above.]

The compound represented by the formula (M1-4-2c) can be produced, for example, by coupling-reacting a compound represented by the formula (M1-4-2a) and a compound represented by the formula (M1-4-2b). This coupling reaction may be the same reaction as explained for the compound represented by the formula (M1-1).

The compound represented by the formula (M1-4-2) can be synthesized, for example, by subjecting a compound represented by the formula (M1-4-2c) and a compound represented by the formula (M1-4-2d) to the Ishiyama-Miyaura-Hartwig reaction.

The compound represented by the formula (M1-3) can be produced, for example, by coupling-reacting a compound represented by the formula (M1-5) and a compound represented by the formula (M1-6). This coupling reaction may be the same reaction as explained for the compound represented by the formula (M1-1). 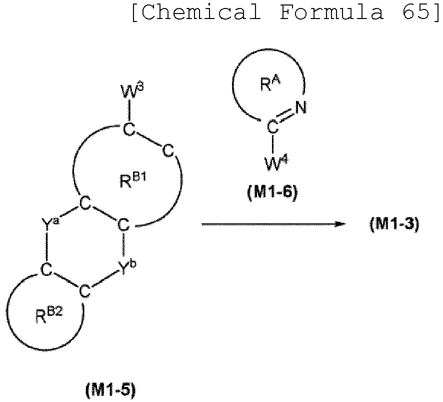 [in the formula (M1-5), Ring R^{B1}, Ring R^{B2}, Y^{a} and Y^{b} represent the same meaning as described above. Further, in the formula (M1-6), Ring R^{A} represents the same meaning as described above. However, at least one of Ring R^{A}, Ring R^{B1}, Ring R^{B2}, Ring R^{C1} and Ring R^{C2} has a group represented by -B(OR^{W1})₂, an alkylsulfonyloxy group, a cycloalkylsulfonyloxy group, an arylsulfonyloxy group, a chlorine atom, a bromine atom or an iodine atom as a substituent, instead of the group represented by the formula (D-A), the formula (D-B) or the formula (D-C).

W³ and W⁴ each independently represent a group represented by -B(OR^{W1})₂, an alkylsulfonyloxy group, a cycloalkylsulfonyloxy group, an arylsulfonyloxy group, a chlorine atom, a bromine atom or an iodine atom, and these groups optionally have a substituent.]

The metal complex represented by the formula (1) in which M is an iridium atom and n₁ is 1 can be produced, for example, by a method including
a step A1' of reacting a precursor of a ligand represented by A¹-G¹-A² and an iridium compound or its hydrate, and
a step B1' of reacting the metal complex obtained in the step A1' and a compound represented by the formula (M1-1) .

The step A1' and the step B1' can be carried out with reference to the step A1 and the step B1, respectively.

### [Production method 2]

The metal complex represented by the formula (1) which is the metal complex of the present embodiment can also be produced, for example, by a method of reacting a precursor of a metal complex and a precursor of a ligand of a metal complex.

The metal complex represented by the formula (1) can be produced, for example,
by coupling-reacting the compound represented by the formula (M1-4) and a metal complex represented by the formula (M1-7). This coupling reaction may be the same reaction as explained for the compound represented by the formula (M1-1). 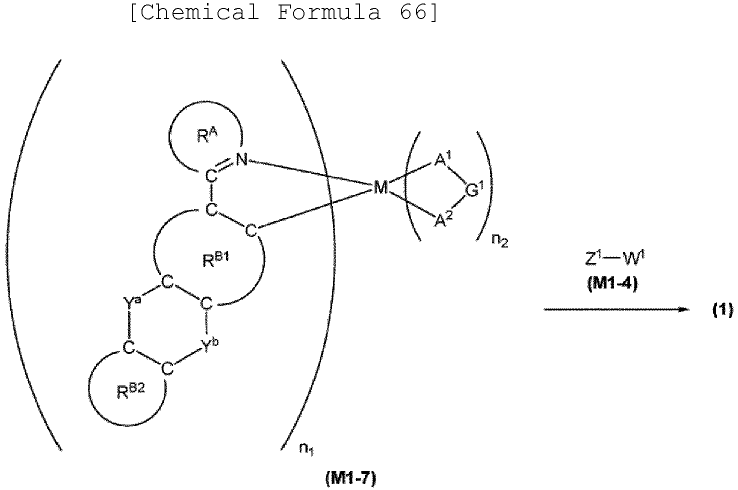 [in the formula (M1-7), n₁, n₂, Ring R^{A}, Ring R^{B1}, Ring R^{B2}, Y^{a}, Y^{b}, A¹-G¹-A² represent the same meaning as described above. However, at least one of Ring R^{A}, Ring R^{B1}, Ring R^{B2}, Ring R^{C1} and Ring R^{C2} has a group represented by -B(OR^{W1})₂, an alkylsulfonyloxy group, a cycloalkylsulfonyloxy group, an arylsulfonyloxy group, a chlorine atom, a bromine atom or an iodine atom as a substituent, instead of the group represented by the formula (D-A), the formula (D-B) or the formula (D-C).

R^{W1} represents a hydrogen atom, an alkyl group, a cycloalkyl group, an aryl group or an amino group, and these groups optionally have a substituent. A plurality of R^{W1} may be the same or different, and may be combined together to form a ring structure together with oxygen atoms to which they are attached.]

The metal complex represented by the formula (M1-7) can be synthesized, for example, by using a compound represented by the above-described formula (M1-3) instead of the compound represented by the formula (M1-1) in the step A1 and the step B1 in [Production method 1] of the metal complex represented by the formula (1) described above.

The compounds, the catalysts and the solvents used in respective reactions explained in <Production method of metal complex represented by the formula (1)> may each be used singly or in combination of two or more.

### <Composition>

The composition of the present embodiment contains at least one material selected from the group consisting of a hole transporting material, a hole injection material, an electron transporting material, an electron injection material, a light emitting material (differing from the metal complex of the present embodiment), an antioxidant and a solvent, and the metal complex of the present embodiment.

In the composition of the present embodiment, the metal complex of the present embodiment may be contained singly or in combination of two or more.

### [Host material]

If the metal complex of the present embodiment is combined with a host material having at least one function selected from hole injectability, hole transportability, electron injectability and electron transportability to provide a composition, the external quantum yield of a light emitting device obtained by using the metal complex of the present embodiment is more excellent. In the composition of the present embodiment, the host material may be contained singly or in combination of two or more.

In the composition containing the metal complex of the present embodiment and the host material, the content of the metal complex of the present embodiment is usually 0.01 to 80 parts by mass, preferably 0.05 to 40 parts by mass, more preferably 0.1 to 20 parts by mass, further preferably 1 to 20 parts by mass, when the sum of the metal complex of the present embodiment and the host material is taken as 100 parts by mass.

It is preferable that the lowest excited triplet state (T₁) of the host material is at the energy level equivalent to or higher than the lowest excited triplet state (T₁) of the metal complex of the present embodiment, since the external quantum yield of a light emitting device obtained by using the composition of the present embodiment is more excellent.

The host material is preferably one which exhibits solubility in a solvent capable of dissolving the metal complex of the present embodiment, since a light emitting device obtained by using the composition of the present embodiment is fabricated by a solution application process.

The host material is classified into a low molecular host and a polymer host.

### • Low molecular host

The low molecular host is preferably a compound represented by the formula (H-1). 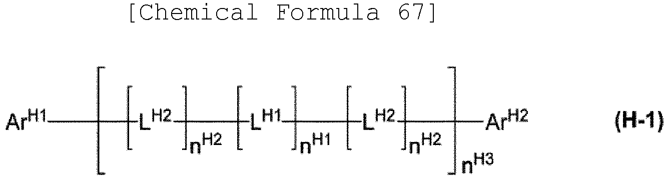 [wherein,
Ar^{H1} and Ar^{H2} each independently represent an aryl group or a monovalent hetero ring group, and these groups optionally have a substituent.
n^{H1} and n^{H2} each independently represent 0 or 1. When a plurality of n^{H1} are present, they may be the same or different. A plurality of n^{H2} may be the same or different.
n^{H3} represents an integer of 0 or more.
L^{H1} represents an arylene group, a divalent hetero ring group, or a group represented by - [C (R^{H11})₂]n^{H11}-, and these groups optionally have a substituent. When a plurality of L^{H1} are present, they may be the same or different. n^{H11} represents an integer of 1 or more and 10 or less. R^{H11} represents a hydrogen atom, an alkyl group, a cycloalkyl group, an alkoxy group, a cycloalkoxy group, an aryl group or a monovalent hetero ring group, and these groups optionally have a substituent. A plurality of R^{H11} may be the same or different, and may be combined together to form a ring together with carbon atoms to which they are attached.
L^{H2} represents a group represented by -N(-L^{H21}-R^{H21})-. When a plurality of L^{H2} are present, they may be the same or different. L^{H21} represents a single bond, an arylene group or a divalent hetero ring group, and these groups optionally have a substituent. R^{H21} represents a hydrogen atom, an alkyl group, a cycloalkyl group, an aryl group or a monovalent hetero ring group, and these groups optionally have a substituent.]

Ar^{H1} and Ar^{H2} represent preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a spirobifluorenyl group, a pyridyl group, a pyrimidinyl group, a triazinyl group, a dibenzothienyl group, a dibenzofuryl group, a carbazolyl group or an azacarbazolyl group, further preferably a phenyl group, a pyridyl group, a carbazolyl group or an azacarbazolyl group, particularly preferably a group represented by the formula (TDA-1) or (TDA-3), especially preferably a group represented by the formula (TDA-3), and these groups optionally have a substituent.

The substituent which Ar^{H1} and Ar^{H2} optionally have is preferably a halogen atom, an alkyl group, a cycloalkyl group, an alkoxy group, a cycloalkoxy group, an aryl group or a monovalent hetero ring group, more preferably an alkyl group, a cycloalkoxy group, an alkoxy group or a cycloalkoxy group, further preferably an alkyl group or a cycloalkoxy group, and these groups optionally further have a substituent.

n^{H1} is preferably 1. n^{H2} is preferably 0.

n^{H3} is usually an integer of 0 or more and 10 or less, preferably an integer of 0 or more and 5 or less, further preferably an integer of 1 or more and 3 or less, particularly preferably 1.

n^{H11} is preferably an integer of 1 or more and 5 or less, more preferably an integer of 1 or more and 3 or less, further preferably 1.

R^{H11} is preferably a hydrogen atom, an alkyl group, a cycloalkyl group, an aryl group or a monovalent hetero ring group, more preferably a hydrogen atom, an alkyl group or a cycloalkyl group, further preferably a hydrogen atom or an alkyl group, and these groups optionally have a substituent.

L^{H1} is preferably an arylene group or a divalent hetero ring group.

L^{H1} is preferably a group represented by the formula (A-1) to the formula (A-3), the formula (A-8) to the formula (A-10), the formula (AA-1) to the formula (AA-6), the formula (AA-10) to the formula (AA-21) or the formula (AA-24) to the formula (AA-34), more preferably a group represented by the formula (A-1), the formula (A-2), the formula (A-8), the formula (A-9), the formula (AA-1) to the formula (AA-4), the formula (AA-10) to the formula (AA-15) or the formula (AA-29) to the formula (AA-34), further preferably a group represented by the formula (A-1), the formula (A-2), the formula (A-8), the formula (A-9), the formula (AA-2), the formula (AA-4), the formula (AA-10) to the formula (AA-15), particularly preferably a group represented by the formula (A-1), the formula (A-2), the formula (A-8), the formula (AA-2), the formula (AA-4), the formula (AA-10), the formula (AA-12) or the formula (AA-14), especially preferably a group represented by the formula (A-1), the formula (A-2), the formula (AA-2), the formula (AA-4) or the formula (AA-14).

The substituent which L^{H1} optionally has is preferably a halogen atom, an alkyl group, a cycloalkyl group, an alkoxy group, a cycloalkoxy group, an aryl group or a monovalent hetero ring group, more preferably an alkyl group, an alkoxy group, an aryl group or a monovalent hetero ring group, further preferably an alkyl group, an aryl group or a monovalent hetero ring group, and these groups optionally further have a substituent.

L^{H21} is preferably a single bond or an arylene group, more preferably a single bond, and this arylene group optionally has a substituent.

The examples and preferable ranges of the arylene group or the divalent hetero ring group represented by L^{H21} are the same as the examples and preferable ranges of the arylene group or the divalent hetero ring group represented by L^{H1}.

R^{H21} is more preferably an aryl group or a monovalent hetero ring group, and these groups optionally have a substituent.

The examples and preferable ranges of the aryl group and the monovalent hetero ring group represented by R^{H21} are the same as the examples and preferable ranges of the aryl group and the monovalent hetero ring group represented by Ar^{H1} and Ar^{H2}.

The examples and preferable ranges of the substituent which R^{H21} optionally has are the same as the examples and preferable ranges of the substituent which Ar^{H1} and Ar^{H2} optionally have.

The compound represented by the formula (H-1) is preferably a compound represented by the formula (H-2). 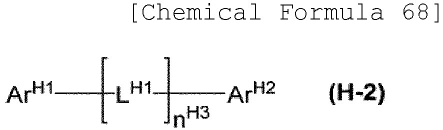 [wherein, Ar^{H1}, Ar^{H2}, n^{H3} and L^{H1} represent the same meaning as described above.]

Specific examples of the low molecular compound used for the host material includes compounds represented by the following formulae.

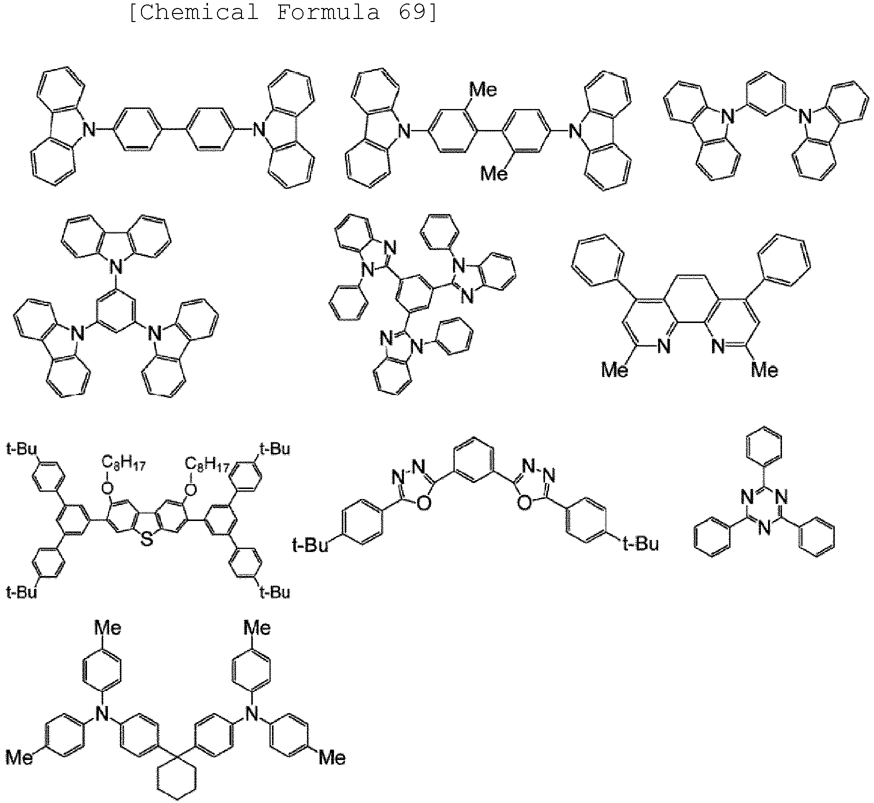

### • Polymer host

The polymer compound used for the host material includes, for example, polymer compounds as hole transporting materials described later and polymer compounds as electron transporting materials described later.

The polymer compound which is preferable as the host material (hereinafter, referred to as "polymer host") will be explained.

The polymer host is preferably a polymer compound containing a constitutional unit represented by the formula (Y) . 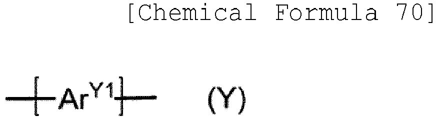 [wherein, Ar^{Y1} represents an arylene group, a divalent hetero ring group, or a divalent group in which an arylene group and a divalent hetero ring group are bonded directly, and these groups optionally have a substituent.]

The arylene group represented by Ar^{Y1} is more preferably a group represented by the formula (A-1), the formula (A-2), the formula (A-6) to the formula (A-10), the formula (A-19) or the formula (A-20), further preferably a group represented by the formula (A-1), the formula (A-2), the formula (A-7), the formula (A-9) or the formula (A-19), and these groups optionally have a substituent.

The divalent hetero ring group represented by Ar^{Y1} is more preferably a group represented by the formula (AA-1) to the formula (AA-4), the formula (AA-10) to the formula (AA-15), the formula (AA-18) to the formula (AA-21), the formula (A-53) or the formula (A-54), further preferably a group represented by the formula (AA-4), the formula (AA-10), the formula (AA-12), the formula (AA-14) or the formula (AA-33), and these groups optionally have a substituent.

The more preferable ranges and further preferable ranges of the arylene group and the divalent hetero ring group in the divalent group in which an arylene group and a divalent hetero ring group are bonded directly represented by Ar^{Y1} are the same as the more preferable ranges and further preferable ranges of the arylene group and the divalent hetero ring group represented by Ar^{Y1} described above, respectively.

"The divalent group in which an arylene group and a divalent hetero ring group are bonded directly" includes, for example, groups represented by the following formulae, and these optionally have a substituent. 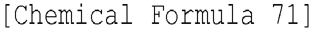 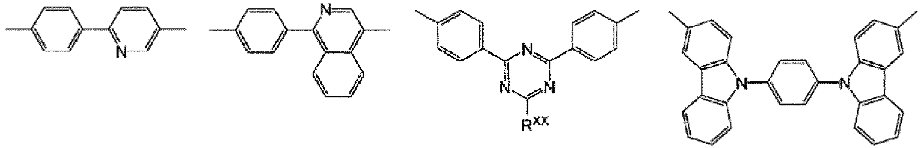 [wherein, R^{XX} represents a hydrogen atom, an alkyl group, a cycloalkyl group, an aryl group or a monovalent hetero ring group, and these groups optionally have a substituent.]

R^{XX} is preferably an alkyl group, a cycloalkyl group or an aryl group, and these groups optionally have a substituent.

The substituent which the group represented by Ar^{Y1} optionally has is preferably an alkyl group, a cycloalkyl group or an aryl group, and these groups optionally further have a substituent.

The constitutional unit represented by the formula (Y) includes, for example, constitutional units represented by the formula (Y-1) to the formula (Y-10); and preferable are constitutional units represented by the formula (Y-1) to the formula (Y-3) from the standpoint of the luminance life of a light emitting device using the composition containing a polymer host and the metal complex of the present invention; and preferable are constitutional units represented by the formula (Y-4) to the formula (Y-7) from the standpoint of electron transportability; and preferable are constitutional units represented by the formula (Y-8) to the formula (Y-10) from the standpoint of hole transportability. 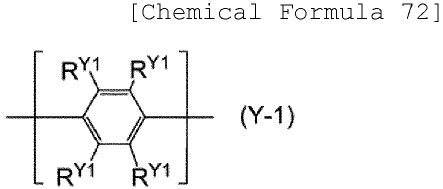 [wherein, R^{Y1} represents a hydrogen atom, an alkyl group, a cycloalkyl group, an alkoxy group, a cycloalkoxy group, an aryl group or a monovalent hetero ring group, and these groups optionally have a substituent. A plurality of R^{Y1} may be the same or different, and the adjacent groups R^{Y1} may be combined together to form a ring together with carbon atoms to which they are attached.]

R^{Y1} is preferably a hydrogen atom, an alkyl group, a cycloalkyl group or an aryl group, and these groups optionally have a substituent. 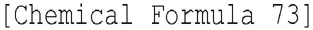 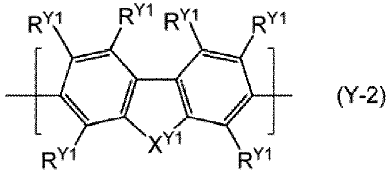 [wherein, R^{Y1} represents the same meaning as described above. X^{Y1} represent a group represented by -C (R^{Y2})₂-,-C (R^{Y2}) =C (R^{Y2}) - or C(R^{Y2})₂-C(R^{Y2})₂-. R^{Y2} represents a hydrogen atom, an alkyl group, a cycloalkyl group, an alkoxy group, a cycloalkoxy group, an aryl group or a monovalent hetero ring group, and these groups optionally have a substituent. A plurality of R^{Y2} may be the same or different, and groups R^{Y2} may be combined together to form a ring together with carbon atoms to which they are attached.]

R^{Y2} is preferably an alkyl group, a cycloalkyl group, an aryl group or a monovalent hetero ring group, more preferably an alkyl group, a cycloalkyl group or an aryl group, and these groups optionally have a substituent.

The combination of two groups R^{Y2} in the group represented by -C(R^{Y2})₂- represented by X^{Y1} is preferably a combination in which both are alkyl groups or cycloalkyl groups, both are aryl groups, both are monovalent hetero ring groups, or one is an alkyl group or a cycloalkyl group and the other is an aryl group or a monovalent hetero ring group, more preferably a combination in which one is an alkyl group or a cycloalkyl group and the other is an aryl group, and these groups optionally have a substituent. Two groups R^{Y2} may be combined together to form a ring together with atoms to which they are attached, and when R^{Y2} forms a ring, the group represented by -C(R^{Y2})₂- is preferably a group represented by the formula (Y-A1) to the formula (Y-A5), more preferably a group represented by the formula (Y-A4), and these groups optionally have a substituent.

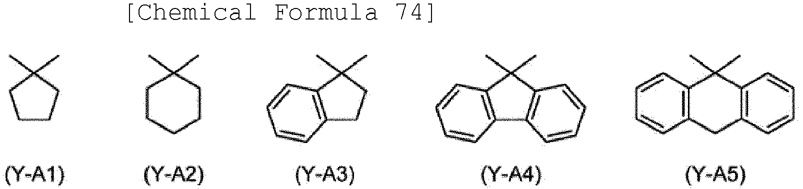

The combination of two groups R^{Y2} in the group represented by -C(R^{Y2})=C(R^{Y2})- represented by X^{Y1} is preferably a combination in which both are alkyl groups or cycloalkyl groups, or one is an alkyl group or a cycloalkyl group and the other is an aryl group, and the foregoing groups optionally have a substituent.

Four groups R^{Y2} in the group represented by -C(R^{Y2})₂-C(R^{Y2})₂- represented by X^{Y1} are preferably alkyl groups or cycloalkyl groups optionally having a substituent. A plurality of R^{Y2} may be combined together to form a ring together with atoms to which they are attached, and when R^{Y2} forms a ring, the group represented by -C(R^{Y2})₂-C(R^{Y2})₂-is preferably a group represented by the formula (Y-B1) to the formula (Y-B5), and more preferably a group represented by the formula (Y-B3), and these groups optionally have a substituent. 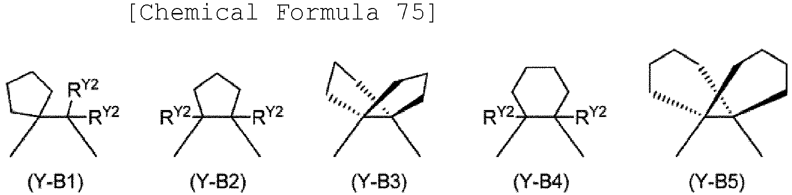 [wherein, R^{Y2} represents the same meaning as described above.] 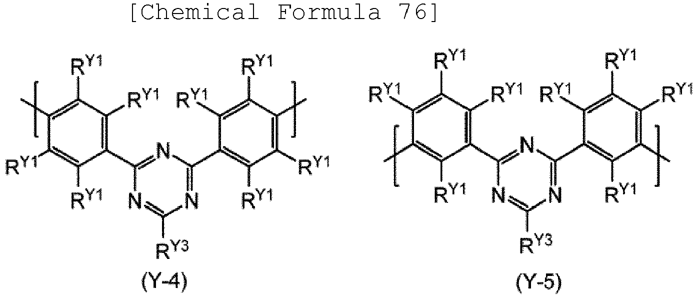 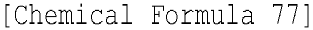 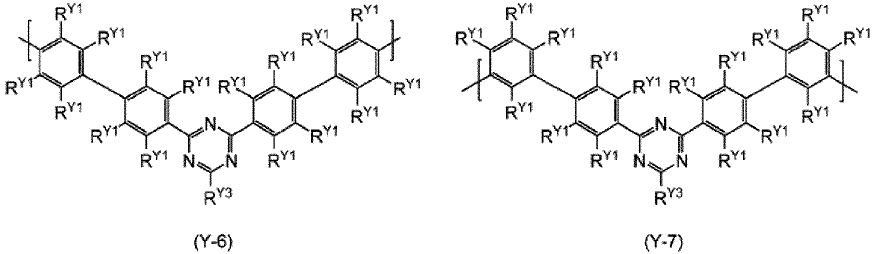 [wherein, R^{Y1} represents the same meaning as described above. R^{Y3} represents a hydrogen atom, an alkyl group, a cycloalkyl group, an alkoxy group, a cycloalkoxy group, an aryl group or a monovalent hetero ring group, and these groups optionally have a substituent.]

R^{Y3} is preferably an alkyl group, a cycloalkyl group, an alkoxy group, a cycloalkoxy group, an aryl group or a monovalent hetero ring group, more preferably aryl group, and these groups optionally have a substituent. 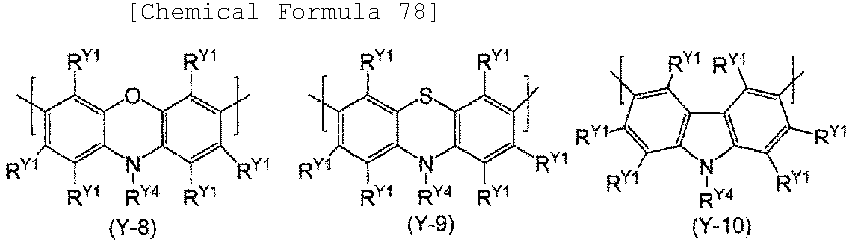 [wherein, R^{Y1} represents the same meaning as described above. R^{Y4} represents a hydrogen atom, an alkyl group, a cycloalkyl group, an alkoxy group, a cycloalkoxy group, an aryl group or a monovalent hetero ring group, and these groups optionally have a substituent.]

R^{Y4} is preferably an alkyl group, a cycloalkyl group, an alkoxy group, a cycloalkoxy group, an aryl group or a monovalent hetero ring group, more preferably aryl group, and these groups optionally have a substituent.

The constitutional unit represented by the formula (Y) includes, for example, constitutional units composed of arylene groups represented by the formula (Y-101) to the formula (Y-121), constitutional units composed of divalent hetero ring groups represented by the formula (Y-201) to the formula (Y-206), and constitutional units composed of divalent groups in which an arylene group and a divalent hetero ring group are bonded directly represented by the formula (Y-301) to the formula (Y-304).

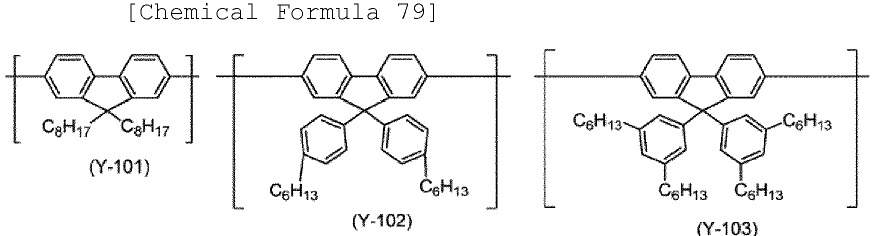

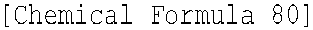

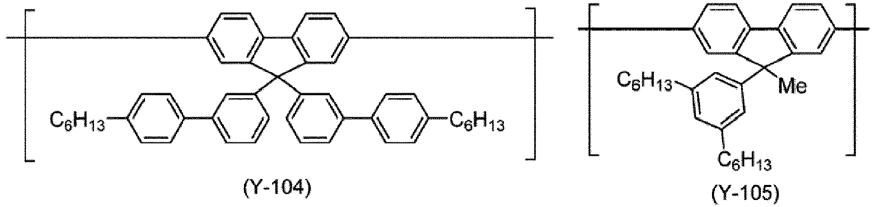

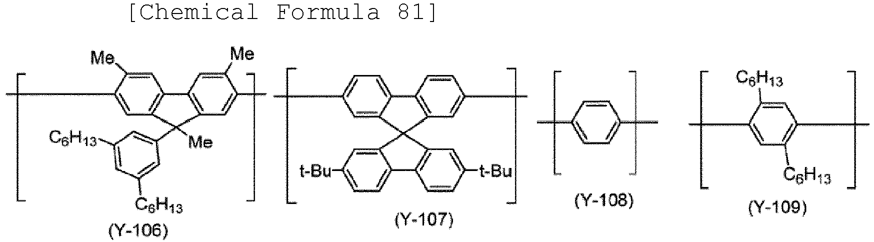

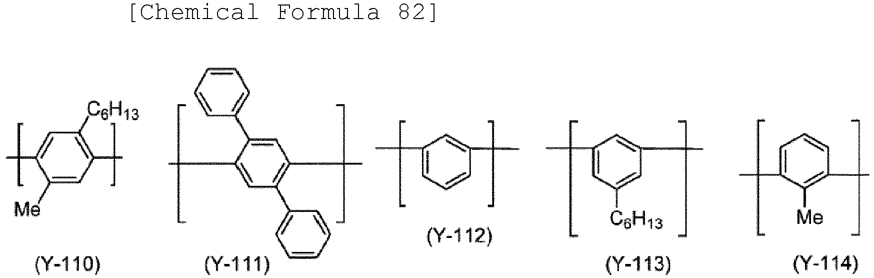

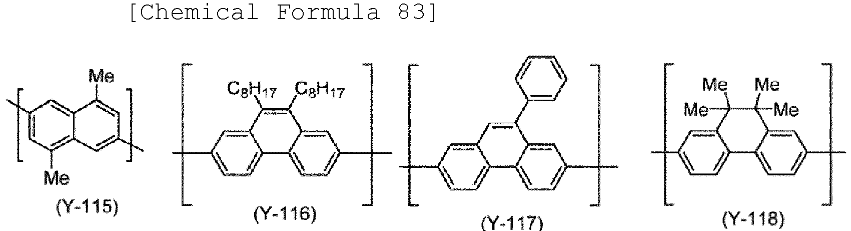

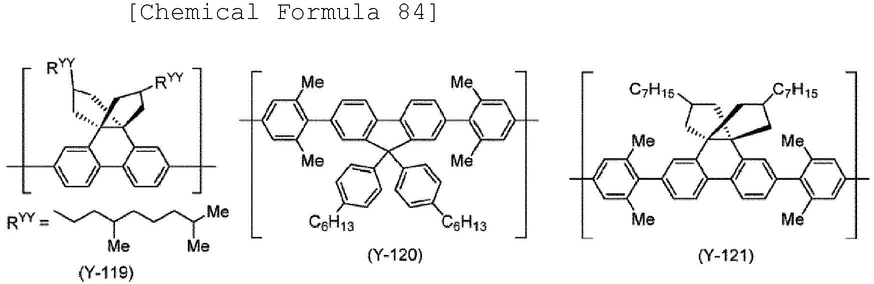

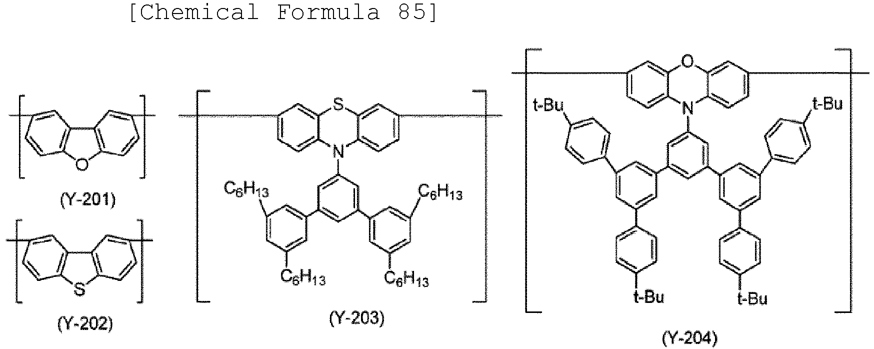

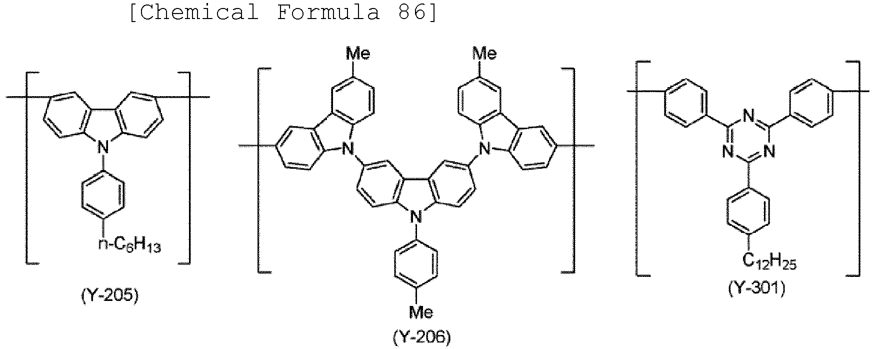

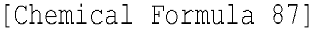

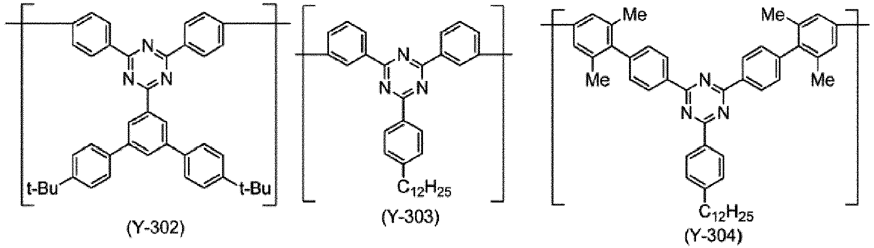

The content of the constitutional unit represented by the formula (Y) in which Ar^{Y1} is an arylene group is preferably 0.5 to 100% by mol, more preferably 60 to 95% by mol, with respect to the total amount of constitutional units contained in the polymer compound, since a light emitting device using the composition containing a polymer host and the metal complex of the present embodiment is excellent in luminance life.

The content of the constitutional unit represented by the formula (Y) in which Ar^{Y1} is a divalent hetero ring group, or a divalent group in which an arylene group and a divalent hetero ring group are bonded directly is preferably 0.5 to 30% by mol, more preferably 3 to 20% by mol, with respect to the total amount of constitutional units contained in the polymer compound, since a light emitting device using the composition containing a polymer host and the metal complex of the present embodiment is excellent in charge transportability.

The constitutional unit represented by the formula (Y) may be contained singly or in combination of two or more in the polymer host.

It is preferable that the polymer host further contains a constitutional unit represented by the formula (X), since hole transportability is excellent. 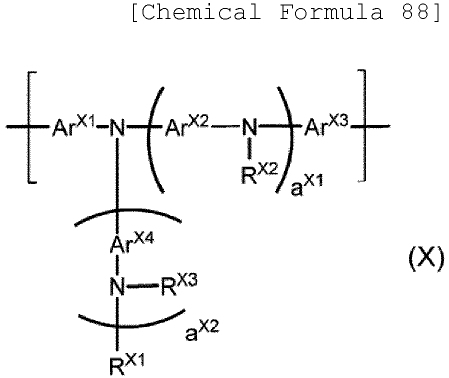 [wherein, a^{X1} and a^{X2} each independently represent an integer of 0 or more. Ar^{X1} and Ar^{x3} each independently represent an arylene group or a divalent hetero ring group, and these groups optionally have a substituent. Ar^{x2} and Ar^{x4} each independently represent an arylene group, a divalent hetero ring group, or a divalent group in which an arylene group and a divalent hetero ring group are bonded directly, and these groups optionally have a substituent. R^{X1}, R^{X2} and R^{X3} each independently represent a hydrogen atom, an alkyl group, a cycloalkyl group, an aryl group or a monovalent hetero ring group, and these groups optionally have a substituent.]

a^{X1} is preferably 2 or less, more preferably 1, since a light emitting device using the composition containing a polymer host and the metal complex of the present embodiment is excellent in luminance life.

a^{X2} is preferably 2 or less, more preferably 0, since a light emitting device using the composition containing a polymer host and the metal complex of the present embodiment is excellent in luminance life.

R^{X1}, R^{X2} and R^{X3} represent preferably an alkyl group, a cycloalkyl group, an aryl group or a monovalent hetero ring group, more preferably an aryl group, and these groups optionally have a substituent.

The arylene group represented by Ar^{X1} and Ar^{x3} is more preferably a group represented by the formula (A-1) or the formula (A-9), further preferably a group represented by the formula (A-1), and these groups optionally have a substituent.

The divalent hetero ring group represented by Ar^{X1} and Ar^{X3} is more preferably a group represented by the formula (AA-1), the formula (AA-2) or the formula (AA-7) to the formula (AA-26), and these groups optionally have a substituent.

Ar^{X1} and Ar^{x3} represent preferably an arylene group optionally having a substituent.

The arylene group represented by Ar^{x2} and Ar^{x4} is more preferably a group represented by the formula (A-1), the formula (A-6), the formula (A-7), the formula (A-9) to the formula (A-11) or the formula (A-19), and these groups optionally have a substituent.

The more preferable range of the divalent hetero ring group represented by Ar^{x2} and Ar^{X4} is the same as the more preferable range of the divalent hetero ring group represented by Ar^{X1} and Ar^{x3}.

The more preferable ranges and further preferable ranges of the arylene group and the divalent hetero ring group in the divalent group in which an arylene group and a divalent hetero ring group are bonded directly represented by Ar^{x2} and Ar^{x4} are the same as the more preferable ranges and further preferable ranges of the arylene group and the divalent hetero ring group represented by Ar^{X1} and Ar^{x3}, respectively.

The divalent group in which an arylene group and a divalent hetero ring group are bonded directly represented by Ar^{X2} and Ar^{x4} includes the same groups as the divalent group in which an arylene group and a divalent hetero ring group are bonded directly represented by Ar^{Y1} in the formula (Y).

Ar^{x2} and Ar^{x4} represent preferably an arylene group optionally having a substituent.

The substituent which the group represented by Ar^{X1} to Ar^{X4} and R^{X1} to R^{X3} optionally has is preferably an alkyl group, a cycloalkyl group or an aryl group, and these groups optionally further have a substituent.

The constitutional unit represented by the formula (X) is preferably a constitutional unit represented by the formula (X-1) to the formula (X-7), more preferably a constitutional unit represented by the formula (X-1) to the formula (X-6), further preferably a constitutional unit represented by the formula (X-3) to the formula (X-6). 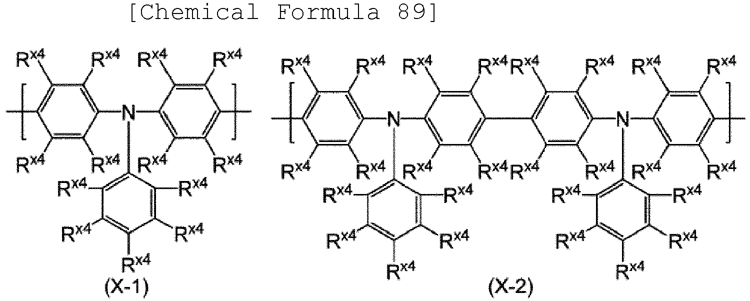 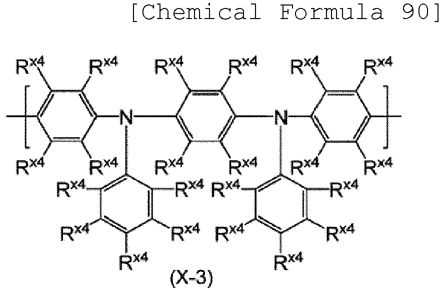 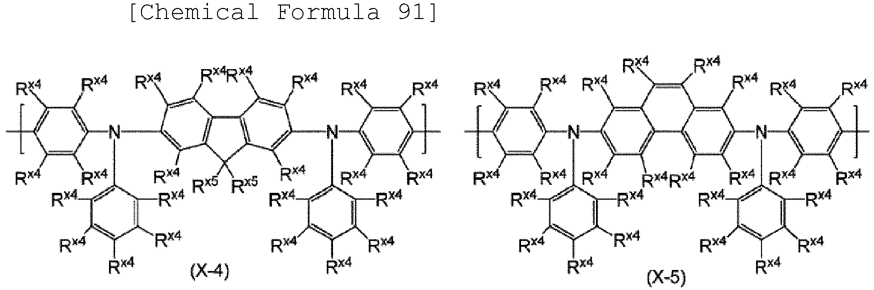 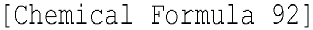 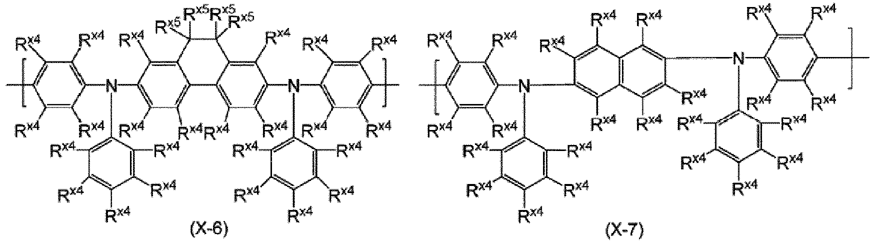 [wherein, R^{X4} and R^{X5} each independently represent a hydrogen atom, an alkyl group, a cycloalkyl group, an alkoxy group, a cycloalkoxy group, an aryl group, an aryloxy group, a halogen atom, monovalent hetero ring group or a cyano group, and these groups optionally have a substituent. A plurality of R^{X4} may be the same or different. A plurality of R^{X5} may be the same or different, and the adjacent groups R^{X5} may be combined together to form a ring together with carbon atoms to which they are attached.]

The content of the constitutional unit represented by the formula (X) is preferably 0.1 to 50% by mol, more preferably 1 to 40% by mol, further preferably 2 to 30% by mol, with respect to the total amount of constitutional units contained in a polymer host, since hole transportability is excellent.

The constitutional unit represented by the formula (X) includes, for example, constitutional units represented by the formula (X1-1) to the formula (X1-17), preferably constitutional units represented by the formula (X1-3) to the formula (X1-10).

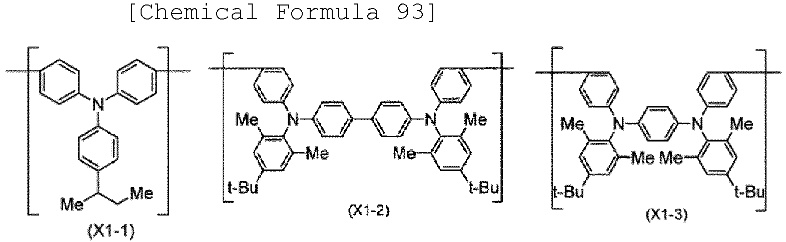

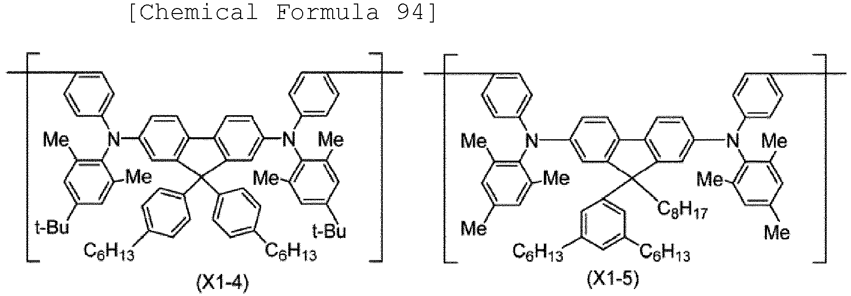

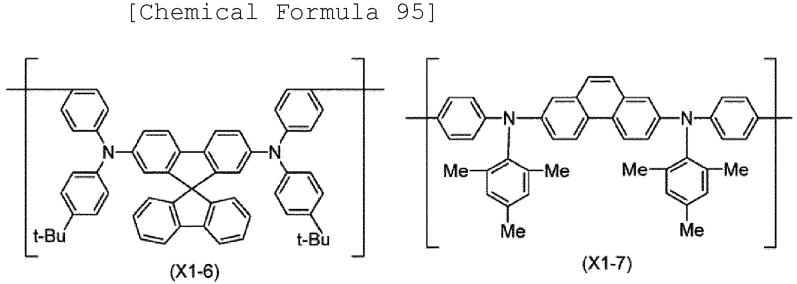

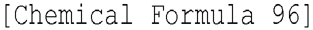

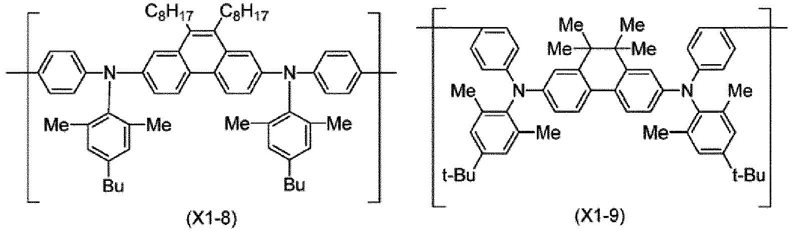

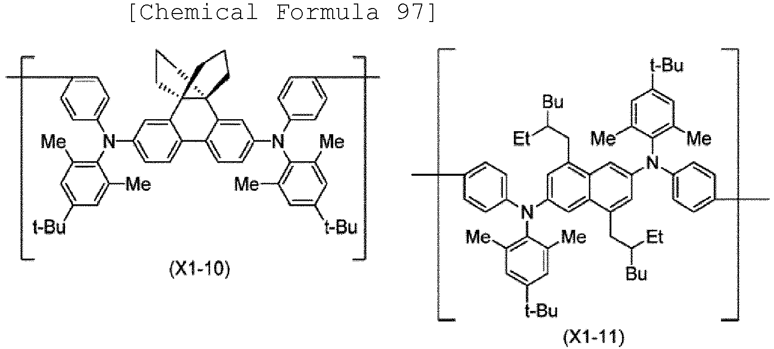

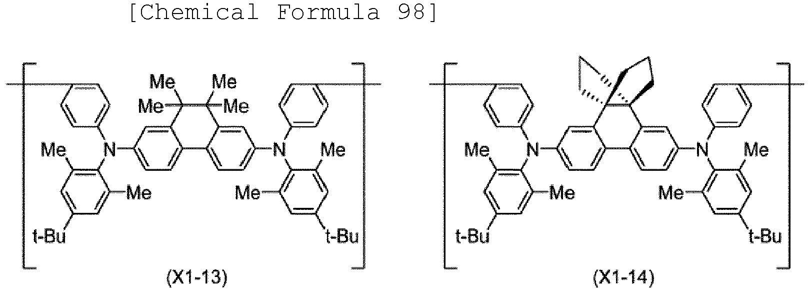

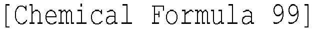

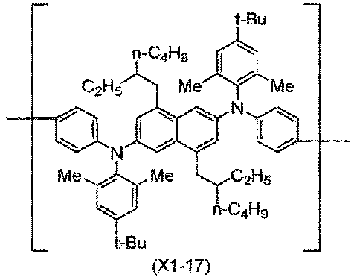

In the polymer host, the constitutional unit represented by the formula (X) may be contained singly or in combination of two or more.

The polymer host includes, for example, polymer compounds P-1 to P-7 in Table 1. Here, the "other" constitutional unit means a constitutional unit other than the constitutional unit represented by the formula (Y) and the constitutional unit represented by the formula (X).

**[Table 1]**

| Polymer compound | Constitutional unit and its molar ratio | | | | |
|---|---|---|---|---|---|
| | Formula (Y) | | | Formula (X) | other |
| | Formula (Y-1) to formula (Y-3) | Formula (Y-4) to formula (Y-7) | Formula (Y-8) to formula (Y-10) | Formula (X-1) to formula (X-7) | |
| | p | q | r | s | t |
| P-1 | 0.1 to 99.9 | 0.1 to 99.9 | 0 | 0 | 0 to 30 |
| P-2 | 0.1 to 99.9 | 0 | 0.1 to 99.9 | 0 | 0 to 30 |
| P-3 | 0.1 to 99.9 | 0 | 0 | 0.1 to 99.9 | 0 to 30 |
| P-4 | 0.1 to 99.8 | 0.1 to 99.8 | 0 | 0.1 to 99.8 | 0 to 30 |
| P-5 | 0.1 to 99.8 | 0.1 to 99.8 | 0.1 to 99.8 | 0 | 0 to 30 |
| P-6 | 0.1 to 99.8 | 0 | 0.1 to 99.8 | 0.1 to 99.8 | 0 to 30 |
| P-7 | 0.1 to 99.7 | 0.1 to 99.7 | 0.1 to 99.7 | 0.1 to 99.7 | 0 to 30 |

In the table, p, q, r, s and t represent the molar ratio of each constitutional unit. p+q+r+s+t = 100 and 100 ≥ p+q+r+s ≥ 70. The other constitutional unit means a constitutional unit other than the constitutional unit represented by the formula (Y) and the constitutional unit represented by the formula (X).

The polymer host may be any of a block copolymer, a random copolymer, an alternating copolymer and a graft copolymer, and may also be in another form, and from the above-described standpoint, a copolymer obtained by copolymerizing a plurality of raw material monomers is preferred.

### <Production method of polymer host>

The polymer host can be produced by using a known polymerization method described in Chemical Reviews (Chem. Rev.), Vol. 109, pp. 897-1091 (2009) and the like, and exemplified are methods for polymerizing by a coupling reaction using a transition metal catalyst such as the Suzuki reaction, the Yamamoto reaction, the Buchwald reaction, the Stille reaction, the Negishi reaction, the Kumada reaction and the like.

In the above-described polymerization method, the method of charging monomers includes a method of charging the whole amount of monomers into the reaction system at once, a method of charging a part of monomers and reacting them, then, charging the remaining monomers at once, continuously or dividedly, a method of charging monomers continuously or dividedly, and the like.

The transition metal catalyst is not particularly restricted, and includes palladium catalysts and nickel catalysts.

The post-treatment of the polymerization reaction is conducted by known methods, for example, a method of removing water-soluble impurities by liquid separation, a method of adding the reaction liquid after the polymerization reaction to a lower alcohol such as methanol and the like, filtrating the deposited precipitate, then, drying it, and the like, singly or in combination. When the purity of the polymer host is low, it can be purified by a usual method such as, for example, recrystallization, reprecipitation, continuous extraction with a Soxhlet extractor, column chromatography and the like.

### [Hole transporting material]

The hole transporting material is classified into a low molecular compound and a polymer compound, and is preferably a polymer compound, more preferably a polymer compound having a crosslinkable group.

The polymer compound includes, for example, polyvinylcarbazoles and derivatives thereof; polyarylenes having an aromatic amine structure in the side chain or main chain, and derivatives thereof. The polymer compound may be a compound to which an electron accepting site is bonded. The electron accepting site includes, for example, fullerenes, tetrafluorotetracyanoquinodimethane, tetracyanoethylene, trinitrofluorenone and the like, preferably fullerenes.

In the composition of the present embodiment, the blending amount of a hole transporting material is usually 1 to 400 parts by mass, preferably 5 to 150 parts by mass, with respect to 100 parts by mass of the metal complex of the present embodiment.

The hole transporting material may be used singly or in combination of two or more.

### [Electron transporting material]

The electron transporting material is classified into a low molecular compound and a polymer compound. The electron transporting material may have a crosslinkable group.

The low molecular compound includes, for example, a metal complex having 8-hydroxyquinoline as a ligand; oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polyphenylene, polyfluorene, and derivatives thereof. The polymer compound may be doped with a metal.

In the composition of the present embodiment, the blending amount of an electron transporting material is usually 1 to 400 parts by mass, preferably 5 to 150 parts by mass, with respect to 100 parts by mass of the metal complex of the present embodiment.

The electron transporting material may be used singly or in combination of two or more.

### [Hole injection material and electron injection material]

The hole injection material and the electron injection material are each classified into a low molecular compound and a polymer compound. The hole injection material and the electron injection material may have a crosslinkable group.

The low molecular compound includes, for example, metal phthalocyanines such as copper phthalocyanine and the like; carbon; oxides of metals such as molybdenum, tungsten and the like; and metal fluorides such as lithium fluoride, sodium fluoride, cesium fluoride, potassium fluoride and the like.

The polymer compound includes, for example, conductive polymers such as polyaniline, polythiophene, polypyrrole, polyphenylenevinylene, polythienylenevinylene, polyquinoline and polyquinoxaline, and derivatives thereof; and polymers containing a group represented by the formula (X) in the main chain or side chain, and the like.

In the composition of the present embodiment, the blending amounts of a hole injection material and an electron injection material are each usually 1 to 400 parts by mass, preferably 5 to 150 parts by mass, with respect to 100 parts by mass of the metal complex of the present embodiment.

The electron injection material and the hole injection material may each be used singly or in combination of two or more.

### [Ion doping]

When the hole injection material or the electron injection material contains a conductive polymer, the electrical conductivity of the conductive polymer is preferably 1 × 10⁻⁵ S/cm to 1 × 10³ S/cm or less. In order to set the electric conductivity of the conductive polymer within the above range, the conductive polymer can be doped with an appropriate amount of ions.

The types of ions to be doped are anions for hole injection materials and cations for electron injection materials. The anion includes, for example, a polystyrenesulfonate ion, an alkylbenzenesulfonate ion and a camphorsulfonate ion. The cation includes, for example, a lithium ion, a sodium ion, a potassium ion, and a tetrabutylammonium ion.

The ions to be doped may be used singly or in combination of two or more.

### [Light emitting material]

The light emitting material (differing from the metal complex of the present embodiment) is classified into a low molecular compound and a polymer compound. The light emitting material may have a crosslinkable group.

The low molecular compound includes, for example, naphthalene and derivatives thereof, anthracene and derivatives thereof, perylene and derivatives thereof, and triplet light emitting complexes having iridium, platinum or europium as a central metal.

The polymer compound includes polymer compounds containing, for example, a phenylene group, a naphthalenediyl group, an anthracenediyl group, a fluorenediyldiyl group, a phenanthrenediyl group, a dihydrophenanthrenediyl group, a group represented by the formula (X), a carbazolediyl group, a phenoxazinediyl group, a phenothiazinediyl group, an anthracenediyl group, a pyrenediyl group, and the like.

The light emitting material may contain a low molecular compound and a polymer compound, preferably contains a triplet light emitting complex and a polymer compound.

The triplet light emitting complex includes, for example, metal complexes shown below.

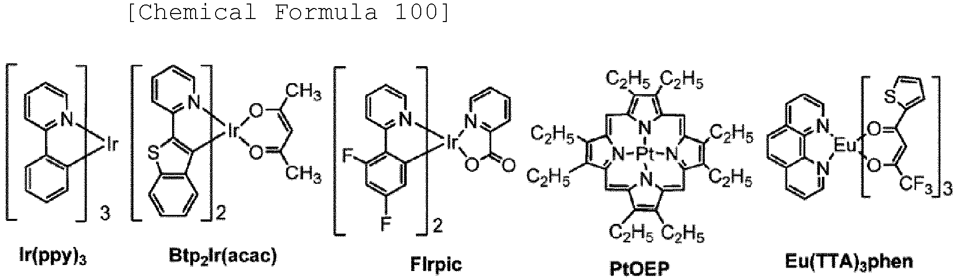

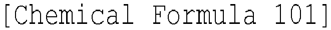

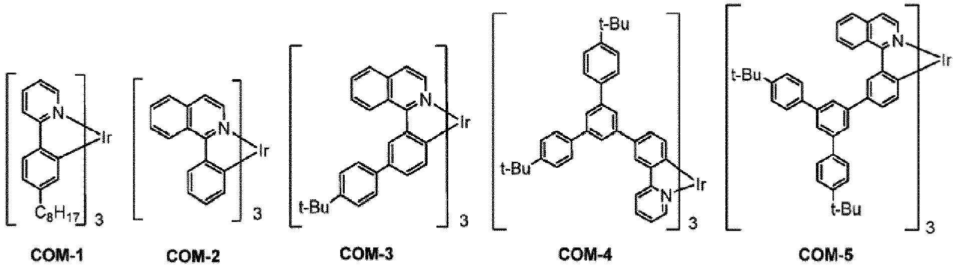

In the composition of the present embodiment, the content of a light emitting material is usually 0.1 to 400 parts by mass, with respect to 100 parts by mass of the metal complex of the present invention.

The metal complex and the composition containing a solvent (hereinafter, referred to as "ink" in some cases) of the present embodiment are suitable for fabricating a light emitting device using a printing method such as an inkjet printing method, a nozzle printing method, and the like.

The viscosity of the ink may be adjusted according to the type of the printing method, but when applied to a printing method in which a solution passes through an ejection device such as an inkjet printing method and the like, it is preferably 1 to 20 mPa•s at 25°C to prevent clogging and flight bending during discharge.

The solvent contained in the ink is preferably a solvent capable of dissolving or uniformly dispersing the solid content in the ink. The solvent includes, for example, chlorine-based solvents such as 1,2-dichloroethane, 1,1,2-trichloroethane, chlorobenzene, o-dichlorobenzene and the like; ether solvents such as tetrahydrofuran, dioxane, anisole, 4-methylanisole and the like; aromatic hydrocarbon solvents such as toluene, xylene, mesitylene, ethylbenzene, n-hexylbenzene, cyclohexylbenzene and the like; aliphatic hydrocarbon solvents such as cyclohexane, methylcyclohexane, n-pentane, n-hexane, n-heptane, n-octane, n-nonane, n-decane, n-decane, bicyclohexyl and the like; ketone solvents such as acetone, methyl ethyl ketone, cyclohexanone, acetophenone and the like; ester solvents such as ethyl acetate, butyl acetate, ethyl cellosolve acetate, methyl benzoate, phenyl acetate and the like; polyhydric alcohol solvents such as ethylene glycol, glycerin, 1,2-hexanediol and the like; alcohol solvents such as isopropyl alcohol, cyclohexanol and the like; sulfoxide solvents such as dimethyl sulfoxide and the like; amide solvents such as N-methyl-2-pyrrolidone, N,N-dimethylformamide and the like. The solvent may be used only singly or in combination of two or more.

In the ink, the blending amount of a solvent is usually 1000 to 100000 parts by mass, preferably 2000 to 20000 parts by mass, with respect to 100 parts by mass of the metal complex of the present embodiment.

### <Film>

The film contains the metal complex of the present embodiment.

The film includes an insolubilized film in which the metal complex of the present embodiment is insolubilized in a solvent by cross-linking it. The insolubilized film is a film obtained by cross-linking the metal complex of the present embodiment with an external stimulus such as heating, light irradiation, and the like. Since the insolubilized film is substantially insoluble in a solvent, it can be suitably used for lamination of a light emitting device.

The heating temperature for cross-linking the film is usually 25 to 300°C; and since the external quantum yield becomes excellent, it is preferably 50 to 250°C, more preferably 150 to 200°C.

The type of the light used for light irradiation for cross-linking the film is, for example, ultraviolet light, near ultraviolet light, and visible light.

The film is suitable as a hole transporting layer or a hole injection layer in a light emitting device.

The film can be fabricated, for example, by a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, or a nozzle coat method, using an ink.

The thickness of the film is usually 1 nm to 10 µm.

### <Light emitting device>

The light emitting device of the present embodiment is a light emitting device obtained by using the metal complex of the present embodiment, may be one in which the metal complex of the present embodiment is cross-linked intramolecularly or intermolecularly, or one in which the metal complex of the present embodiment is cross-linked intramolecularly and intermolecularly.

The constitution of the light emitting device of the present embodiment has, for example, electrodes consisting of an anode and a cathode, and a layer obtained by using the metal complex of the present embodiment disposed between the electrodes.

### [Layer constitution]

The layer obtained by using the metal complex of the present embodiment is usually one or more of a light emitting layer, a hole transporting layer, a hole injection layer, an electron transporting layer, and an electron injection layer, preferably a light emitting layer. These layers contain a light emitting material, a hole transporting material, a hole injection material, an electron transporting material, and an electron injection material, respectively. These layers can be formed by dissolving a light emitting material, a hole transporting material, a hole injection material, an electron transporting material, and an electron injection material in the solvent described above, to prepare inks, and using the same method as for fabrication of the film described above using the obtained inks.

The light emitting device has a light emitting layer between an anode and a cathode. The light emitting device of the present embodiment preferably has at least one of a hole injection layer and a hole transporting layer between an anode and a light emitting layer from the standpoint of hole injectability and hole transportability, and preferably has at least one of an electron injection layer and an electron transporting layer between a cathode and a light emitting layer from the standpoint of electron injectability and electron transportability.

The materials of a hole transporting layer, an electron transporting layer, a light emitting layer, a hole injection layer and an electron injection layer include the hole transporting material, the electron transporting material, the light emitting material, the hole injection material and the electron injection material described above, respectively, in addition to the metal complex of the present embodiment.

When the material of a hole transporting layer, the material of an electron transporting layer and the material of a light emitting layer are soluble in a solvent used in forming layers adjacent to a hole transporting layer, an electron transporting layer and a light emitting layer, respectively, in fabricating a light emitting device, it is preferable that the material has a crosslinkable group for avoiding the material from being dissolved in the solvent. After forming each layer using the material having a crosslinkable group, the crosslinkable group can be cross-linked to insolubilize the layer.

The method of forming each layer such as a light emitting layer, a hole transporting layer, an electron transporting layer, a hole injection layer, an electron injection layer and the like in the light emitting device of the present embodiment includes, for example, a vacuum vapor deposition method from a powder, and a method by film formation from a solution or melted state when a low molecular compound is used, and for example, a method by film formation from a solution or melted state when a polymer compound is used.

The order, the number and the thickness of the layers to be laminated may be adjusted in consideration of the external quantum yield and the device life.

### [Substrate/Electrode]

The substrate in the light emitting device is preferably a substrate on which an electrode can be formed and which does not chemically change when forming the organic layer, and is a substrate made of a material such as, for example, glass, plastic, silicon, or the like. When an opaque substrate is used, it is preferable that the electrode farthest from the substrate is transparent or semitransparent.

The material for the anode includes, for example, conductive metal oxides and semitransparent metals, preferably, indium oxide, zinc oxide, tin oxide; conductive compounds such as indium•tin•oxide (ITO), indium•zinc•oxide, and the like; a complex of argentine, palladium and copper (APC); NESA, gold, platinum, silver, and copper.

The material of the cathode includes, for example, metals such as lithium, sodium, potassium, rubidium, cesium, beryllium, magnesium, calcium, strontium, barium, aluminum, zinc, indium and the like; alloys composed of two or more of them; alloys composed of one or more of them and one or more of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The anode and the cathode each may take a laminated structure composed of two or more layers.

### [Application]

The light emitting device of the present embodiment is useful for, for example, display and illumination.

Suitable embodiments of the present invention were described above, but the present invention is not limited to the embodiments described above.

### EXAMPLES

The present invention will be illustrated further in detail below with reference to examples, but the present invention is not limited to these examples.

LC-MS was measured by a method described below.

A measurement sample was dissolved in chloroform or tetrahydrofuran so as to give a concentration of about 2 mg/mL, and about 1 µL of the solution was injected into LC-MS (manufactured by Agilent, trade name: 1290 Infinity LC and 6230 TOF LC/MS). As the mobile phase for LC-MS, acetonitrile and tetrahydrofuran were used while changing the ratio thereof, and allowed to flow at a flow rate of 1.0 mL/min. As the column, SUMIPAX ODS Z-CLUE (manufactured by Sumika Chemical Anaysis Service, Ltd., internal diameter: 4.6 mm, length: 250 mm, particle size: 3 µm) was used.

NMR was measured by a method described below.

Five to ten milligrams (5 to 10 mg) of a measurement sample was dissolved in about 0.5 mL of heavy chloroform (CDCl₃), heavy tetrahydrofuran, heavy dimethyl sulfoxide, heavy acetone, heavy N,N-dimethylformamide, heavy toluene, heavy methanol, heavy ethanol, heavy 2-propanol or heavy methylene chloride, and NMR thereof was measured using an NMR apparatus (trade name: JNM-ECZ400S/L1, manufactured by JEOL RESONANCE, or trade name: AVANCE600, manufactured by Bruker).

As the index for the purity of a compound, the value of the high performance liquid chromatography (HPLC) area percentage was used. This value is a value according to HPLC (manufactured by Shimadzu Corp., trade name: LC-20A) at UV = 254 nm, unless otherwise stated. In this procedure, the compound to be measured was dissolved in tetrahydrofuran or chloroform so as to give a concentration of 0.01 to 0.2% by mass, and the solution was injected into HPLC at an amount of 1 to 10 µL depending on the concentration. As the mobile phase for HPLC, acetonitrile/tetrahydrofuran were used while changing the ratio thereof from 100/0 to 0/100 (volume ratio) and allowed to flow at a flow rate of 1.0 mL/min. As the column, SUMIPAX ODS Z-CLUE (manufactured by Sumika Chemical Anaysis Service, Ltd., internal diameter: 4.6 mm, length: 250 mm, particle size: 3 µm) or an ODS column having the equivalent ability was used. As the detector, Photo Diode Array detector (manufactured by Shimadzu Corp., trade name: SPD-M20A) was used.

As the index for the purity of a compound, the value of the gas chromatography (GC) area percentage was used. This value is a value according to GC (manufactured by Agilent, trade name: Agilent 7820), unless otherwise stated. In this procedure, the compound to be measured was dissolved in tetrahydrofuran or chloroform so as to give a concentration of 0.01 to 0.2% by mass, and the solution was injected into GC at an amount of 1 to 10 µL depending on the concentration. As the carrier, helium was used and allowed to flow at a flow rate of 1.0 mL/min. The column oven was used while changing the temperature from 50°C to 300°C. The heater temperature was 280°C at the injection port, and 320°C at the detector. As the column, BPX-5 manufactured by SGE (30 m × 0.25 mm × 0.25 µm) was used.

TLC-MS was measured by a method described below.

A measurement sample was dissolved in any of toluene, tetrahydrofuran or chloroform at an arbitrary concentration, and applied on TLC plate for DART (manufactured by Techno Applications, trade name: YSK5-100), and the value was measured using TLC-MS (manufactured by JEOL Ltd., trade name: JMS-T100TD (The AccuTOF TLC)). The temperature of the helium gas at measurement was controlled in the range of 200 to 400°C.

### <Example 1> Synthesis of metal complex M1

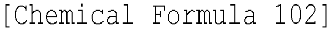

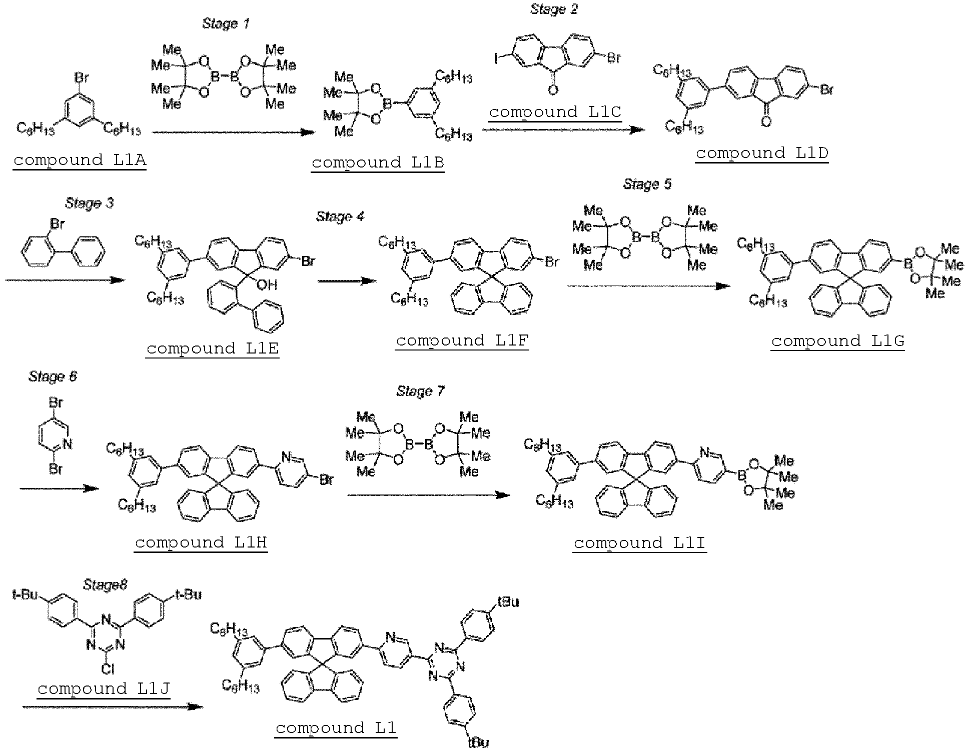

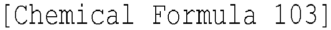

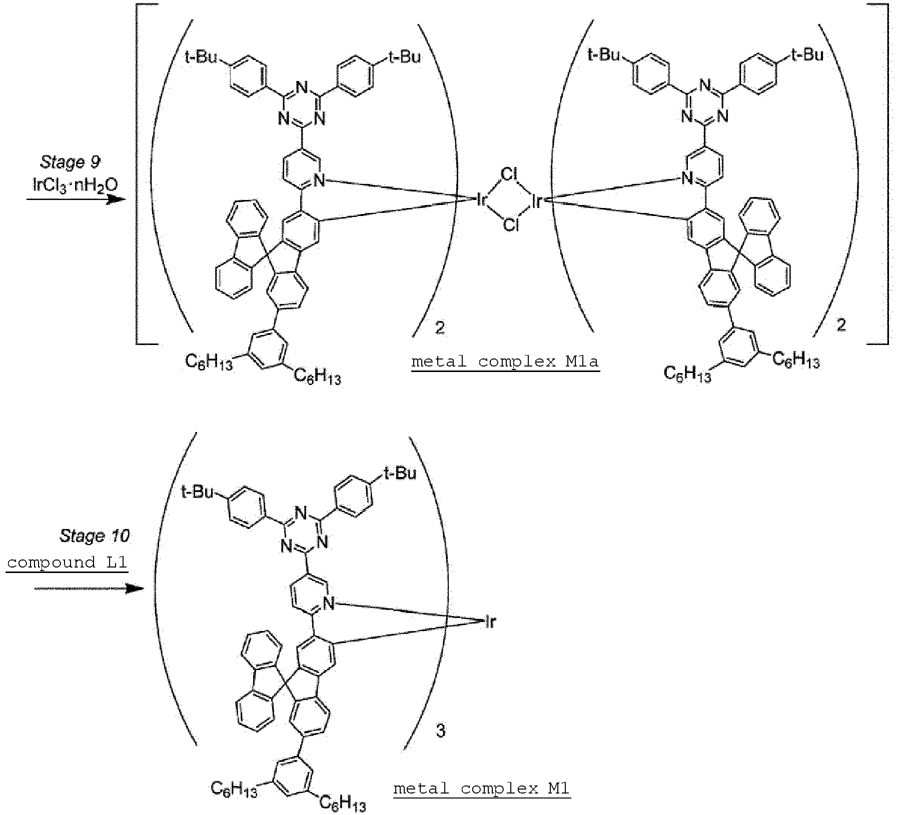

### (Synthesis of compound L1A)

A compound L1A was synthesized with reference to a method described in JP-A No. 2011-174062.

### (Stage 1: Synthesis of compound L1B)

A nitrogen atmosphere was prepared in a reaction vessel, then, the compound L1A (300 g), bis(pinacolato)diboron (258 g), [1,1'-bis(diphenylphosphino)ferrocene]palladium(II) dichloride-dichloromethane adduct (15 g), potassium acetate (136 g), and 1,2-dimethoxyethane (3 L) were added, and the mixture was stirred at 80°C for 1 hour. The resultant reaction liquid was cooled down to room temperature, then, ion exchanged water (2.7 L) and n-heptane (1.4 L) were added, and the aqueous layer was removed, and filtration was performed. The resultant filtrate was concentrated under reduced pressure, to obtain a coarse product. The resultant coarse product was crystallized using acetonitrile, then, dried under reduced pressure, to obtain a compound L1B (300 g). The compound L1B had a GC area percentage value of 99.5% or more.

### (Stage 2: Synthesis of compound L1D)

A nitrogen atmosphere was prepared in a reaction vessel, then, the compound L1B (73 g), the compound L1C (75 g), tetrakis(triphenylphosphine)palladium(0) (4.5 g), a 35% by mass tetraethyl ammonium hydroxide aqueous solution (328 g), ion exchanged water (190 mL), and toluene (1040 mL) were added, and the mixture was stirred at 80°C for 2 hours. The resultant reaction liquid was cooled down to room temperature, then, ion exchanged water (400 mL) was added, and the aqueous layer was removed. The resultant organic layer was washed with ion exchanged water, then, filtrated, and the resultant filtrate was concentrated under reduced pressure, to obtain a coarse product. The resultant coarse product was purified by silica gel column chromatography (a mixed solvent of toluene and n-hexane), to obtain a compound L1D (79 g). The compound L1D showed an HPLC area percentage value of 99.3%.

TLC-MS (DART positive): m/z = 502[M]⁺

¹H-NMR (600 mHz, CD₂Cl₂) δ (ppm) = 7.89 (s, 1H), 7.81-7.73 (m, 2H), 7.68-7.58 (m, 2H), 7.47 (d, 1H), 7.27 (s, 2H), 7.05 (s, 1H), 2.69-2.61 (m, 4H), 1.70-1.60 (m, 4H), 1.43-1.28 (m, 12H), 0.94-0.85 (m, 6H).

### (Stage 3: Synthesis of compound L1E)

A nitrogen atmosphere was prepared in a reaction vessel, then, 2-bromodiphenyl (53 g), and tetrahydrofuran (1300 g) were added, and the mixture was cooled down to - 70°C. To this was added a 1.6 M n-butyllithiumn hexane solution (139 mL) slowly, and the mixture was stirred at - 70°C for 1 hour. To this was added a mixture of the compound L1D (72 g), toluene (72 g) and tetrahydrofuran (216 g) slowly, thereafter, the mixture was stirred at - 65°C for 2 hours. To this was added methanol (72 g) slowly, and the temperature of the resultant reaction liquid was adjusted to room temperature, then, ion exchanged water (360 g) and toluene (360 g) were added, and the aqueous layer was removed. The resultant organic layer was washed with ion exchanged water, the resultant organic layer was dried over magnesium sulfate, then, filtrated. The resultant filtrate was concentrated under reduced pressure, to obtain a coarse product. The resultant coarse product was purified by silica gel column chromatography (a mixed solvent of toluene and n-hexane), to obtain a compound L1E (75 g). The compound L1E showed an HPLC area percentage value of 99.5% or more.

TLC-MS (DART positive): m/z = 639[M-OH]⁺

¹H-NMR (600 mHz, CD₂Cl₂) δ (ppm) = 8.45 (d, 1H), 7.58-7.52 (m, 1H), 7.47-7.43 (m, 1H), 7.40-7.31 (m, 4H), 7.22-7.16 (m, 3H), 7.08 (d, 1H)6.99 (s, 1H), 6.92-6.83 (m, 2H), 6.75-6.00 (m, 2H), 6,14-6.03 (m, 2H), 2.67-2.58 (m, 4H), 2.48 (s, 1H), 1.68-1.58 (m, 4H), 1.41-1.26 (m, 12H), 0.93-0.86 (m, 6H).

### (Stage 4: Synthesis of compound L1F)

A nitrogen atmosphere was prepared in a reaction vessel, then, the compound L1E (74 g), and toluene (856 mL) were added, and the mixture was cooled down to 0°C. To this was added concentrated sulfuric acid (17 g) slowly, and the mixture was stirred at 0°C for 3 hours. To this was added ion exchanged water (742 g) slowly, thereafter, toluene (742 g) was added, and the resultant reaction liquid was stirred at room temperature for 40 minutes. The aqueous layer was removed, the resultant organic layer was washed with a sodium hydrogen carbonate aqueous solution, then, washed with ion exchanged water, and the resultant organic layer was dried over magnesium sulfate, then, filtrated. The resultant filtrate was concentrated under reduced pressure, to obtain a coarse product. The resultant coarse product was crystallized using a mixed solvent of toluene and acetonitrile, then, dried under reduced pressure, to obtain a compound L1F (68 g). The compound L1F showed an HPLC area percentage value of 99.5% or more.

TLC-MS (DART positive): m/z = 639[M+H]⁺

¹H-NMR (600 mHz, CD₂Cl₂) δ (ppm) = 7.93-7.88 (m, 3H), 7.77 (d, 1H), 7.65 (dd, 1H), 7.52 (dd, 1H), 7.41 (t, 2H), 7.16 (t, 2H), 7.04 (s, 2H), 6.93-6.90 (m, 2H), 6.83-6.74 (m, 3H), 2.57-2.49 (m, 4H), 1.59-1.49 (m, 4H), 1.34-1.22 (m, 12H), 0.89-0.83 (m, 6H).

### (Stage 5: Synthesis of compound L1G)

An argon gas atmosphere was prepared in a reaction vessel, then, the compound L1F (14 g),

bis(pinacolato)diboron (6.4 g), cyclopentylmethyl ether (135 mL), [1,1'-bis(diphenylphosphino)ferrocene]palladium(II) dichloride-dichloromethane adduct (860 mg) and potassium acetate (4.1 g) were added, and the mixture was stirred at 100°C for 6 hours.

Thereafter, to this was added n-heptane, and the resultant organic layer was washed with ion exchanged water. Thereafter, it was dried over anhydrous magnesium sulfate, filtration thereof was performed, and the resultant filtrate was concentrated under reduced pressure, to obtain an oil.

The resultant oil was purified by silica gel column chromatography (toluene/hexane), then, dried under reduced pressure, then, dissolved with toluene/heptane, then, activated carbon was added and the mixture was stirred for 30 minutes, then, filtrated through a filter paved with Celite, and the resultant filtrate was concentrated under reduced pressure, to obtain a compound L1G (13.2 g) as a white solid. The compound L1G showed an HPLC area percentage value of 99.5% or more.

LC-MS (ESI positive): m/z = 687[M+H]⁺

### (Stage 6: Synthesis of compound L1H)

An argon gas atmosphere was prepared in a reaction vessel, then, the compound L1G (13 g), 2,5-dibromopyridine (4.5 g), toluene (120 mL), and a 20% by mass tetraethyl ammonium hydroxide aqueous solution (56 g) were added, and the mixture was stirred at 65°C for 15 hours.

Thereafter, to this was added n-heptane, and the resultant organic layer was washed with ion exchanged water. Thereafter, it was dried over anhydrous magnesium sulfate, filtration thereof was performed, and the resultant filtrate was concentrated under reduced pressure, to obtain an oil.

To the resultant oil were added toluene, n-heptane and activated carbon and the mixture was stirred at 60°C for 30 minutes, then, the mixture was filtrated through a filter paved with Celite, and the resultant filtrate was concentrated under reduced pressure, then, crystallized with toluene, n-heptane and ethanol, then, the mixture was dried at 50°C under reduced pressure, to obtain a compound L1H (7.3 g) as a white solid. The compound L1H showed an HPLC area percentage value of 99.5% or more.

¹H-NMR (600 mHz, CD₂Cl₂) δ (ppm) = 8.57 (s, 1H), 8.03-7.91 (m, 5H), 7.78 (d, 1H), 7.68 (d, 1H), 7.52 (d, 1H), 7.41 (t, 2H), 7.31 (s, 1H), 7.14 (t, 2H), 7.04 (s, 2H), 6.93 (d, 2H), 6.78 (d, 2H), 2.53 (t, 4H), 1.59-1.49 (m, 4H), 1.33-1.22 (m, 12H), 0.88-0.83 (m, 6H).

### (Stage 7: Synthesis of compound L1I)

An argon gas atmosphere was prepared in a reaction vessel, then, the compound L1H (7.3 g), bis(pinacolato)diboron (3.4 g), [1,1'-bis(diphenylphosphino)ferrocene]palladium(II) dichloride●dichloromethane adduct (290 mg), potassium acetate (3.2 g) and 1,2-dimethoxyethane (60 mL) were added, and the mixture was stirred for 3 hours under reflux with heating.

Thereafter, to this was added toluene (90 mL), the mixture was filtrated through a filter paved with Celite, and the resultant filtrate was concentrated under reduced pressure. Thereafter, to this were added toluene, n-heptane and activated carbon, and the mixture was stirred at room temperature for 30 minutes, then, the mixture was filtrated through a filter paved with Celite, and the resultant filtrate was concentrated under reduced pressure, and further crystallized with toluene/acetonitrile, to obtain a compound L1I (7.8 g) as a white solid. The compound L1I showed an HPLC area percentage value of 99.5% or more.

TLC-MS (DART positive): m/z = 764[M+H]⁺

¹H-NMR (600 mHz, CDCl₃) δ (ppm) = 8.89 (s, 1H), 8.15 (d, 1H), 7.97-7.88 (m, 5H), 7.63 (d, 1H), 7.51 (d, 1H), 7.39 (t, 2H), 7.32 (s, 1H), 7.14 (t, 2H), 7.03 (s, 2H), 6.90 (m, 2H), 6.83 (d, 2H), 2.54 (t, 4H), 1.59-1.49 (m, 4H), 1.33-1.22 (m, 24H), 0.88-0.83 (m, 6H).

### (Stage 8: Synthesis of compound L1)

An argon gas atmosphere was prepared in a light-shielded reaction vessel, then, the compound L1I (7.0 g), the compound L1J (3.7 g), tetrakis(triphenylphosphine)palladium(0) (210 mg), toluene (70 mL) and a 20% by mass tetraethyl ammonium hydroxide aqueous solution (27 g) were added, and the mixture was stirred at 70°C for 3 hours. Note that the compound L1J was synthesized according to a method described in JP-A No. 2008-179617.

Thereafter, to this was added toluene, and the resultant organic layer was washed with ion exchanged water. Thereafter, it was dried over anhydrous magnesium sulfate, filtration thereof was performed, and the resultant filtrate was concentrated under reduced pressure, to obtain a solid.

The resultant solid was purified by silica gel column chromatography (toluene/hexane), then, dried under reduced pressure, then, further crystallized with toluene/ethanol, to obtain a compound L1 (8.3 g) as a pale yellow solid. The compound L1 showed an HPLC area percentage value of 99.5% or more.

¹H-NMR (600 mHz, CDCl₃) δ (ppm) = 9.89 (s, 1H), 8.88 (d, 1H), 8.63 (d, 4H), 8.25 (d, 1H), 8.02-7.89 (m, 4H), 7.76 (d, 1H), 7.66 (d, 1H), 7.58 (d, 4H), 7.48 (s, 1H), 7.39 (t, 1H), 7.17-7.13 (m, 3H), 7.06 (s, 2H), 6.94 (s, 1H), 6.90 (s, 1H), 6.86 (d, 2H), 2.56 (t, 4H), 1.59-1.49 (m, 4H), 1.33-1.24 (m, 12H), 0.88-0.83 (m, 6H).

### (Stage 9: Synthesis of metal complex M1a)

An argon gas atmosphere was prepared in a light-shielded reaction vessel, then, ion exchanged water (5 mL), iridium(III) chloride hydrate (65 mg), the compound L1 (4.0 g) and 2-butoxyethanol (40 mL) were added, and the mixture was stirred at 105°C for 1 hour. Thereafter, the mixture was stirred at 150°C for 65 hours.

The resultant reaction mixture was cooled down to room temperature, then, added to methanol (90 mL), and the mixture was stirred at room temperature for 1 hour. Thereafter, filtration thereof was performed, and the resultant residue was dried under reduced pressure, then, purified by silica gel column chromatography (toluene/hexane), then, concentrated under reduced pressure, then, a red solid (2.8 g) containing a metal complex M1a was obtained.

### (Stage 10: Synthesis of metal complex M1)

An argon gas atmosphere was prepared in a light-shielded reaction vessel, then, the red solid (800 mg) containing the metal complex M1a, the compound L1 (210 mg), silver trifluoromethanesulfonate (I) (122 mg), 2,6-lutidine (860 µL) and diethylene glycol dimethyl ether (6.4 mL) were added, and the mixture was stirred at 140°C for 8 hours.

The resultant reaction mixture was cooled down to room temperature, then, added to methanol (40 mL), and the mixture was stirred at 0°C for 1 hour. Thereafter, filtration thereof was performed, to the resultant residue was added toluene (20 mL), and activated carbon was added and the mixture was stirred for 30 minutes, then, filtrated through a filter paved with Celite, and the resultant filtrate was concentrated under reduced pressure, to obtain a solid.

The resultant solid was purified by silica gel column chromatography (toluene/hexane), and by crystallization (toluene/n-heptane/acetonitrile) in series, then, dried under reduced pressure, to obtain a metal complex M1 (590 mg; the yield is 40% with respect to the charging amount of IrCl₃●3H₂O which is a trihydrate of iridium(III) chloride) as a red solid. The metal complex M1 showed an HPLC area percentage value of 99.5% or more.

LC-MS (APCI positive): m/z = 2623[M+H]⁺

### <Example 2> Synthesis of metal complex M2

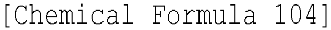

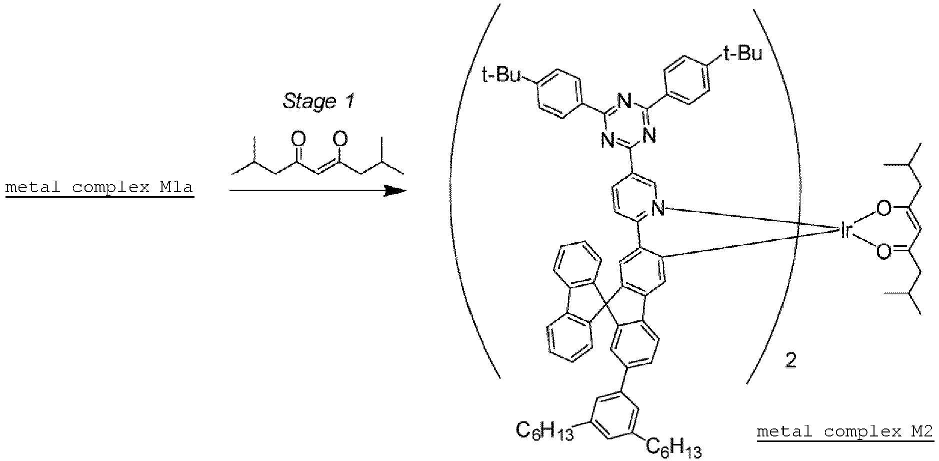

### (Stage 1: Synthesis of metal complex M2)

A nitrogen atmosphere was prepared in a reaction vessel, then, the metal complex M1a (1.00 g), 2,8-dimethyl-4,6-nonane dione (210 mg), silver trifluoromethanesulfonate (I) (122 mg), sodium carbonate (81 mg), toluene (50 ml) and 2-ethoxyethanol (25 mL) were added, and the mixture was stirred at 50°C for 30 minutes. Subsequently, the mixture was stirred at 80°C for 2 hours, then, stirred at 100°C for 2 hours.

The resultant reaction mixture was cooled down to room temperature, then, added to methanol (45 mL), and the mixture was stirred at 0°C for 1 hour. Thereafter, filtration thereof was performed, to the resultant residue was added dichloromethane (20 mL), and the mixture was filtrated through a filter paved with amine silica gel, and the resultant filtrate was concentrated under reduced pressure, to obtain a solid.

The resultant solid was purified by crystallization with dichloromethane/2-propanol and with toluene, then, dried under reduced pressure, to obtain a metal complex M2 (564 mg, yield 44%) as a red solid. The metal complex M2 showed an HPLC area percentage value of 99.4%.

¹H-NMR (400 mHz, CD₂Cl₂) δ (ppm) = 9.99 (d, 2H), 9.01 (d, 1H), 8.99 (d, 1H), 8.82-8.77 (m, 8H), 7.94 (d, 4H), 7.88 (d, 2H), 7.67-7.55 (m, 12H), 7.52 (d, 2H), 7.45-7.37 (m, 6H), 7.27-7.08 (m, 12H), 6.92 (d, 4H), 6.85-6.80 (m, 8H), 5.42 (s, 1H), 2.46 (t, 8H), 2.22-2.11 (m, 4H), 1.75-1.65 (m, 2H), 1.47 (penta, 8H), 1.28-1.15 (m, 24H), 0.81 (t, 12H), 0.57 (d, 6H), 0.52 (d, 6H).

### <Comparative Example 1> Synthesis of metal complex CM1

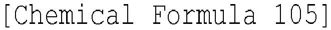

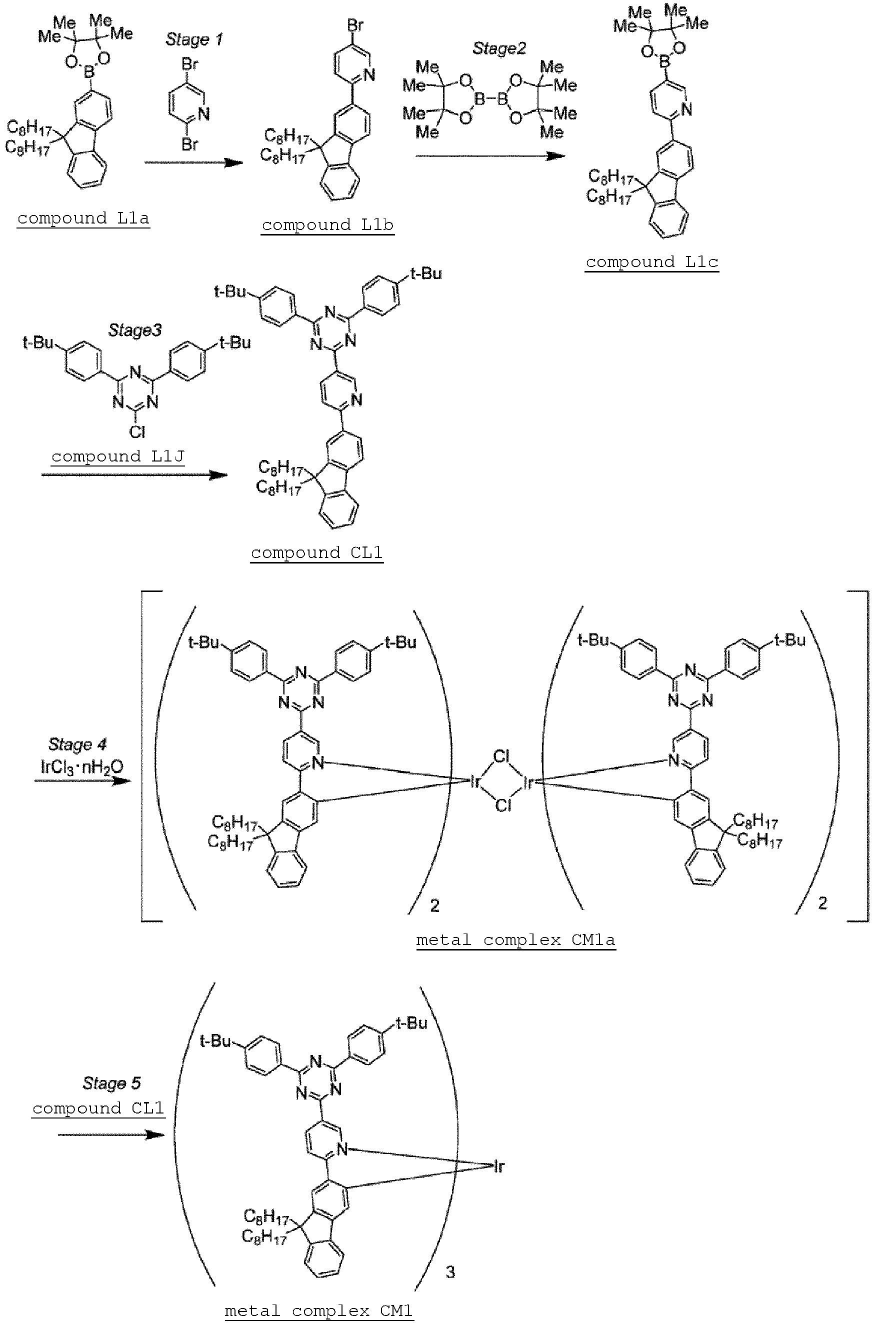

### (Stage 1: Synthesis of compound L1b)

An argon gas atmosphere was prepared in a reaction vessel, then, the compound L1a (12 g), 2,5-dibromopyridine (5.7 g), toluene (140 mL), tert-butanol (90 mL), tetrahydrofuran (70 mL), ion exchanged water (45 mL), tetrakis(triphenylphosphine)palladium(0) (530 mg) and a 40% by mass tetrabutyl ammonium hydroxide aqueous solution (60 g) were added, and and the mixture was stirred at 50°C for 15 hours.

Thereafter, to this was added toluene, and the resultant organic layer was washed with ion exchanged water. Thereafter, it was dried over anhydrous sodium sulfate, and filtrated, and the resultant filtrate was concentrated under reduced pressure, to obtain an oil.

The resultant oil was purified by silica gel column chromatography (toluene/hexane), then, dried under reduced pressure, to obtain a compound L1b (10 g, yield 80%) as a colorless oil. The compound L1b showed an HPLC area percentage value of 99.5% or more.

TLC-MS (DART positive): m/z = 546[M+H]⁺

### (Stage 2: Synthesis of compound L1c)

An argon gas atmosphere was prepared in a reaction vessel, then, the compound L1b (10 g), bis(pinacolato)diboron (7.2 g), [1,1'-bis(diphenylphosphino)ferrocene]palladium(II) dichloride-dichloromethane adduct (PdCl₂ (dppf)●CH₂Cl₂, 780 mg), potassium acetate (5.6 g) and 1,2-dimethoxyethane (60 mL) were added, and the mixture was stirred for 2 hours under reflux with heating.

Thereafter, to this was added toluene (90 mL), the mixture was filtrated through a filter paved with Celite, and the resultant filtrate was concentrated under reduced pressure. Thereafter, to this were added hexane and activated carbon, and the mixture was stirred at 60°C for 1 hour, then, the mixture was filtrated through a filter paved with Celite, and the resultant filtrate was concentrated under reduced pressure, to obtain a compound L1c (12 g) as a colorless oil. The compound L1c showed an HPLC area percentage value of 99.5% or more.

### (Stage 3: Synthesis of compound CL1)

An argon gas atmosphere was prepared in a light-shielded reaction vessel, then, the compound L1c (12 g), the compound L1J (8.7 g), tetrakis(triphenylphosphine)palladium(0) (440 mg), toluene (105 mL) and a 20% by mass tetraethyl ammonium hydroxide aqueous solution (56 g) were added, and the mixture was stirred at 70°C for 3 hours.

Thereafter, to this was added toluene, and the resultant organic layer was washed with ion exchanged water. Thereafter, it was dried over anhydrous sodium sulfate, and filtrated, and the resultant filtrate was concentrated under reduced pressure, to obtain a solid.

The resultant solid was purified by silica gel column chromatography (toluene/hexane), then, dried under reduced pressure, to obtain a compound CL1 (9.3 g) as a pale yellow solid. The compound CL1 showed an HPLC area percentage value of 99.5% or more.

TLC-MS (DART positive): m/z = 812[M+H]⁺

¹H-NMR (CD₂Cl₂, 300 MHz): δ (ppm) = 10.02 (d, 1H), 9.07 (dd, 1H), 8.72 (dt, 4H), 8.23 (s, 1H), 8.19 (dd, 1H), 8.06 (d, 1H), 7.87 (d, 1H), 7.81-7.78 (m, 1H), 7.65 (dt, 4H), 7.43-7.35 (m, 3H), 2.18-2.01 (m, 4H), 1.43 (s, 18H), 1.21-1.07 (m, 20H), 0.80 (t, 6H), 0.75-0.56 (m, 4H).

### (Stage 4: Synthesis of metal complex CM1a)

An argon gas atmosphere was prepared in a light-shielded reaction vessel, then, the compound CL1 (480 mg) and 2-ethoxyethanol (40 mL) were added, and the mixture was heated up to 60°C. Thereafter, iridium(III) chloride hydrate (88 mg) dissolved in ion exchanged water (13 mL) was added to this, and the mixture was stirred at 105°C for 15 hours.

The resultant reaction mixture was cooled down to room temperature, then, added to methanol (80 mL), and the mixture was stirred at room temperature for 1 hour. Thereafter, filtration thereof was performed, and the resultant residue was dried under reduced pressure, to obtain a red solid (470 mg) containing a metal complex CM1a.

### (Stage 5: Synthesis of metal complex CM1)

An argon gas atmosphere was prepared in a light-shielded reaction vessel, then, the red solid (470 mg) containing the metal complex CM1a, the compound CL1 (210 mg), silver trifluoromethanesulfonate (I) (87 mg), 2,6-lutidine (40 µL) and diethylene glycol dimethyl ether (6.3 mL) were added, and the mixture was stirred at 150°C for 17 hours.

The resultant reaction mixture was cooled down to room temperature, then, added to methanol (20 mL), and the mixture was stirred at room temperature for 1 hour. Thereafter, filtration thereof was performed, to the resultant residue was added toluene (20 mL), and the resultant organic layer was washed with ion exchanged water. Thereafter, it was dried over anhydrous sodium sulfate, and filtrated, and the resultant filtrate was concentrated under reduced pressure, to obtain a solid.

The resultant solid was purified by silica gel column chromatography (toluene/hexane), and by recrystallization (ethyl acetate/acetonitrile) in series, then, dried under reduced pressure, to obtain a metal complex CM1 (200 mg; the yield is 30% with respect to the charging amount of IrCl₃●H₂O which is a trihydrate of iridium(III) chloride) as a red solid. The metal complex CM1 showed an HPLC area percentage value of 99.5% or more.

LC-MS (APCI positive): m/z = 3132[M+H]⁺

### <Comparative Example 2> Synthesis of metal complex CM2

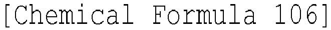

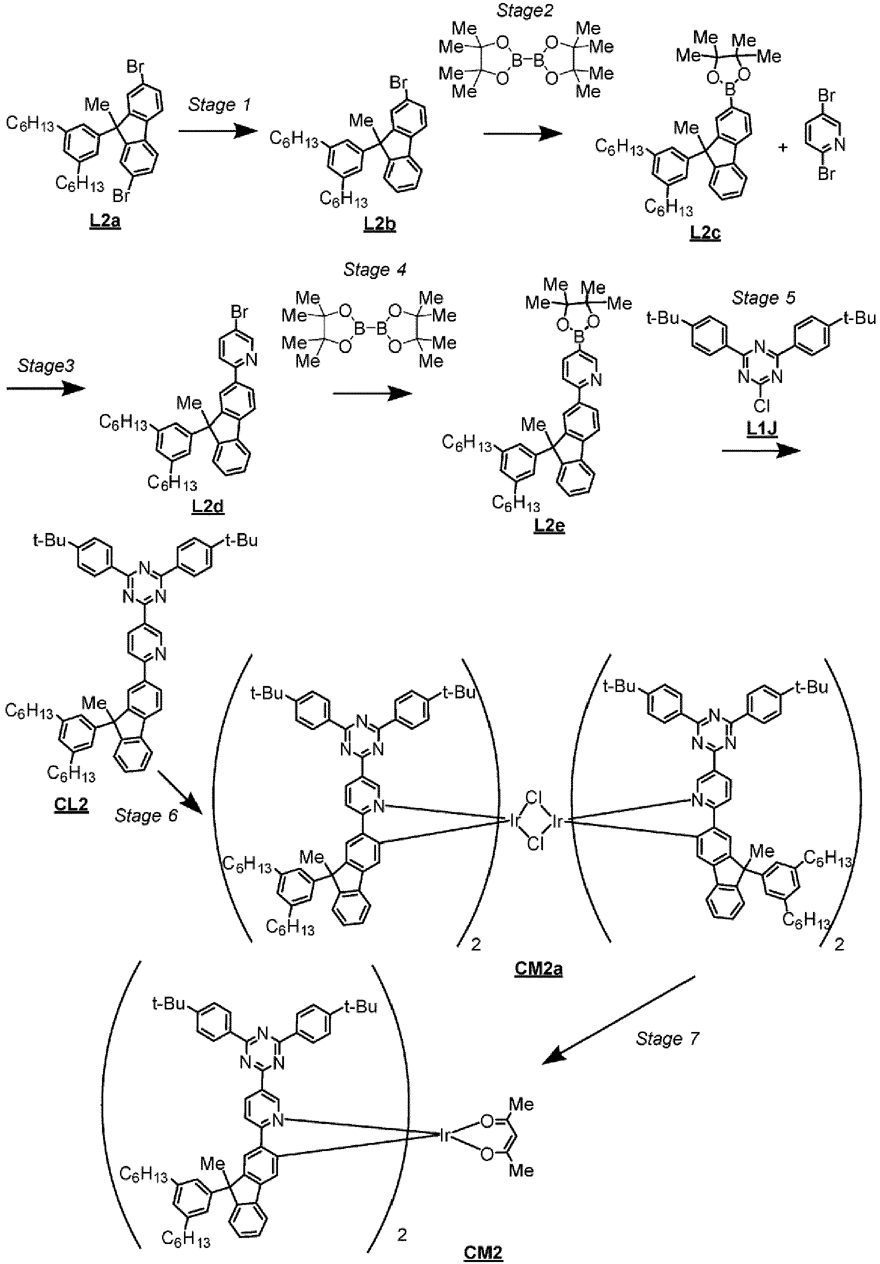

### (Stage 1: Synthesis of compound L2b)

A nitrogen gas atmosphere was prepared in a reaction vessel, then, a compound L2a (87.4 g) synthesized according to a method described in JP-A No. 2012-144721 and tetrahydrofuran (dehydrated product, 870 mL) were added, and the mixture was cooled down to -74°C while stirring. Thereafter, a n-butyllithium hexane solution (1.6 mol/L, 100 mL) was added to this, and the mixture was stirred at - 74°C for 1 hour. Thereafter, to this was added ion exchanged water (440 mL), and the mixture was heated up to room temperature, then, and the solvent was distilled off under reduced pressure. The resultant residue was dissolved in toluene, then, the solution was washed with ion exchanged water. Thereafter, it was dried over anhydrous sodium sulfate, and filtrated, and the filtrate was concentrated under reduced pressure, to obtain an oil.

This oil was purified by silica gel column chromatography (hexane), then, dried under reduced pressure, to obtain a compound L2b (63.5 g, yield 84%) as a yellow oil. The compound L2b showed an HPLC area percentage value of 93.0%.

TLC-MS (DART positive): m/z = 502[M]⁺

### (Stage 2: Synthesis of compound L2c)

A nitrogen gas atmosphere was prepared in a reaction vessel, then, the compound L2b (63.5 g), bis(pinacolato)diboron (35.2 g), [1,1'-bis(diphenylphosphino)ferrocene]palladium(II) dichloride-dichloromethane adduct (3.1 g), 1,1'-bis(diphenylphosphino)ferrocene (2.1 g), potassium acetate (37.1 g) and 1,4-dioxane (370 mL) were added, and the mixture was stirred for 3.5 hours under reflux with heating. The resultant reaction mixture was cooled down to room temperature, then, toluene (550 mL) was added, and the mixture was filtrated through a filter paved with silica gel and Celite. The filtrate was concentrated under reduced pressure, then, toluene, activated white earth and activated carbon were added, and the mixture was stirred at 60°C for 30 minutes, then, the mixture was filtrated through a filter paved with Celite. The filtrate was concentrated under reduced pressure, to obtain a compound L2c (78.5 g) as a yellow oil. The compound L2c showed an HPLC area percentage value of 89.9%.

TLC-MS (DART positive): m/z = 550[M]⁺

### (Stage 3: Synthesis of compound L2d)

A nitrogen gas atmosphere was prepared in a reaction vessel, then, the compound L2c (69.4 g), 2,5-dibromopyridine (35.8 g), toluene (760 mL), tert-butanol (380 mL), tetrahydrofuran (500 mL), ion exchanged water (250 mL), tetrakis(triphenylphosphine)palladium(0) (4.4 g) and a 40% by mass tetrabutyl ammonium hydroxide aqueous solution (330 mL) were added, and the mixture was stirred at 50°C for 15 hours. The resultant reaction mixture was cooled down to room temperature, then, toluene was added, the resultant organic layer was washed with ion exchanged water. Thereafter, it was dried over anhydrous sodium sulfate, and filtrated, and the filtrate was concentrated under reduced pressure, to obtain an oil.

This oil was purified by silica gel column chromatography (a mixed solvent of chloroform and hexane), and purified by reverse phase silica gel column chromatography (a mixed solvent of ethyl acetate and acetonitrile), then, dried under reduced pressure, to obtain a compound L2d (57.2 g, yield 78%) as a colorless oil. The compound L2d showed an HPLC area percentage value of 99.4%.

TLC-MS (DART positive): m/z = 579[M]⁺

### (Stage 4: Synthesis of compound L2e)

A nitrogen gas atmosphere was prepared in a reaction vessel, then, the compound L2d (56.9 g), bis(pinacolato)diboron (37.3 g), [1,1'-bis(diphenylphosphino)ferrocene]palladium(II) dichloride-dichloromethane adduct (4.8 g), potassium acetate (28.9 g) and 1,2-dimethoxyethane (390 mL) were added, and the mixture was stirred for 15 hours under reflux with heating. The resultant reaction mixture was cooled down to room temperature, then, toluene (590 mL) was added, and the mixture was filtrated through a filter paved with Celite. The filtrate was concentrated under reduced pressure, then, hexane and activated carbon were added, and the mixture was stirred at 65°C for 1 hour, then, the mixture was filtrated through a filter paved with Celite. The filtrate was concentrated under reduced pressure, to obtain a compound L2e (82.1 g) as a brown oil. The compound L2e showed an HPLC area percentage value of 98.6%.

LC-MS (APCI positive): m/z = 628[M+H]⁺

### (Stage 5: Synthesis of compound CL2)

An argon gas atmosphere was prepared in a light-shielded reaction vessel, then, the compound L2e (41.4 g), the compound L1J (30.1 g), tetrakis(triphenylphosphine)palladium(0) (4.6 g), toluene (360 mL) and a 20% by mass tetraethyl ammonium hydroxide aqueous solution (390 mL) were added, and the mixture was stirred at 70°C for 12 hours.

The resultant reaction mixture was cooled down to room temperature, then, toluene was added, and the resultant organic layer was washed with ion exchanged water. Thereafter, it was dried over anhydrous sodium sulfate, and filtrated, and the filtrate was concentrated under reduced pressure, to obtain a solid.

This solid was purified by silica gel column chromatography (a mixed solvent of chloroform and hexane), and purified by reverse phase silica gel column chromatography (a mixed solvent of ethyl acetate and acetonitrile), then, purified by recrystallization using a mixed solvent of ethyl acetate and methanol. Thereafter, it was dried at 40°C under reduced pressure overnight, to obtain a compound CL2 (45.5 g, yield 82%) as a pale yellow solid. The compound CL2 showed an HPLC area percentage value of 99.2%.

LC-MS (APCI positive): m/z = 845.5[M+H]⁺

1H-NMR (CD₂Cl₂, 300 MHz): δ (ppm) = 9.95 (d, 1H), 9.02 (dd, 1H), 8.70 (dt, 4H), 8.21 (dd, 1H), 8.09 (d, 1H), 7.96 (t, 2H), 7.87 (d, 1H), 7.63 (dt, 4H), 7.43-7.27 (m, 3H), 6.87 (s, 3H), 2.49 (t, 4H), 1.96 (s, 3H), 1.58-1.21 (m, 34H), 0.85 (t, 6H).

### (Stage 6: Synthesis of metal complex CM2a)

An argon gas atmosphere was prepared in a light-shielded reaction vessel, then, the compound CL2 (376 mg) and 2-ethoxyethanol (30 mL) were added, and the mixture was heated up to 80°C. Thereafter, iridium(III) chloride hydrate (71 mg) dissolved in ion exchanged water (10 mL) was added to this, and the mixture was stirred at 120°C for 15 hours.

The resultant reaction mixture was cooled down to room temperature, then, added to methanol (40 mL), and the mixture was stirred at room temperature for 1 hour. Thereafter, filtration thereof was performed, and residue was dried under reduced pressure, to obtain a solid containing a metal complex M2a (this is referred to as "solid A"; 384 mg). This operation was repeated, to obtain a necessary amount of the solid A.

The solid A was purified by silica gel column chromatography (a mixed solvent of chloroform and hexane). Thereafter, it was dried at 50°C under reduced pressure overnight, to obtain a red solid containing a metal complex CM2a (this is referred to as "solid B").

### (Stage 7: Synthesis of metal complex CM2)

An argon gas atmosphere was prepared in a light-shielded reaction vessel, then, the solid B (500 mg), acetyl acetone (260 mg), sodium carbonate (277 mg) and 2-ethoxyethanol (27 mL) were added, and the mixture was stirred at 120°C for 3 hours.

The resultant reaction mixture was cooled down to room temperature, then, toluene (100 mL) was added, and the mixture was washed with ion exchanged water. Thereafter, it was dried over anhydrous sodium sulfate, and filtrated through a filter paved with silica gel, and the filtrate was concentrated under reduced pressure, to obtain a solid.

This solid was purified by washing with ethanol and washing with hexane, then, dried under reduced pressure, to obtain a metal complex CM2 (320 mg) as a red solid. The metal complex CM2 showed an HPLC area percentage value of 98.9% or more.

LC-MS (ESI positive): m/z = 2018[M+K]⁺

1H-NMR (CD₂Cl₂, 300 MHz): δ (ppm) = 9.97 (d, 2H), 9.06 (d, 2H), 9.35 (d, 8H), 8.05 (d, 2H), 7.69 (m, 2H), 7.61 (d, 8H), 7.40-7.31 (m, 2H), 7.13 (t, 6H), 6.88-6.81 (m, 8H), 5.48 (s, 1H), 2.52-2.39 (m, 8H), 2.06 (s, 6H), 1.87-1.83 (m, 6H), 1.61-1.40 (m, 44H), 1.26 (m, 24H), 0.89 (m, 12H).

### <Synthesis Example 1> Synthesis of polymer compound IP1

A polymer compound IP1 was synthesized by a method described in JP-A No. 2012-144722, using a monomer PM1 synthesized according to a method described in JP-A No. 2011-174062, a monomer PM2 synthesized according to a method described in International Publication WO2005/049546, a monomer PM3 synthesized according to a method described in International Publication WO2002/045184, and a monomer PM4 synthesized according to a method described in JP-A No. 2008-106241.

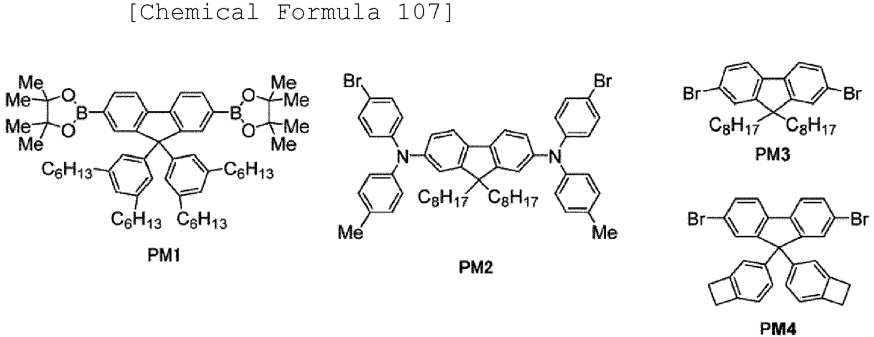

The polymer compound IP1 is copolymer constituted of a constitutional unit derived from the monomer PM1, a constitutional unit derived from the monomer PM2, a constitutional unit derived from the monomer PM3, and a constitutional unit derived from the monomer PM4 at a molar ratio of 50:30:12.5:7.5, according to the theoretical value calculated from the amounts of the charging raw materials.

### <Synthesis Example 2> Synthesis of polymer compound P1

An inert gas atmosphere was prepared in a reaction vessel, then, a monomer PM5 (4.77 g) synthesized by a method described in Synthesis Example 2' below, a monomer PM6 (0.773 g) synthesized according to a method described in International Publication WO2012/086671, the monomer PM3 (1.97 g), a monomer PM7 (0.331 g) synthesized according to a method described in International Publication WO2009/131255, a monomer PM8 (0.443 g) synthesized according to a method described in JP-A No. 2004-143419, and toluene (67 mL) were added, and the mixture was stirred while heating at 105°C.

Thereafter, to this was added bistriphenylphosphine palladium dichloride (4.2 mg), then, a 20% by mass tetraethyl ammonium hydroxide aqueous solution (20 mL) was dropped into this, then, the mixture was stirred under reflux for 3 hours.

Thereafter, to this were added phenylboronic acid (0.077 g), bistriphenylphosphine palladium dichloride (4.2 mg), toluene (60 mL) and a 20% by mass tetraethyl ammonium hydroxide aqueous solution (20 mL), and the mixture was stirred under reflux for 24 hours.

The organic layer was separated from the aqueous layer, then, to the resultant organic layer were added sodium N,N-diethyldithiocarbamate trihydrate (3.33 g) and ion exchanged water (67 mL), and the mixture was stirred at 85°C for 2 hours. The organic layer was separated from the aqueous layer, then, the organic layer was washed with ion exchanged water (78 mL) twice, with a 3% by mass acetic acid aqueous solution (78 mL) twice, and with ion exchanged water (78 mL) twice in this order. The organic layer was separated from the aqueous layer, then, the organic layer was dropped into methanol to cause precipitation of a solid, and it was collected by filtration, and dried, to obtain a solid. This solid was dissolved in toluene, and the liquid was passed through a silica gel column and an alumina column though which toluene had been passed previously. The resultant solution was dropped into methanol, to cause precipitation of a solid, and the solid was collected by filtration, and dried, to obtain a polymer compound P1 (4.95 g). The polystyrene-equivalent number-average molecular weight (Mn) and weight-average molecular weight (Mw) of the polymer compound P1 were Mn = 1.4 × 10⁵ and Mw = 4.1 × 10⁵.

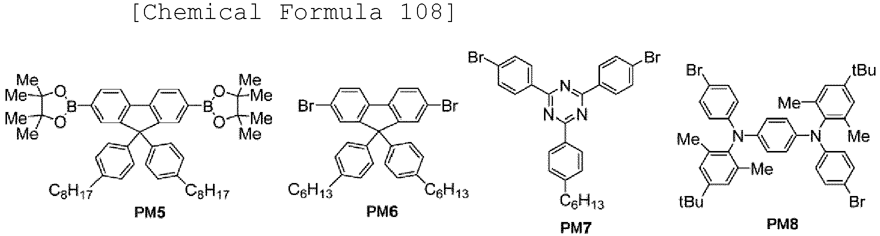

The polymer compound P1 is a copolymer constituted of a constitutional unit derived from the monomer PM5, a constitutional unit derived from the monomer PM6, a constitutional unit derived from the monomer PM3, a constitutional unit derived from the monomer PM7, and a constitutional unit derived from the monomer PM8 at a molar ratio of 50:10:30:5:5, according to the theoretical value calculated from the amounts of the charging raw materials.

### <Synthesis Example 2'> Synthesis of monomer PM5

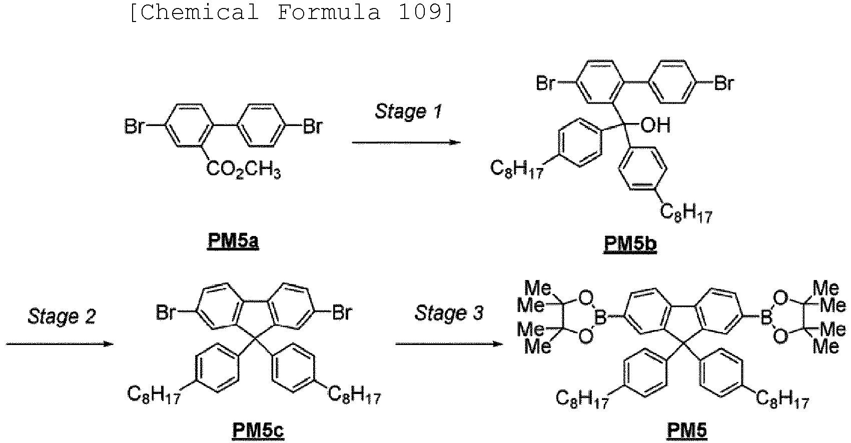

A compound PM5a was synthesized according to a method described in International Publication WO2012/086671.

### (Stage 1: Synthesis of compound PM5b)

A nitrogen gas atmosphere was prepared in a reaction vessel, then, 4-bromo-n-octylbenzene (250 g) and tetrahydrofuran (dehydrated product, 2.5 L) were added, and the mixture was cooled down to -70°C or less. Thereafter, a 2.5 mol/L n-butyllithium hexane solution (355 mL) was dropped, and the mixture was stirred at -70°C or less for 3 hours. Thereafter, a solution prepared by dissolving the compound PM5a (148 g) in tetrahydrofuran (dehydrated product, 400 mL) was dropped into this, then, the mixture was heated up to room temperature, and stirred overnight at room temperature. The resultant reaction mixture was cooled down to 0°C, then, water (150 mL) was added and the mixture was stirred. The resultant reaction mixture was concentrated under reduced pressure, to remove the organic solvent. To the resultant reaction mixture were added hexane (1 L) and water (200 mL), and the aqueous layer was removed by a liquid-separation operation. The resultant organic layer was washed with saturated saline, then, magnesium sulfate was added for drying it. The resultant mixture was filtrated, and the filtrate was concentrated under reduced pressure, to obtain a compound PM5b (330 g) as a yellow oil.

### (Stage 2: Synthesis of compound PM5c)

A nitrogen gas atmosphere was prepared in a reaction vessel, then, the compound PM5b (330 g) and dichloromethane (900 mL) were added, and the mixture was cooled down to 5°C or less. Thereafter, a 2.0 mol/L boron trifluoride diethyl ether complex (245 mL) was dropped into this. Thereafter, the solution was heated up to room temperature, and stirred overnight at room temperature. The resultant reaction mixture was put into a vessel charged with ice water (2 L), and stirred for 30 minutes, then, the aqueous layer was removed. The resultant organic layer was washed with a 10% by mass potassium phosphate aqueous solution (1 L) once and with water (1 L) twice, then, dried over magnesium sulfate. The resultant mixture was filtrated, and the filtrate was concentrated under reduced pressure, to obtain an oil. This oil was dissolved in toluene (200 mL), then, the liquid was passed through a filter paved with silica gel, to obtain a toluene solution 1. After the toluene solution 1 was obtained, toluene (about 3 L) was further passed through a filter paved with silica gel, to obtain toluene solution 2. The toluene solution 1 and the toluene solution 2 were mixed, then, concentrated under reduced pressure, to obtain an oil. To this oil was added methanol (500 mL), and these were stirred. The resultant reaction mixture was filtrated, to obtain a solid. To this solid was added a mixed solvent of butyl acetate and methanol, and recrystallization thereof was repeated, to obtain a compound PM5c (151 g) as a white solid. The compound PM5c showed an HPLC area percentage value of 99.0% or more.

¹H-NMR (400 mHz/CDCl₃): δ (ppm) = 7.56 (d, 2H), 7.49 (d, 2H), 7.46 (dd, 2H), 7.06 to 7.01 (m, 8H), 2.55 (t, 4H), 1.61 to 1.54 (m, 4H), 1.30 to 1.26 (m, 20H), 0.87 (t, 6H).

### (Stage 3: Synthesis of compound PM5)

A nitrogen gas atmosphere was prepared in a reaction vessel, then, the compound PM5c (100 g) and tetrahydrofuran (dehydrated product, 1000 mL) were added, and the mixture was cooled down to -70°C or less. Thereafter, a 2.5 mol/L n-butyllithium hexane solution (126 mL) was dropped into this, and the solution was stirred for 5 hours at -70°C or less. Thereafter, 2-isopropoxy-4,4,5,5-tetramethyl-1,3,2-dioxaborolane (81 mL) was dropped into this. Thereafter, the solution was heated up to room temperature, and stirred overnight at room temperature. The resultant reaction mixture was cooled down to -30°C, and a 2.0 mol/L hydrochloric acid diethyl ether solution (143 mL) was dropped. Thereafter, the solution was heated up to room temperature, and concentrated under reduced pressure, to obtain a solid. To this solid was added toluene (1.2 L), and the mixture was stirred for 1 hour at room temperature, then, the liquid was passed through a filter paved with silica gel, to obtain a filtrate. This filtrate was concentrated under reduced pressure, to obtain a solid. To this solid was added methanol and the mixture was stirred, then, filtrated, to obtain a solid. This solid was purified by being recrystallized from isopropyl alcohol repeatedly, then, dried under reduced pressure at 50°C overnight, to obtain a compound PM5 (72 g) as a white solid. The compound PM5 showed an HPLC area percentage value of 99.0% or more.

¹H-NMR (400 mHz/CDCl₃) : δ (ppm) = 7.82 (d, 2H), 7.81 (s, 2H), 7.76 (d, 2H), 7.11 (d, 4H), 7.00 (d, 4H), 2.52 (t, 4H), 1.59 to 1.54 (m, 4H), 1.36 to 1.26 (m, 20H), 1.31 (s, 24H), 0.87 (t, 6H).

### <Example D1> Fabrication and evaluation of light emitting device D1

### (Formation of anode and hole injection layer)

An ITO film was attached with a thickness of 45 nm to a glass substrate by a sputtering method, to form an anode. On the anode, a polythiophene sulfonic acid type hole injection agent AQ-1200 (manufactured by Plextronics) was spin-coated to form a film with a thickness of 65 nm, and the film was heated on a hot plate at 170°C for 15 minutes under an air atmosphere, to form a hole injection layer.

### (Formation of hole transporting layer)

The polymer compound IP1 was dissolved at a concentration of 0.70% by mass in xylene. The resultant xylene solution was spin-coated on the hole injection layer to form a film with a thickness of 20 nm, and the film was heated on a hot plate at 180°C for 60 minutes under a nitrogen gas atmosphere, to form a hole transporting layer.

### (Formation of light emitting layer)

The polymer compound P1 and the metal complex M1 (polymer compound P1/metal complex M1 = 92.5% by mass/7.5% by mass) were dissolved at a concentration of 1.7% by mass in xylene. The resultant xylene solution was spin-coated on the hole transporting layer to form a film with a thickness of 90 nm, and the film was heated at 150°C for 10 minutes under a nitrogen gas atmosphere, to form a light emitting layer.

### (Formation of cathode)

The substrate carrying the light emitting device formed thereon was placed in a vapor deposition machine, and the internal pressure thereof was reduced to 1.0 × 10⁻⁴ Pa or less, then, as the cathode, sodium fluoride was vapor-deposited with a thickness of about 4 nm on the light emitting layer, then, aluminum was vapor-deposited with a thickness of about 80 nm on the sodium fluoride layer. After vapor deposition, sealing was performed using a glass substrate, to fabricate a light emitting device D1.

### (Evaluation of light emitting device)

Voltage was applied to the light emitting device D1 to observe light emission having the maximum peak of the light emission spectrum at 620 nm, and the CIE chromaticity coordinate (x, y) was (0.658,0.339). The external quantum efficiency at 1000 cd/m² was 15.2%. The current value was set so that the current density was 50 mA/cm², then, the device was driven at the constant current density, and the time change of the luminance was measured. The time until the luminance reached 80% of the initial luminance was 203 hours.

### <Comparative Example CD1> Fabrication and evaluation of light emitting device CD1

A light emitting device CD1 was fabricated in the same manner as in Example D1, except that the polymer compound P1 and the metal complex CM1 were used instead of "the polymer compound P1 and the metal complex M1" in Example D1.

Voltage was applied to the light emitting device CD1 to observe light emission having the maximum peak of the light emission spectrum at 625 nm, and the CIE chromaticity coordinate (x, y) was (0.668,0.329). The external quantum efficiency at 1000 cd/m² was 15.1%. The current value was set so that the current density was 50 mA/cm², then, the device was driven at the constant current density, and the time change of the luminance was measured. The time until the luminance reached 80% of the initial luminance was 164 hours.

### <Example D2> Fabrication and evaluation of light emitting device D2

A light emitting device D2 was fabricated in the same manner as Example D1, except that the polymer compound P1 and the metal complex M2 were used instead of "the polymer compound P1 and the metal complex M1" in Example D1.

Voltage was applied to the light emitting device D2 to observe light emission having the maximum peak of the light emission spectrum at 630 nm, and the CIE chromaticity coordinate (x, y) was (0.662,0.327). The external quantum efficiency at 1000 cd/m² was 10.7%. The current value was set so that the current density was 50 mA/cm², then, the device was driven at the constant current density, and the time change of the luminance was measured. The time until the luminance reached 80% of the initial luminance was 244 hours.

### <Comparative Example CD2> Fabrication and evaluation of light emitting device CD2

A light emitting device CD2 was fabricated in the same manner as in Example D1, except that the polymer compound P1 and the metal complex CM2 were used instead of "the polymer compound P1 and the metal complex M1" in Example D1.

Voltage was applied to the light emitting device CD2 to observe light emission having the maximum peak of the light emission spectrum at 625 nm, and the CIE chromaticity coordinate (x, y) was (0.666, 0.330). The external quantum efficiency at 1000 cd/m² was 10.6%. The current value was set so that the current density was 50 mA/cm², then, the device was driven at the constant current density, and the time change of the luminance was measured. The time until the luminance reached 80% of the initial luminance was 79 hours.

### Industrial Applicability

The metal complex and the composition containing the metal complex of the present invention are useful for production of a light emitting device of which long-term degradation is suppressed.

## Claims

1. A metal complex represented by the formula (1): 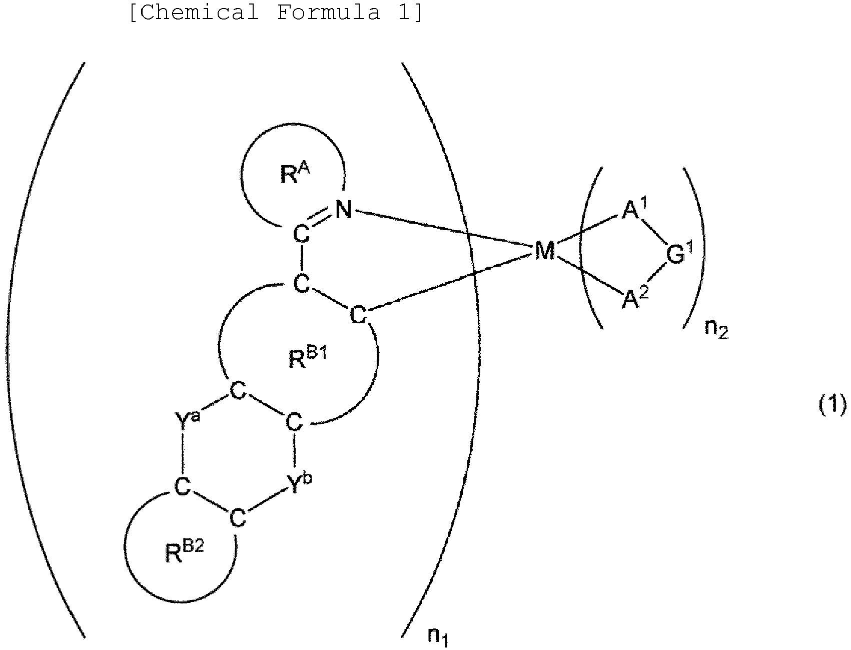 wherein,
M represents a rhodium atom, a palladium atom, an iridium atom or a platinum atom,
n₁ represents 1, 2 or 3, n₂ represents 0, 1 or 2, n₁+n₂ is 3 when M is a rhodium atom or an iridium atom, while n₁+n₂ is 2 when M is a platinum atom or a palladium atom,
Ring R^{A} represents an aromatic hetero ring, and the aromatic hetero ring optionally has a substituent, when a plurality of the substituents are present, they may be combined together to form a ring together with atoms to which they are attached, when a plurality of Ring R^{A} are present, they may be the same or different at each occurrence,
Ring R^{B1} and Ring R^{B2} each independently represent an aromatic hydrocarbon ring or an aromatic hetero ring, and these rings optionally have a substituent, when a plurality of the substituents are present, they may be combined together to form a ring together with atoms to which they are attached, when a plurality of Ring R^{B1} and Ring R^{B2} are present, they may be the same or different at each occurrence,
one of Y^{a} and Y^{b} is a single bond, and the other is a group represented by the formula (C-1): 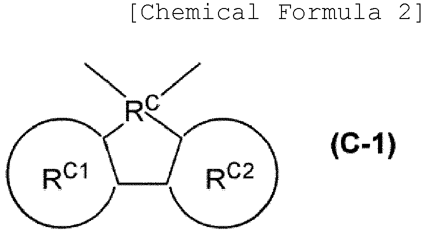 wherein,
R^{c} represents a carbon atom, a silicon atom, a germanium atom, a tin atom or a lead atom,
Ring R^{C1} and Ring R^{C2} each independently represent an aromatic hydrocarbon ring or an aromatic hetero ring, and these rings optionally have a substituent, when a plurality of the substituents are present, they may be combined together to form a ring together with atoms to which they are attached, a substituent which Ring R^{C1} optionally has and a substituent which Ring R^{C2} optionally has may be combined together to form a ring together with atoms to which they are attached,
when a plurality of Y^{a} and Y^{b} are present, they may be the same or different at each occurrence,
A¹⁻G¹⁻A² represents an anionic bidentate ligand, and G¹ represents an atomic group constituting a bidentate ligand together with A¹ and A², and A¹ and A² each independently represent a carbon atom, an oxygen atom or a nitrogen atom, and these atoms may be ring-constituent atoms, when a plurality of A¹⁻G¹⁻A² are present, they may be the same or different,
at least one of Ring R^{A}, Ring R^{B1}, Ring R^{B2}, Ring R^{C1} and Ring R^{C2} has a group represented by the formula (D-A), the formula (D-B) or the formula (D-C) as a substituent, 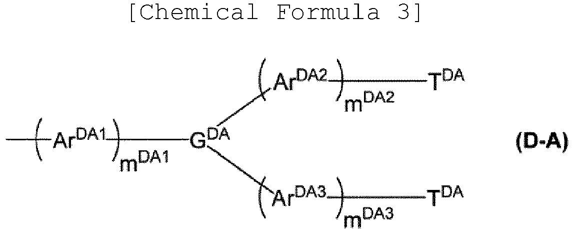 wherein,
m^{DA1}, m^{DA2} and m^{DA3} each independently represent an integer of 0 or more,
G^{DA} represents a nitrogen atom, an aromatic hydrocarbon group or a hetero ring group, and these groups optionally have a substituent,
Ar^{DA1}, Ar^{DA2} and Ar^{DA3} each independently represent an arylene group or a divalent hetero ring group, and these groups optionally have a substituent, when a plurality of Ar^{DA1}, Ar^{DA2} and Ar^{DA3} are present, they may be the same or different at each occurrence,
T^{DA} represents an aryl group or a monovalent hetero ring group, and these groups optionally have a substituent, a plurality of T^{DA} may be the same or different, 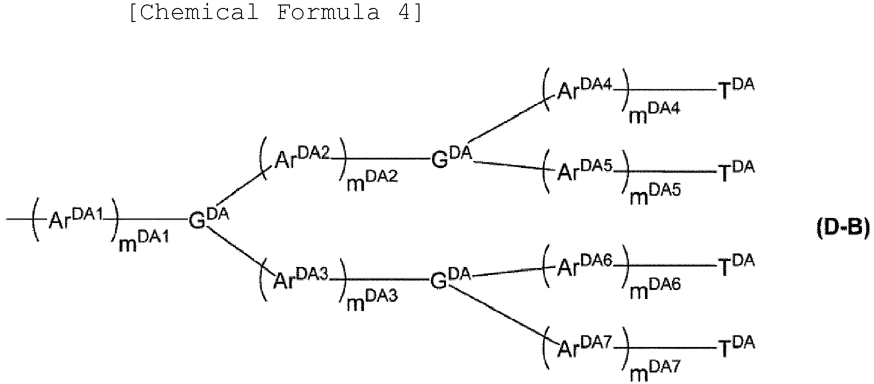 wherein,
m^{DA1}, m^{DA2}, m^{DA3}, m^{DA4}, m^{DA5}, m^{DA6} and m^{DA7} each independently represent an integer of 0 or more,
G^{DA} represents a nitrogen atom, an aromatic hydrocarbon group or a hetero ring group, and these groups optionally have a substituent, a plurality of G^{DA} may be the same or different,
Ar^{DA1}, Ar^{DA2}, Ar^{DA3}, Ar^{DA4}, Ar^{DA5}, Ar^{DA6} and Ar^{DA7} each independently represent an arylene group or a divalent hetero ring group, and these groups optionally have a substituent, when a plurality of Ar^{DA1}, Ar^{DA2}, Ar^{DA3}, Ar^{DA4}, Ar^{DA5}, Ar^{DA6} and Ar^{DA7} are present, they may be the same or different at each occurrence,
T^{DA} represents an aryl group or a monovalent hetero ring group, and these groups optionally have a substituent, a plurality of T^{DA} may be the same or different, 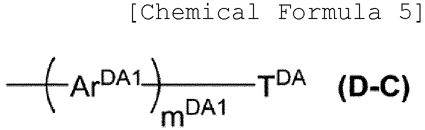 wherein,
m^{DA1} represents an integer of 0 or more,
Ar^{DA1} represents an arylene group or a divalent hetero ring group, and these groups optionally have a substituent, when a plurality of Ar^{DA1} are present, they may be the same or different,
T^{DA} represents an aryl group or a monovalent hetero ring group, and these groups optionally have a substituent.

2. The metal complex according to claim 1, wherein said metal complex represented by the formula (1) is a metal complex represented by the formula (1-A1), a metal complex represented by the formula (1-A2) or a metal complex represented by the formula (1-A3): 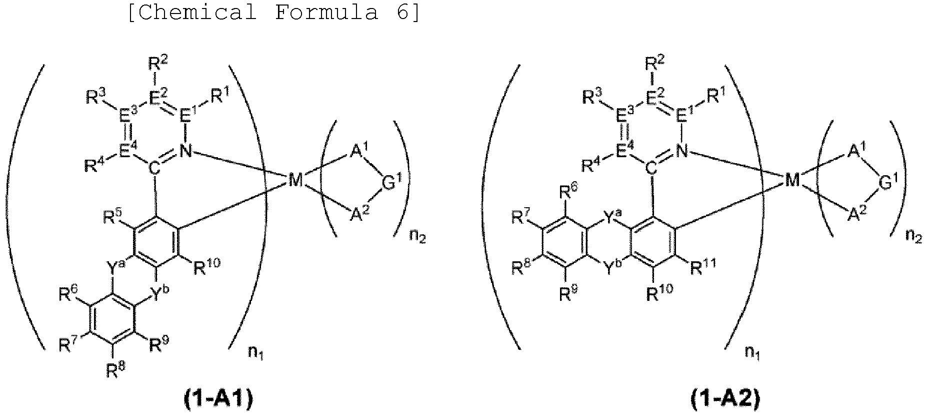 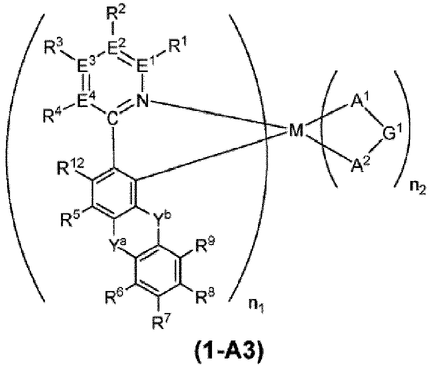 wherein,
M, n¹, n², Y^{a}, Y^{b} and A¹-G¹-A² represent the same meaning as described above,
E¹, E², E³ and E⁴ each independently represent a nitrogen atom or a carbon atom, when a plurality of E¹, E², E³ and E⁴ are present, they may be the same or different at each occurrence, when E¹ is a nitrogen atom, R¹ is not present, when E² is a nitrogen atom, R² is not present, when E³ is a nitrogen atom, R³ is not present, and when E⁴ is a nitrogen atom, R⁴ is not present,
R¹, R², R³ and R⁴ each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom, a group represented by said formula (D-A), a group represented by said formula (D-B) or a group represented by said formula (D-C), and these groups optionally have a substituent, when a plurality of R¹, R², R³ and R⁴ are present, they may be the same or different at each occurrence,
R⁵, R⁶, R⁷, R⁸, R⁹, R¹⁰, R¹¹ and R¹² each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom, a group represented by said formula (D-A), a group represented by said formula (D-B) or a group represented by said formula (D-C), and these groups optionally have a substituent, when a plurality of R⁵, R⁶, R⁷, R⁸, R⁹, R¹⁰, R¹¹ and R¹² are present, they may be the same or different at each occurrence, R⁶ and R⁷, R⁷ and R⁸, R⁸ and R⁹, R¹⁰ and R¹¹, and R⁵ and R¹² may each be combined together to form a ring together with atoms to which they are attached,
at least one of R¹, R², R³, R⁴, R⁵, R⁶, R⁷, R⁸, R⁹, R¹⁰, R¹¹, R¹², a substituent which Ring R^{C1} has and a substituent which Ring R^{C2} has is a group represented by said formula (D-A), said formula (D-B) or said formula (D-C).

3. The metal complex according to claim 1 or 2, wherein the group represented by said formula (C-1) is a group represented by the formula (C-2): 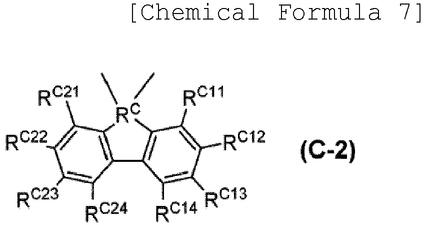 wherein, R^{c} represents the same meaning as described above,
R^{C11}, R^{C12}, R^{C13}, R^{C14}, R^{C21}, R^{C22}, R^{C23} and R^{C24} each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom, a group represented by said formula (D-A), a group represented by said formula (D-B) or a group represented by said formula (D-C), and these groups optionally have a substituent, when a plurality of R^{C11}, R^{C12}, R^{C13}, R^{C14}, R^{C21}, R^{C22}, R^{C23} and R^{C24} are present, they may be the same or different at each occurrence, R^{C11} and R^{C12}, R^{C12} and R^{C13}, R^{C13} and R^{C14}, R^{C14} and R^{C24,} R^{C24} and R^{C23,} R^{C23} and R^{C22}, and R^{C22} and R^{C21} may each be combined together to form a ring together with atoms to which they are attached,
at least one of a substituent which Ring R^{B1} has, a substituent which Ring R^{B2} has, R^{C11}, R^{C12}, R^{C13}, R^{C14}, R^{C21}, R^{C22}, R^{C23} and R^{C24} is a group represented by said formula (D-A), a group represented by said formula (D-B) or a group represented by said formula (D-C).

4. The metal complex according to claim 3, wherein the metal complex represented by said formula (1) is a metal complex represented by the formula (1-A1-1): 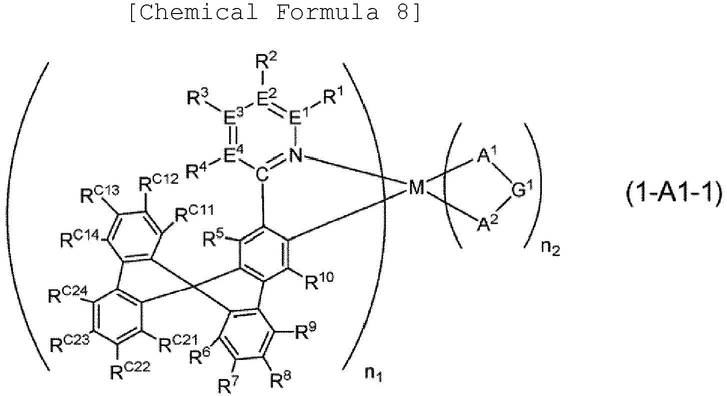 wherein, M, n¹, n², E¹, E², E³, E⁴, R¹, R², R³, R⁴, R⁵, R⁶, R⁷, R⁸, R⁹, R¹⁰, R^{C11}, R^{C12}, R^{C13}, R^{C14}, R^{C21}, R^{C22}, R^{C23}, R^{C24}, and A¹-G¹⁻A² represent the same meaning as described above.

5. The metal complex according to any one of claims 1 to 4, wherein Ring R^{A} has a group represented by said formula (D-A), said formula (D-B) or said formula (D-C) as a substituent.

6. The metal complex according to claim 5, wherein Ring R^{A} is a 6-membered ring, and the group represented by said formula (D-A), said formula (D-B) or said formula (D-C) is present at the para position with respect to a carbon atom bonding to Ring R^{B1}.

7. The metal complex according to any one of claims 1 to 6, wherein the group represented by said formula (D-A) is a group represented by the formula (D-A1), a group represented by the formula (D-A2), a group represented by the formula (D-A3), a group represented by the formula (D-A4) or a group represented by the formula (D-A5): 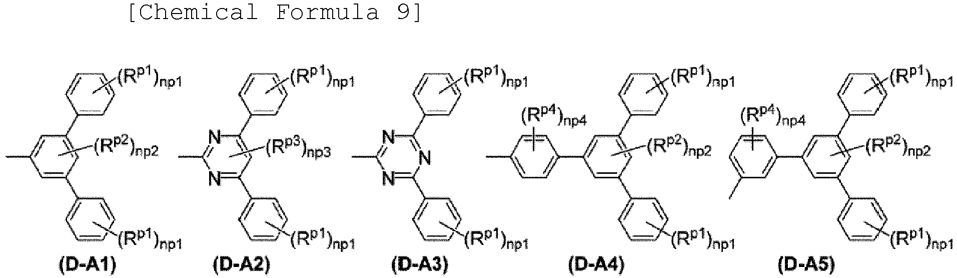 wherein,
R^{p1}, R^{p2}, R^{p3} and R^{p4} each independently represent an alkyl group, a cycloalkyl group, an alkoxy group, a cycloalkoxy group or a halogen atom, and these groups optionally have a substituent, when a plurality of RP1, RP2 and R^{p4} are present, they may be the same or different at each occurrence,
n^{p1} represents an integer of 0 to 5, n^{p2} represents an integer of 0 to 3, n^{p3} represents 0 or 1, and n^{p4} represents an integer of 0 to 4, and a plurality of n^{p1} may be the same or different.

8. The metal complex according to any one of claims 1 to 7, wherein Ring R^{A} is a pyridine ring.

9. A composition comprising the metal complex as described in any one of claims 1 to 8, and at least one selected from the group consisting of a compound represented by the formula (H-1) and a polymer compound containing a constitutional unit represented by the formula (Y) : 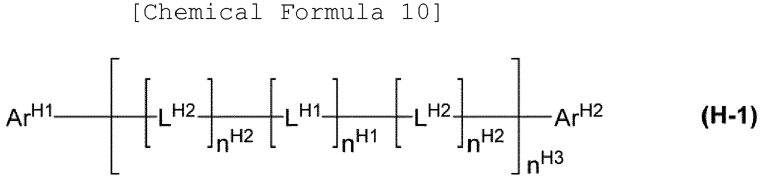 wherein,
Ar^{H1} and Ar^{H2} each independently represent an aryl group or a monovalent hetero ring group, and these groups optionally have a substituent,
n^{H1} and n^{H2} each independently represent 0 or 1, when a plurality of n^{H1} are present, they may be the same or different, a plurality of n^{H2} may be the same or different,
n^{H3} represents an integer of 0 or more,
L^{H1} represents an arylene group, a divalent hetero ring group, or a group represented by - [C(R^{H11})₂]n^{H11}-, and these groups optionally have a substituent, when a plurality of L^{H1} are present, they may be the same or different, n^{H11} represents an integer of 1 or more and 10 or less, R^{H11} represents a hydrogen atom, an alkyl group, a cycloalkyl group, an alkoxy group, a cycloalkoxy group, an aryl group or a monovalent hetero ring group, and these groups optionally have a substituent, a plurality of R^{H11} may be the same or different, and may be combined together to form a ring together with carbon atoms to which they are attached,
L^{H2} represents a group represented by -N(-L^{H21}-R^{H21})-, when a plurality of L^{H2} are present, they may be the same or different,
L^{H21} represents a single bond, an arylene group or a divalent hetero ring group, and these groups optionally have a substituent, R^{H21} represents a hydrogen atom, an alkyl group, a cycloalkyl group, an aryl group or a monovalent hetero ring group, and these groups optionally have a substituent, 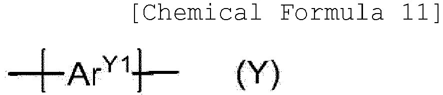 wherein, Ar^{Y1} represents an arylene group, a divalent hetero ring group, or a divalent group in which an arylene group and a divalent hetero ring group are bonded directly, and these groups optionally have a substituent.

10. A composition comprising the metal complex as described in any one of claims 1 to 8, and at least one material selected from the group consisting of a hole transporting material, a hole injection material, an electron transporting material, an electron injection material, a light emitting material, an antioxidant and a solvent.

11. A light emitting device comprising the metal complex as described in any one of claims 1 to 8.
